(19) Europäisches Patentamt
European Patent Office
Office européen des brevets

(11) **EP 1 566 802 B1**

(12) **EUROPEAN PATENT SPECIFICATION**

(45) Date of publication and mention
of the grant of the patent:
**09.01.2008 Bulletin 2008/02**

(51) Int Cl.:
*G11B 7/24* (2006.01)

(21) Application number: **05011266.3**

(22) Date of filing: **04.06.2003**

(54) **Optical recording process**

Optisches Aufzeichnungsverfahren

procédé d'enregistrement optique

(84) Designated Contracting States:
**DE ES FR GB IT NL**

(30) Priority: 05.06.2002 JP 2002163793
28.06.2002 JP 2002189628
08.07.2002 JP 2002198114
23.07.2002 JP 2002214500
04.09.2002 JP 2002258638
27.11.2002 JP 2002344719

(43) Date of publication of application:
**24.08.2005 Bulletin 2005/34**

(62) Document number(s) of the earlier application(s) in
accordance with Art. 76 EPC:
**03012695.7 / 1 372 148**

(73) Proprietor: **Ricoh Company, Ltd.**
**Tokyo 143-8555 (JP)**

(72) Inventors:
• **Harigaya, Makoto**
**Tokyo 143-8555 (JP)**
• **Ito, Kazunori**
**Tokyo 143-8555 (JP)**
• **Tashiro, Hiroko**
**Tokyo 143-8555 (JP)**
• **Mizutani, Miku**
**Kumagaya-shi**
**Saitama (JP)**
• **Shinotsuka, Michiaki**
**Tokyo 143-8555 (JP)**
• **Iwasa, Hiroyuki**
**Tokyo 143-8555 (JP)**
• **Shinkai, Masaru**
**Tokyo 143-8555 (JP)**

(74) Representative: **Barz, Peter**
**Kaiserplatz 2**
**80803 München (DE)**

(56) References cited:
**EP-A- 1 260 973**          **WO-A-02/084657**
**US-A- 5 848 043**

**Description**

BACKGROUND OF THE INVENTION

Field of the Invention

The present invention relates to a phase change optical recording process using a recording medium on which materials to be recorded are optically changed by irradiating electromagnetic wave, and which enables recording and reproducing and rewriting.

Description of the Related Art

As one of optical recording media which enables recording and reproducing and erasing by irradiating a light, there is known a so-called phase change optical disk. Such phase change optical disk utilizes a phase transition between a crystalline phase and an amorphous phase, or between a crystalline phase and other crystalline phase. Since overwriting on the phase change optical disk can be carried out by a single beam, and because of the simple optical system of driving, such optical disk is generally employed as AV-related recording media or as recording media for a computer.

Materials used for the recording media include Ge-Te, Ge-Te-Se, In-Sb, Ga-Sb, Ge-Sb-Te, and Ag-In-Sb-Te. In particular, Ag-In-Sb-Te is employed as a mark edge recording material, having features such as high sensitivity, and clear outline of amorphous part in a recording mark (see Japanese Patent Application Laid-Open (JP-A) No. 03-231889, JP-A No. 04-191089, JP-A No. 04-232779, JP-A No. 04-267192, and JP-A No. 05-345478, or the like).

However, these recording materials are to be used for an optical recording medium having relatively low recording density, such as CD-RW (Compact Disk-Rewritable). If it is used in DVD (Digital Versatile Disk) RAM or DVD-RW and the like, overwriting can be carried out when a recording linear velocity is around 3.5m/ s (×1speed). However, when it becomes ×2 speed or faster, there is a problem that overwriting property may deteriorate. It is because speed for crystallization of the recording materials as described above is low, thus overwriting in high linear velocity becomes difficult.

It is possible to crystallize faster, by increasing the amount of Sb, but this may lead to fall in crystallization temperature due to increase of Sb, and then a storage property may be deteriorated.

To solve this problem, there is disclosed an approach to use Ag-In-Ge-Sb-Te system recording material in JP-A No. 2000-322740. It is possible to apply this approach when the recording linear velocity is 3.0 m/s to 20 m/s, but at a higher velocity, such as 20 m/s or more, it is not applicable.

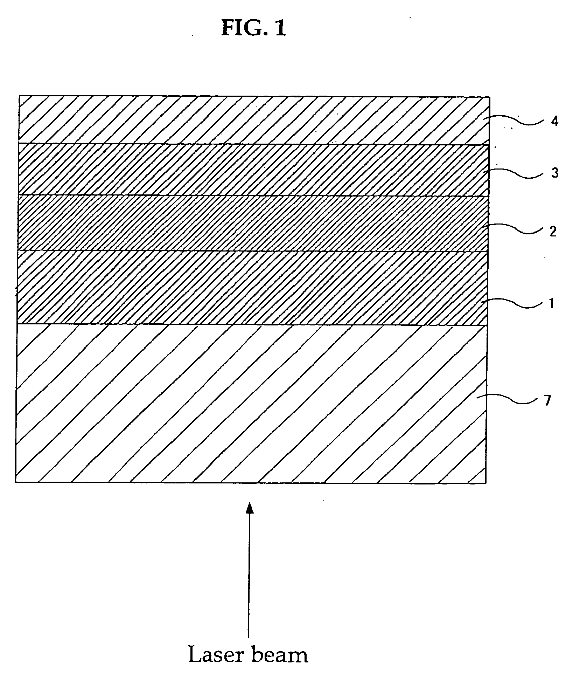

In the meantime, GaSb has been proposed as a high-speed crystallization material ("Phase-change optical data storage in GaSb" Applied optics. /vol. 26, No. 22115, November 1987). It is reported that as for this alloy, crystallization speed is extremely high, however, since a crystallization temperature is as high as 350˚C, crystallization at the initial stage is difficult. Furthermore, the U.S. Patent Nos. 4,818,666 and 5,072,423 disclose that Mo, W, Ta, Ni, Pd, Pt, Cu, Ag, Au, Zn, Cd, Al, Tl, Si, Ge, Sn, Pb, As, Bi, S, Se, Te or the like are added to GaSb, so as to enhance its property. However, such disclosures do not satisfy an overwriting property at high speed recording, degree of modulation and archival stability at the same time. For instance, the optical recording medium disclosed in the U.S. Patent No. 4,818,666 utilizes the phase change between the crystalline and crystalline phases for optical recording. The modulation is 0.29 at the best, which causes problems in the practical use. The U.S. Patent No. 4,818,666 states that a layer or a film lifts up, which is presumably because of the bubble generated on a portion where a laser beam is irradiated, when a content of Ga is less than 20%. It also states that, because of the lift-up, the level, in which the reflectance differs, becomes unstable. The U.S. Patent No.4,818,666 states that the invention stated therein causes problems in practical use, accordingly. The phase change between the crystal and crystalline phases utilizes the difference in reflectance derived from the difference in the crystal particle diameters. Therefore, it is unfavorable for the high-density recording that requires fine marks. The optical recording medium disclosed in the U.S. Patent No.4,818,666 does not allow the same recording capacity as DVD-ROM. Appl. Phys. Lett. 60 (25), 22 June 1992, pp.3123-3125 states an optical recording medium that utilizes a GeSb thin film and that is capable of phase change at an extra-high speed. An electron diffraction shown in the FIG.1 attached thereto does not describe the orientation of crystals. Furthermore, the modulation between a phase which serves as the crystalline phase and the amorphous phase is 0.15 to 0.2, which causes problems in practical use.

Japanese Patent Application Laid-Open (JP-A) No. 2001-39031 discloses an optical recording medium whose recording layer is mainly formed of alloy as $(Sb_xGe_{1-x})_{1-y}In_y$ (herein, $0.65 \leq x \leq 0.95$, $0 < y \leq 0.2$). However, there is only one statement in initialization condition of the optical recording medium. It only states that the initialization condition is to crystallize at an initial phase with a laser power density of around $2.6mW/\mu m^2$. There is no statement about a high laser power density at an initial phase. The low laser power density as disclosed therein provides a medium having poorly oriented crystals and low reflectance. The recording linear velocity disclosed therein is as slow as 2.4m/ s to 9.6m/s, which does not meet the present invention's a high recording linear velocity.

As described above, various kinds of phase change recording materials have been reported so far, but any of the materials has not been satisfactorily provided with the properties required by a rewritable phase change optical recoding medium. In particular, those have not been the materials such as having a high-density recording capacity equivalent of that of DVD-ROM's, being capable of handling a situation when recording linear velocity is further increased (- 35 m/S), and simultaneously satisfying requirements as to overwriting property, degree of modulation, and archival stability.

EP 1260973 A2 is an intermediate document pursuant to Art. 54(3) EPC. EP 1260973 A2 discloses an optical recording process including the steps of forming a laser beam which reversibly phase changes between an amorphous phase and a crystalline phase in a recording layer which is disposed on a substrate of an optical recording medium so as to have a single pulse or a plurality of pulses; and irradiating the laser beam to the optical recording medium at a linear velocity of between more than 3 m/s and 40 m/s or less so as to record in the recording layer. The recording medium includes a substrate and a recording layer disposed on the substrate; wherein the recording layer contains Ga and Sb, the content of Sb being 80 atom % to 95 atom % relative to the total content of Ga and Sb in the recording layer.

## SUMMARY OF THE INVENTION

The present invention has been proposed in view of the problems of the related arts as mentioned above.

It is therefore an object of the present invention to provide an optical recording process using a recording medium which is capable of recording and erasing by a reversible phase change between an amorphous phase and a crystalline phase in the recording layer, and has a large degree of modulation and good stability in an amorphous mark. The optical recording medium is capable of recording and erasing by a reversible phase change between an amorphous phase and a crystalline phase, even at a high linear velocity of 10m/ s or more.

In order to solve the above problems, the inventors of the present invention have focused attention on materials in recording layer, and have dedicated to and pursued their studies, resulting in accomplishment of the present invention. The above problems can be solved by the following aspects of the present invention.

According to a first aspect of the present invention, an optical recording medium comprises a substrate and a recording layer disposed on the substrate, in which the recording layer comprises Ga and Sb, a content of the Sb is 80atm% to 95atm% relative to a total content of the Ga and the Sb in the recording layer, and recording and erasing are carried out by a reversible phase change between an amorphous phase and a crystalline phase in the recording layer.

According to a second aspect of the present invention, the recording and the erasing are carried out by the reversible phase change between the amorphous phase and the crystalline phase in the recording layer, when a laser beam having wavelength of 350nm to 700nm is irradiated at a linear velocity (V) one of between more than 3m/s and 40m/s or less.

According to a third aspect of the present invention, the recording and the erasing are carried out by the reversible phase change between the amorphous phase and the crystalline phase in the recording layer, at a linear velocity of 10m/s or more.

According to a fourth aspect of the present invention, the total content of the Ga and the Sb is 90atm% or more in the recording layer.

According to a fifth aspect of the present invention, the total content of the Ga and the Sb in the recording layer is 95atm% or more.

According to a sixth aspect of the present invention, the content of the Sb is 85atm% to 95atm% relative to the total content of the Ga and the Sb in the recording layer.

According to a seventh aspect of the present invention, the optical recording medium comprises the substrate, a first protective layer, the recording layer, a second protective layer, and a reflection layer. In the optical recording medium of the seventh aspect, the first protective layer, the recording layer, the second protective layer, and the reflection layer are disposed on the substrate in this order, and a thickness of the reflection layer satisfies a relation of: $0.10\lambda$ or more, when the "$\lambda$" expresses the wavelength of the laser beam.

According to an eighth aspect of the present invention, the laser beam may have the wavelength of 630nm to 700nm.

According to a ninth aspect of the present invention, the optical recording medium comprises the substrate, a first protective layer, the recording layer, a second protective layer, and a reflection layer. In the optical recording medium of the ninth aspect, the first protective layer, the recording layer, the second protective layer, and the reflection layer are disposed on the substrate in this order, and each of a thickness of the first protective layer, a thickness of the recording layer, a thickness of the second protective layer, and a thickness of the reflection layer satisfies the following relations, when "$\lambda$" expresses the wavelength of the laser beam;

$$0.070\lambda \le t_1 \le 0.16\lambda$$

$$0.015\lambda \le t_2 \le 0.032\lambda$$

$$0.011\lambda \le t_3 \le 0.040\lambda$$

$$0.10\lambda \le t_4 \, ;$$

wherein "$t_1$" expresses the thickness of the first protective layer, "$t_2$" expresses the thickness of the recording layer, "$t_3$" expresses the thickness of the second protective layer, and "$t_4$" expresses the thickness of the reflection layer.

According to a tenth aspect of the present invention, the thickness of the recording layer may be 5nm to 25nm.

According to an eleventh aspect of the present invention, the thickness of the recording layer may be 8nm to 20nm.

According to a twelfth aspect of the present invention, the laser beam may have wavelength of 350nm to 450nm.

According to a thirteenth aspect of the present invention, the optical recording medium comprises the substrate, a first protective layer, the recording layer, a second protective layer, and a reflection layer. In the optical recording medium of the thirteenth aspect, the first protective layer, the recording layer, the second protective layer, and the reflection layer are disposed on the substrate in this order, and each of a thickness of the first protective layer, a thickness of the recording layer, a thickness of the second protective layer, and a thickness of the reflection layer satisfies the following relations, when "$\lambda$" expresses the wavelength of the laser beam;

$$0.070\lambda \le t_1 \le 0.5\lambda$$

$$0.015\lambda \le t_2 \le 0.05\lambda$$

$$0.011\lambda \le t_3 \le 0.055\lambda$$

$$0.10\lambda \le t_4 \, ;$$

wherein "$t_1$" expresses the thickness of the first protective layer, "$t_2$" expresses the thickness of the recording layer, "$t_3$" expresses the thickness of the second protective layer, and "$t_4$" expresses the thickness of the reflection layer.

According to a fourteenth aspect of the present invention, the optical recording medium comprises the substrate, a reflection layer, a second protective layer, the recording layer, a first protective layer, and a light transmittance layer. In the optical recording medium of the fourteenth aspect, the reflection layer, the second protective layer, the recording layer, the first protective layer, and the light transmittance layer are disposed on the substrate in this order, and each of a thickness of the reflection layer, a thickness of the second protective layer, a thickness of the recording layer, and a thickness of the first protective layer, and a thickness of the light transmittance layer satisfies the following relations, when "$\lambda$" expresses the wavelength of the laser beam;

$$0.10\lambda \le t_4 \le 0.75\lambda$$

$$0.011\lambda \le t_3 \le 0.055\lambda$$

$$0.015\lambda \le t_2 \le 0.05\lambda$$

$$0.070\lambda \le t_1 \le 0.5\lambda$$

$$0 \le t_5 \le 0.6\text{mm},$$

wherein "$t_4$" expresses the thickness of the reflection layer, "$t_3$" expresses the thickness of the second protective layer, "$t_2$" expresses the thickness of the recording layer, "$t_1$" expresses the thickness of the first protective layer, and "$t_5$" expresses the thickness of the light transmittance layer.

According to a fifteenth aspect of the present invention, the optical recording medium may further comprise one or more of the recording layers.

According to a sixteenth aspect of the present invention, the optical recording medium includes a first information layer which has one of the recording layers, and a second information layer which has other one of the recording layers in this order, from a direction that the laser beam is irradiated, and a light transmittance of the first information layer is 40% or more with the wavelength.

According to a seventeenth aspect of the present invention, the recording and the erasing are carried out by the reversible phase change between the amorphous phase and the crystalline phase in the recording layer, at a linear velocity of 14m/ s or more.

According to an eighteenth aspect of the present invention, the recording and the erasing are carried out by the reversible phase change between the amorphous phase and the crystalline phase in the recording layer, at a linear velocity of 28m/s or more.

According to a nineteenth aspect of the present invention, a reflectance (Rg) at an unrecorded space part satisfies a relation of 12% $\le$ Rg $\le$ 30%, when a laser beam having wavelength between 350nm and 700nm is irradiated.

According to a twentieth aspect of the present invention, the optical recording medium has a degree of modulation (M) of 0.4 or more, when the recording is carried out at a linear velocity (V) one of between more than 3m/ s and 40m/ s or less and at wavelength of a laser beam of between 350nm and 700nm, and the degree of modulation (M) satisfies a relation of:

$$M = (Rg-Rb)/Rg,$$

where "M" expresses the degree of modulation, "Rb" expresses a reflectance at a recording mark of the optical recording medium, and "Rg" expresses a reflectance at an unrecorded space part of the optical recording medium.

According to a twenty first aspect of the present invention, the optical recording medium has the degree of modulation (M) of 0.4 or more, when the recording is carried out by an optical lens having NA of 0.60 or more.

According to a twenty second aspect of the present invention, the optical recording medium has the degree of modulation (M) of 0.6 or more.

According to a twenty third aspect of the present invention, the optical recording medium has the degree of modulation (M) of 0.4 or more, when the recording is carried out at any linear velocity (V) between 10m/s and 35m/s.

According to a twenty fourth aspect of the present invention; the optical recording medium has the degree of modulation (M) of 0.6 or more, when the recording is carried out at any linear velocity (V) between 10m/ s and 35m/s.

According to a twenty fifth aspect of the present invention, the recording layer further comprises at least one element selected from Ag, Au, Cu, Zn, B, Al, In, Si, Ge, Sn, Pb, N, P, Bi, La, Ce, Gd, Tb, Mg, Co, Mn, Zr, Rh, Se, Fe, and Ir.

According to a twenty sixth aspect of the present invention, the element is at least one selected from Ag, Au, Cu, B, Al, In, Mn, Sn, Zn, Bi, Pb, Ge, Si., and N.

According to a twenty seventh aspect of the present invention, the recording layer comprises an alloy expressed by the following Formula (1);

$$Ga_\alpha Sb_\beta X_\gamma \qquad \text{Formula (1)}$$

where "X" expresses one of an element and a mixture of elements excluding Ga and Sb, "$\alpha$," "$\beta$," and "$\gamma$" are each expressed in atm%, and each satisfy relations of: "$\alpha + \beta + \gamma = 100$," "$5 \le \alpha \le 20$," "$80 \le \beta \le 95$," and "$0 < \gamma \le 10$."

According to a twenty eighth aspect of the present invention, the "X" comprises one of a single element and a mixture selected from Ag, Au, Cu, Zn, B, Al, In, Si, Ge, Sn, Pb, N, P, Bi, La, Ce, Gd, Tb, Mg, Co, Mn, Zr, Rh, Se, Fe, and Ir.

According to a twenty ninth aspect of the present invention, the recording layer comprises Ga, Sb, Bi, and Rh.

According to a thirtieth aspect of the present invention, the recording layer further comprises one element selected from Cu, B, N, Ge, Fe, and Ir.

According to a thirty first aspect of the present invention, the recording layer comprises Ga, Sb, Zr, and Mg.

According to a thirty second aspect of the present invention, the recording layer further comprises one element selected from Al, C, N, Se, and Sn.

According to a thirty third aspect of the present invention, the optical recording medium comprises the substrate, a first protective layer, the recording layer, a second protective layer, a reflection layer, and a surrounding protective layer. In the optical recording medium of the thirty third aspect, the first protective layer, the recording layer, the second protective layer, and the reflection layer are disposed on the substrate in this order, and the surrounding protective layer is disposed on a surface of the reflection layer.

According to a thirty fourth aspect a process for manufacturing an optical recording medium comprises the steps of: disposing a first protective layer, a recording layer, a second protective layer, a reflection layer in this order on a substrate, so as to manufacture an optical recording medium prior to initial crystallization; and irradiating a laser beam having a power density of 5mW/$\mu$m$^2$ to 50mW/$\mu$m$^2$ to the optical recording medium prior to initial crystallization, while rotating the optical recording medium prior to initial crystallization and radially moving the laser beam at a constant linear velocity for initial crystallization of 3m/s to 18m/s, so as to initially crystallize the optical recording medium prior to initial crystallization and manufacture the optical recording medium of the present invention.

According to a thirty fifth aspect of the present invention, the laser beam has the power density of 15mW/$\mu$m$^2$ to 40mW/$\mu$m$^2$, and the constant linear velocity for initial crystallization is 6m/s to 14m/s. the laser beam has the power density of 15mW/$\mu$m$^2$ to 40mW/$\mu$m$^2$, and the constant linear velocity for initial crystallization is 6m/s to 14m/s.

According to a thirty sixth aspect a sputtering target for manufacturing an optical recording medium which comprises an alloy is provided. In the sputtering target for manufacturing an optical recording medium of the thirty sixth aspect, the alloy is expressed by the following Formula (1);

$$Ga\alpha Sb\beta \qquad \text{Formula (1)}$$

where "$\alpha$" and "$\beta$" are each expressed in atm%, and each satisfy relations of: "$5 \le \alpha \le 20$" and "$80 \le \beta \le 95$."

According to a thirty seventh aspect of the present invention, the alloy is expressed by the following Formula (1);

$$Ga\alpha Sb\beta \qquad \text{Formula (1)}$$

where "$\alpha$" and "$\beta$" are each expressed in atm%, and each satisfy relations of: "$5 \le \alpha \le 15$" and "$85 \le \beta \le 95$."

According to a thirty eighth aspect a sputtering target for manufacturing an optical recording medium comprises an alloy, in which at least one element of the alloy is selected from Ag, Au, Cu, B, Al, In, Mn, Sn, Zn, Bi, Pb, Ge, Si, and N, a content of the element is 10atm% or less of other element of the alloy, and the alloy is expressed by one of the following Formula (1);

$$Ga\alpha Sb\beta \qquad \text{Formula (1)}$$

where "$\alpha$" and "$\beta$" are each expressed atm%, and each satisfy relations of: "$5 \le \alpha \le 20$" and "$80 \le \beta \le 95$."

According to a thirty ninth aspect of the present invention, the present invention provides an optical recording process which comprises the steps of: forming a laser beam which reversibly phase changes between an amorphous phase and a crystalline phase in a recording layer which is disposed on a substrate of the optical recording medium of the present invention, so as to have one of a single pulse and a plurality of pulses; and irradiating the laser beam to the optical recording medium at a linear velocity (V) one of between more than 3m/s and 40m/s or less, and at a recording power (Pw) having a power density of 20mW/$\mu$m$^2$ or more, so as to record in the recording layer.

According to a fortieth aspect of the present invention, the linear velocity (V) is one of between 10m/s and 35m/s.

According to a forty first aspect of the present invention, the laser beam is irradiated, so that a ratio of an erasing power (Pe) to the recording power (Pw) satisfies a relation of:

$$0.10 \leq \text{Pe}/\text{Pw} \leq 0.65,$$

where "Pe" expresses the erasing power and "Pw" expresses the recording power.

According to a forty second aspect of the present invention, the laser beam is irradiated so as to have a ratio of an erasing power (Pe) to the recording power (Pw) which satisfies a relation of:

$$0.13 \leq \text{Pe}/\text{Pw} \leq 0.6,$$

where "Pe" expresses the erasing power and "Pw" expresses the recording power.

BRIEF DESCRIPTION OF THE DRAWINGS

FIG. 1 is a sectional view showing an example of a schematic structure of an optical recording medium.

FIG. 2 is a sectional view showing another example of a schematic structure of an optical recording medium.

FIG. 3 is a sectional view showing an example of a schematic structure of an optical recording medium having two recording layers.

FIG. 4 is a perspective view showing an example of a schematic structure of an optical recording medium which can be used in the optical recording process according to the present invention.

FIG. 5 is a transmission electronographic image showing an example of a recording layer after an initial recording.

FIG. 6 is a view showing a recording strategy which is generally used for a rewritable optical recording medium.

FIG. 7 is a graph showing a result of measuring C/N ratio, using GaSb of EXAMPLE A-2.

FIG. 8 is a graph showing a result of evaluation of a degree of modulation, when a thickness of the recording layer was changed in EXAMPLE A-4.

FIG. 9 is a graph showing an example of the X ray diffraction of EXAMPLE A-5.

FIG. 10 is a graph to explain In-plane X-ray diffraction.

FIG. 11 is a diagram showing spectrum measured by In-plane X-ray diffraction as to an optical recording medium of EXAMPLE A-5.

FIG. 12 is a graph showing an example of an effect obtained by converting the powder X-ray diffraction measurement result into wavelength $\lambda = 1.54\text{Å}$ (0.154nm), as to the optical recording medium of EXAMPLE A-5.

FIG. 13 is a graph showing an example of a change in jitter value after having conserved a recorded-medium under a circumstance of 80˚C and 85% RH, as to the optical recording medium of EXAMPLE A-5.

FIG. 14 is a graph showing an example of a result of powder X-ray diffraction as to further alternative optical recording medium of EXAMPLE A-5.

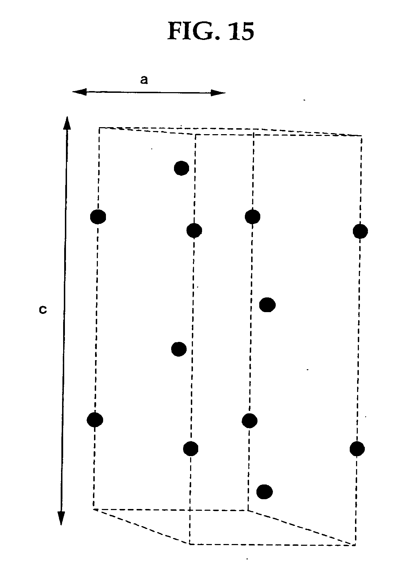

FIG. 15 is a graph showing an example of a unit lattice of hexagonal structure.

FIG. 16 is a graph showing a relationship between lattice constant and crystallization temperature.

FIG. 17 is a graph showing an example of spectrums measured by In-plane X-ray diffraction as to the optical recording medium of COMPARATIVE EXAMPLE A-1.

FIG. 18 is a result of recording test, which was conducted to the optical recording medium manufactured in EXAMPLE A-1.

FIG. 19 is a graph showing an example of plotted C/N ratios, when recording was carried out by changing the recording linear velocity, by utilizing the optical recording medium manufactured in EXAMPLE A-1.

FIG. 20 is a graph showing an example of plotted power conditions when the C/N ratio became maximum, and the optical recording medium manufactured in EXAMPLE A-1 was used and Pe/Pw (erasing power/recording power) of the laser beam to be used for recording was improved under the respective recording linear velocity conditions.

FIG. 21 is a graph showing a relationship between the recording linear velocity and the jitter properties in EXAMPLEs B-1 to B-4.

FIG. 22 is a graph showing a relationship among the thickness of the first dielectric layer, the reflectance, and the degree of modulation (M) in EXAMPLE B-5.

FIG. 23 is a graph showing a relationship between the thickness of the recording layer and the reflectance in EXAMPLE B-6.

FIG. 24 is a graph showing a relationship between the thickness of the recording layer and the reflectance in EXAMPLE B-6.

DESCRIPTION OF THE PREFERRED EMBODIMENTS

Referring to the accompanying drawings, the embodiments of the present invention will be described hereinafter.

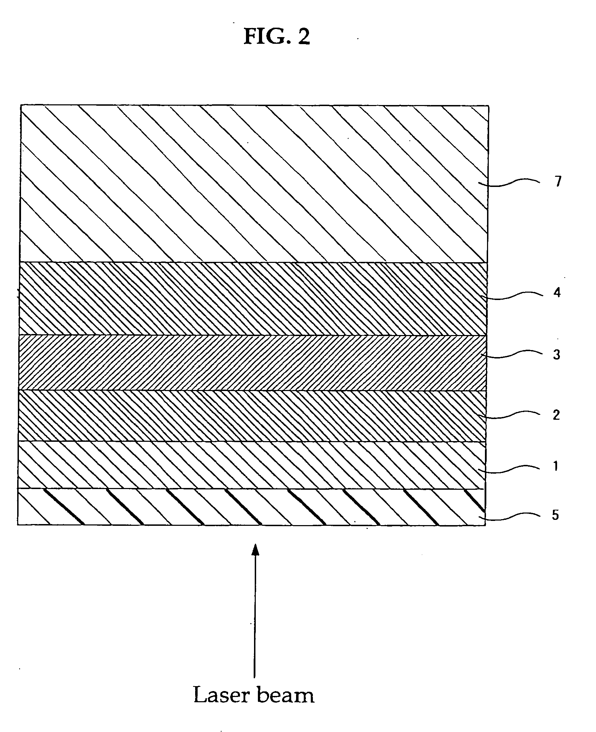

FIG. 1 and FIG. 2 are each sectional views showing examples of schematic structures of an optical recording medium. FIG. 1 shows a structure where a first protective layer 1, a recording layer 2, a second protective layer 3 and a reflection layer 4 are sequentially disposed on a substrate 7. Protective layer such as the first protective layer 1 and the second protective layer 3, are not required to be disposed. However, when the substrate 7 comprises a material having poor heat resistance such as a polycarbonate resin, the first protective layer is preferably disposed. A surrounding protective layer can also be disposed if necessary, though not shown in the figures.

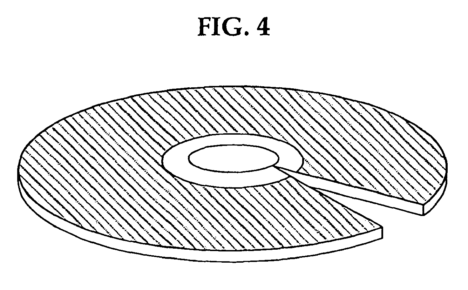

FIG. 2 shows an example of a structure where the reflection layer 4, the second protective layer 3, the recording layer 2, and the first protective layer 1 are sequentially disposed on the substrate 7, in the inverse order of the structure in FIG. 1. In the structure shown in FIG. 2, a light transmittance layer 5 is additionally disposed. Each of the optical recording media is subjected to recording and reproducing by irradiating a laser beam from the direction shown in FIGs. 1 and 2. An optical recording medium having the structure of FIG. 2 has a suitable structure for making the spot diameter of the laser beam smaller by enhancing numerical aperture (NA) of objective lens of an optical pickup, thereby allowing the recording mark to have higher density. The optical recording medium of the present invention preferably has a disk-shape. FIG. 4 is a perspective view showing an example of a schematic structure of an optical recording medium according to the present invention. A sectional view of a cut portion of the optical recording medium shown in FIG. 4 can be referred to as the one shown in FIG. 1, for example. Here, it should be noted that the optical recording medium of the present invention is not limited to the above configurations.

Hereinafter, the present invention will be described in detail.

As for material in a recording layer of the recent DVD system, there is already a marketed DVD system capable of recording at the speed of 2.5X (around 8.5 m/s recording linear velocity). Further demand has been made on a higher speed recording.

In view of this situation, the inventors of the present invention have researched and developed a recording material for an optical recording medium, which is capable of high density recording in a capacity equivalent to, or more than that of DVD-ROM, and which covers, at the same time, $\times$ 10 speed of recording (around 35 m/s or more). As a result, it has been found out that a preferable composition is the one closer to an eutectic composition of Ga and Sb.

It appears that the material, Ga and Sb, was proposed in development of a rewritable optical disk having reflectance interchangeability with CD-ROM in the middle of the 1980's. However, a low reflecting medium formed of AgInSbTe was alternatively proposed, and thus the Ga and Sb did not appear in the practical use.

The inventors of the present invention has found out that an optical recording medium is capable of recording and erasing by a reversible phase change between an amorphous phase and a crystalline phase by comprising a substrate and a recording layer disposed on the substrate in which the recording layer comprises Ga and Sb, and a content of the Sb is 80atm% to 95atm% relative to a total content of the Ga and the Sb in the recording layer. The optical recording medium having a composition ratio of the above is capable of recording at a high linear velocity, and of being applied to a wide range of the linear velocity at recording.

In the recording layer, a content of Sb is 80atm% to 95atm% relative to a total content of Ga and Sb. The content of Sb is preferable from a viewpoint of obtaining an optical recording medium having a good C/N ratio. The total content of Ga and Sb in the recording layer is preferably 90atm% or more, and more preferably 95atm% or more.

The optical recording medium of the present invention is capable of recording and erasing by a reversible phase change between an amorphous phase and a crystalline phase, preferably at a linear velocity of 10m/ s or more, more preferably at a linear velocity of 14m/s or more, and still more preferably at a linear velocity of 28m/s or more. Here, the optical recording medium of this aspect refers to the one that has a capability of recording and erasing at a linear velocity of 10m/s or more. The optical recording medium of this aspect may be or may not be capable of recording and erasing at a linear velocity of less than 10m/ s.

However, the inventors of the present invention have confirmed the following. As described above, a limit of a recording linear velocity of the optical recording medium formed of AgInSbTe is around 20 m/s. As for Ga Sb, it has been confirmed by an experiment that a sufficient degree of modulation can be obtained, at a linear velocity up to around 35 m/ s even with the Ga and Sb alone, when recording is carried out under a condition of 12% $\leq$ Rg $\leq$ 30%, preferably 20% $\leq$ Rg $\leq$ 30% (herein "Rg" expresses a reflectance at an unrecorded space part of a disk upon irradiating a laser beam having wavelength of between 350nm to 700nm), using a DVD recording system having lens NA of around 0.65. The optical recording medium thus manufactured maintains good jitter properties even upon repetitive overwriting, and has very few problems regarding archival stability.

In order to satisfy such conditions, the optical recording medium comprises a substrate, a first protective layer, a recording layer, a second protective layer, and a reflection layer. In the optical recording medium, the first protective layer, the recording layer, the second protective layer, and the reflection layer are disposed on the substrate in this order. A thickness of the reflection layer preferably satisfies a relation of "0.10λ or more," when the "λ" expresses wavelength of the laser beam.

When the wavelength of the laser beam is 630nm to 700nm, a thickness of the second protective layer and a thickness of the reflection layer each satisfy the following relations, and a thickness of the recording layer and a thickness of the first protective layer can mainly be adjusted.

$$0.011\lambda \leq t_3 \leq 0.040\lambda$$

$$0.10\lambda \leq t_4;$$

wherein "$t_3$" expresses the thickness of the second protective layer, and "$t_4$" expresses the thickness of the reflection layer. In particular, when the wavelength is determined, since the thicknesses of the recording layer and the protective layer are selected from an extremely limited range, it is easy to determine these thicknesses of the recording layer and the first protective layer.

The high reflectance within the "Rg," can be attained by thickening the recording layer and the first protective layer. Furthermore, in order to control the reflectance by the first protective layer within the range defined by the above relations of "Rg," the thickness of the recording layer preferably satisfies a relation of:

$$0.015\lambda \leq t_2 \leq 0.032\lambda,$$

wherein the "$t_2$" expresses the thickness of the recording layer.

The thickness of the first protective layer preferably satisfies a relation of:

$$0.070\lambda \leq t_1 \leq 0.16\lambda,$$

wherein the "$t_1$" expresses the thickness of the first protective layer.

If the thickness of the recording layer is within the range defined by the above relations, the thickness of the first protective layer may become larger than the thickness defined by the above relations. In the other words, the thickness of the first protective layer may satisfy other relations than the above in which the thicknesses are larger than the above relations.

If the thickness of the first protective layer satisfies the other relations than the above, it takes more time to form and dispose the first protective layer.

Therefore, from a viewpoint of manufacturing an optical disk (an optical recording medium), the thickness of the first protective layer is preferably within the range defined by the above relation, in order to produce at low-cost. Therefore, the thickness of the first protective layer preferably satisfies the relation of:

$$0.070\lambda \leq t_1 \leq 0.16\lambda,$$

wherein the "$t_1$" expresses the thickness of the first protective layer.

Since the reflectance changes an absorption factor of light energy in a disk (an optical recording medium), it is an important property that influences recording properties of a disk. That is, when "Rg" is more than 30%, recording energy shorts, and a sufficient degree of modulation cannot be obtained. On the other hand, when the "Rg" is less than 12%, sufficient signal strength, which is necessary for a recording system, cannot be obtained.

The second protective layer plays a role of efficiently transmitting the light energy to the reflection layer and the light energy having been absorbed in the disk (the light energy is mainly absorbed in a recording layer material), so as to dissipate the heat derived from the light energy. If the second protective layer is too thick, heat is kept inside and a recording mark becomes fuzzy or unclear. The recording property, particularly jitter property hence deteriorates. If the second protective layer is too thin, heat is released to the reflection layer before reaching a heat amount required to exhibit a phase change recording principle in which the light energy absorbed in the recording layer accumulates therein and the recording layer melts to produce a recording mark. Therefore, sufficient recording property may not be obtained. It is preferable that the second protective layer is not very thick, and is within a range defined by the above relation.

In addition, it is necessary to change the thickness of the second protective layer, since power density of a laser beam changes according to wavelength to be used in a recording system. This problem can be solved by placing the thickness within a range that satisfies the above relation. This can be applied to the thicknesses of the other layers.

Here, the jitter property is evaluated by mark-edge dispersion, $\sigma/Tw$, with respect to a channel cycle, "Tw."

The reflection layer plays a role of releasing the light energy, which has been absorbed in the disk (absorption is mainly carried out by a recording layer material), and also plays a role of reflecting the incident light of the light energy in an optical disk. If the thickness of the reflection layer satisfies a certain level, both of the roles can be carried out.

The inventors of the present invention have found out, through the experiments, that a preferable thickness of the reflection layer is around 60nm or more in order to attain the roles. The maximum thickness of the reflection layer is not particularly limited, as long as the thickness does not affect the manufacturing cost of the disk. The preferable thickness is considered to be 300nm or less.

When using the laser beam for recording, the thickness of the first protective layer is preferably 40nm or more, from a viewpoint of protecting the substrate from heat, and the thickness of the first protective layer is preferably 500nm or less, from a viewpoint that separation is less likely to occur between the substrate and a surface of the first protective layer.

The thickness of the first protective layer enables controlling a degree of modulation (M). In an optical recording medium comprising Ga and Sb according to the present invention, when a recording and reproducing system for a optical recording medium is utilized, there may be a case that a degree of modulation is small.

The degree of modulation (M), can be obtained by the following equation, when a recording test is carried out in an evaluation system of NA 0.65 and wavelength of 660nm, as currently used in a DVD for recording:

$$M = (IH - IL) / IH,$$

wherein "M" expresses the degree of modulation, "IH" expresses a signal level of a space part having a maximum mark length, and "IL" expresses a signal level of a space part having a maximum space length.

In the above condition, the degree of modulation (M) in the currently used optical disk system is required to be around 0.5 or more. On the other hand, if the aforementioned thickness of each of the layers is large, in particular, if the thickness of the first protective layer is large, the degree of modulation may become less than 0.4.

Note that "the reflectance at unrecorded space part, 'Rg,'" has the same meaning as the signal level of a space part having a maximum mark length, "IH," (a signal level when the laser beam was irradiated 100%, is considered as 100%). It also should be noted that "the reflectance at recording mark (recorded portion), 'Rb,'" has the same meaning as the signal level of a space part having a maximum space length, "IL."

The necessary degree of modulation when irradiating a laser beam having wavelength of 630nm to 700nm may be attained, and determining the thickness of the first protective layer so as to have the degree of modulation of 0.4 or more when irradiating the laser beam having the above-mentioned wavelength, and also by controlling the thicknesses of the first protective layer and the recording layer.

In order to have smaller recording marks and to have smaller intervals between the recording marks for achieving higher capacity of the optical recording medium, the wavelength of the laser beam is required to be short. The optical recording medium of the present invention realizes a higher capacity at the same time as having shorter wavelength of the laser beam. The optical recording medium of the present invention can be used when irradiating a laser beam having any wavelength of between 350nm to 450nm.

When irradiating a laser beam having wavelength of between 350nm to 450nm, the thicknesses of each of the layers of the optical recording medium shown in FIG. 1 and FIG. 2, preferably satisfy the following relations, when "$\lambda$" expresses wavelength of the laser beam to be irradiated.

Referring into FIG. 1 and FIG. 2, the thickness of the recording layer 2, "$t_2$," preferably satisfies a relation of "$0.015\lambda \le t_2 \le 0.05\lambda$." If the "$t_2$" is $0.015\lambda$ or more, it is preferable from a viewpoint of having a uniform thickness. If the "$t_2$" is $0.05\lambda$ or less, it is preferable from a viewpoint of recording sensitivity.

The thickness of the first protective layer 1, "$t_1$," preferably satisfies a relation of "$0.070\lambda \le t_1 \le 0.5\lambda$." If the "$t_1$" is $0.070\lambda$ or more, it is preferable from a viewpoint of protecting the substrate from heat generated upon recording. If the "$t_1$" is $0.5\lambda$ or less, it is preferable from a viewpoint of mass-production. The thicknesses, "$t_2$" and "$t_1$," are controlled or adjusted within the relations above, so as to have the most suitable reflectance when a laser beam is irradiated.

The thickness of the second protective layer 3, "$t_3$," satisfies a relation of "$0.011\lambda \le t_3 \le 0.055\lambda$." If the "$t_3$" is $0.011\lambda$ or more, it is preferable from a viewpoint of recording sensitivity. If the "$t_3$" is $0.055\lambda$ or more, it is preferable from a viewpoint that microscopic plastic deformation is accumulated inside the second protective layer 3, in accordance with repetitive overwriting and thus prevents an increasing noise level.

The thickness of the reflection layer 4, "$t_4$," preferably satisfies a relation of "$0.10\lambda \leq t_4$." The "$t_4$" is preferably $0.10\lambda$ or more, from a viewpoint of repetitive recording property. As shown in FIG. 2, if the reflection layer 4 is adjacent to the substrate 7, the thickness of the reflection layer 4, "$t_4$," satisfies a relation of "$0.10\lambda \leq t_4 \leq 0.75\lambda$.". If the "$t_4$" is larger than $0.75\lambda$, a shape of the recording layer 2 may become largely different from the groove of the substrate, and a problem such as crack may occur.

In the structure of FIG. 2, the thickness of the light transmittance layer 5 which is formed on the uppermost in the structure, "$t_5$," is preferably as thin as possible. For instance, "$t_5$" satisfies a relation of "$0 \leq t_5 \leq 0.6$ mm," so as to make a tilt margin larger, even when numerical aperture (NA) of an objective lens used for forming laser spot is large. If the "$t_5$" is larger than 0.6 mm, aberration may occur, causing an increase in errors.

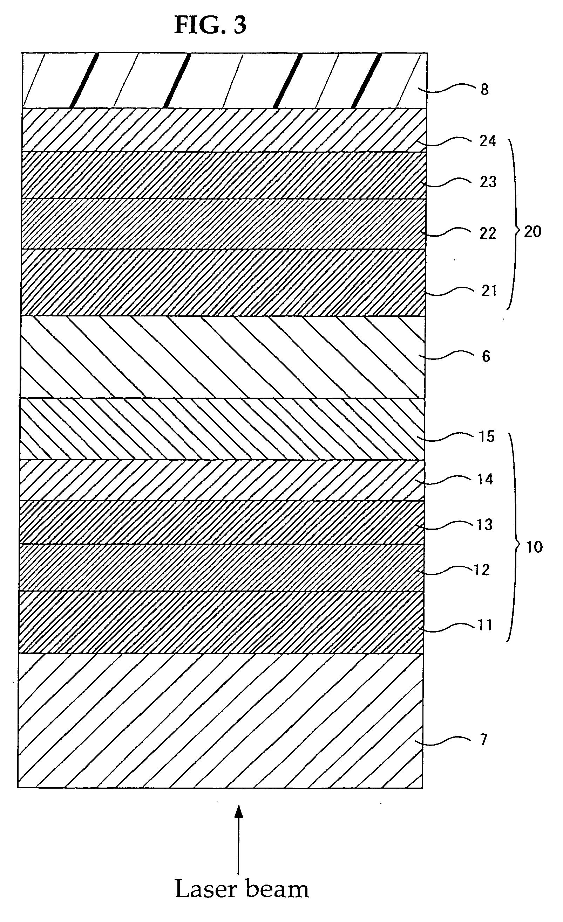

Furthermore, the optical recording medium of the present invention may have a multi-layer structure which has a high recording density, by providing two or more of the recording layers. FIG. 3 is a sectional view showing an example of a schematic structure of the optical recording medium having two of the recording layers. A first information layer 10, and a second information layer 20 are disposed in this order on the substrate 7. An intermediate layer 6 is disposed between the first information layer 10 and the second information layer 20. The first information layer 10 includes the first protective layer 11, the recording layer 12, the second protective layer 13, and the reflection layer 14. The second information layer 20 includes the first protective layer 21, the recording layer 22, the second protective layer 23, and the reflection layer 24. A heat dissipation layer 15 is provided between the intermediate layer 6 and the reflection layer 14. The heat dissipation layer 15 sufficiently dissipates heat which generates upon recording in the first information layer 10.

In order to achieve preferable recording and reproducing properties in the second information layer 20, the light transmittance of the first information layer 10 is required to be high. Therefore, in the optical recording medium of the present invention, the light transmission of the first information layer 10 is 40% or more, by adjusting the thickness of each of the layers in the first information layer 10. Specifically, it means to thin the recording layer 12. Since the material expressed by $Ga\alpha Sb\beta X\gamma$ is utilized, it is possible to attain a sufficient degree of modulation and crystallization speed, even with a thin recording layer 12. Accordingly, it is possible to attain good recording and reproducing, even with double layer-structure optical recording medium, and provides an optical recording medium having a large recording capacity.

As shown in the above, the recording layer of an optical recording medium according to the present invention comprises Ga and Sb. The recording layer may further comprise other element(s). The recording layer may comprise other element(s) than Ga and Sb in 10atm% or less of a total content of Ga and Sb. The other element(s) is preferably at least one selected from Ag, Au, Cu, Zn, B, Al, In, Si, Ge, Sn, Pb, N, P, Bi, La, Ce, Gd, Tb, Mg, Co, Mn, Zr, Rh, Se, Fe, and Ir. Containing at least one of the elements of the above may enable improving recording properties and resistance of the optical recording medium of the present invention.

For instance, containing 10atm% or less of a total content of Ga and Sb of at least one element selected from Ag, Au, Cu, B, Al, In, Mn, Sn, Zn, Bi, Pb, Ge, Si, and N, physical properties of the optical recording medium such as recording power, a recordable linear velocity, stability of amorphous mark, or the like, can be improved.

Adding a single substance of Ge or a mixture of Ge and at least one element selected from In, Al, Ag, Mn, Cu, Au, and N into the recording layer can also contribute to improving the degree of modulation (M).

A preferable composition ratio of the element(s) to be added into the recording layer is 10atm% or less.

For example, the inventors of the present invention have confirmed that adding around 3 atm% of In or Ge to GaSb enhances the degree of modulation by around 10%. The other elements show a similar effect. Here, in $Ga\alpha Sb\beta X\gamma$, "X" expresses an element other than Ga and Sb and a mixture thereof. In addition, "$\alpha$," "$\beta$," and "$\gamma$" each satisfy the relations of, in atm%, "$5 \leq \alpha \leq 20$," "$80 \leq \beta \leq 95$," "$0 < \gamma \leq 10$" and "$\alpha + \beta + \gamma = 100$." If "$\alpha$" is smaller than 5, crystallization speed is lowered and thus a recording and reproducing at a high linear velocity becomes difficult. On the other hand, if "$\alpha$" is larger than 20, cycle of repetitive overwriting may become deteriorated. If "$\beta$" is smaller than 80, a degree of modulation becomes as small as, for example, less than 0.4, between a reflectance of a recording mark and that of unrecorded space part. If "$\beta$" is larger than 95, cycle of repetitive overwriting may become less frequent. Furthermore, if "$\gamma$" is larger than 10, a storage properties may deteriorate.

The recording layer 2 can be formed by various vapor growth methods, including, for example, vacuum deposition method, sputtering method, plasma-CVD method, photo-CVD method, ion plating method, electron beam vacuum deposition method and the like. In particular, the sputtering method is preferable for mass production and for quality of film (layer), or the like.

The inventors have further confirmed that, by adding those elements other than Ga and Sb, it is possible to obtain an optical recording medium which is easily treated in a recording system, having further enhanced storage stability and requires less recording power, compared with an optical recording medium having a recording layer formed of GaSb alone. The addition of each of the elements may be optimized according to a necessity in the recording system.

When irradiating a laser beam having wavelength of 350nm to 450nm, the element(s) other than Ga and Sb is preferably at least one selected from Ag, Au, Cu, Zn, B, Al, In, Si, Ge, Sn, Pb, N, P, Bi, La, Ce, Gd, and Tb. The addition of the element(s) leads to an optical recording medium that can be easily treated, for example, enabling improving archival stability and requiring small laser power for recording.

An optical recording medium according to another aspect of the present invention comprises Bi and Rh as the elements other than Ga and Sb. The optical recording medium of another aspect focuses on a high-speed crystallization ability of Ga and Sb, and the inventors of the present invention have decided to employ GaSb for the components of the recording layer in order to attain a high-speed crystallization. Bi is also employed so as to improve such properties of GaSb that the initial crystallization is slightly difficult because of a high crystallization temperature. Addition of Bi has enabled higher crystallization speed and a sufficient degree of modulation. By further adding Rh, the archival stability and overwriting properties are improved.

The reason why the recording layer comprising Ga and Sb enables a high-speed crystallization has not yet been clear. An assumption has been made on that it is because the most adjacent distance between the atoms of Ga and Sb is 2.65Å (0.265nm) in the case of amorphous phase, and is 2.64Å (0.264nm) in the case of crystalline phase, and that the phase transferring between the amorphous phase to the crystalline phase can be carried out easily, accordingly.

Furthermore, having weak covalent bond, Bi enables weakening covalent bond of Ga and Sb. The crystallization temperature is lowered and re-arrangement of atoms is more easily enabled. Thus, the crystallization speed can be accelerated. Moreover, by adding Bi, a structure between amorphous phase and crystalline phase becomes largely changed, compared with that of GaSb alone. This results in a significant change of optical constant between amorphous and crystalline phases along with the phase transferring. Accordingly, it is possible to obtain a sufficient degree of modulation.

Although it is still unknown how the addition of Rh influences the improvement of archival stability and overwriting properties, an assumption has been made on that a passive state is created by adding Rh, and oxidation may be prevented. Since having a high melting point, Rh prevents substance flow during overwriting, and improves the overwriting properties, as a result.

A content of Bi is preferably 1atm% to 5atm% in the recording layer, and a content of Rh is preferably 1atm% to 3atm% in the recording layer.

Containing 1atm% or more of Bi in the recording layer, crystallization temperature becomes lower, and a degree of modulation improves. If the content of Bi is more than 5atm%, archival stability deteriorates. Containing 1atm% or more of Rh in the recording layer, archival stability and overwriting properties improve. If the content of Rh is less than 3atm%, recording sensitivity deteriorates. In this aspect, the content of Sb is preferably 94atm% or less in the recording layer.

The recording layer which comprises Bi and Ri in addition to Ga and Sb, may further comprise at least one element selected from Cu, B, N, Ge, Fe, and Ir. The optical recording medium having the above recording layer may have a sufficient degree of modulation, with an equivalent capacity of that of DVD-ROM at a recording linear velocity of 3.0 m/ s to 35 m/ s. The optical recording medium also have good overwriting repetitive properties, and have better archival stability.

It is considered to be because in the case of B, N and Ge, those elements have strong covalent bonding property, and thus tend to be connected with an unconnected bond of host material (elements contained in the recording layer), which prevents oxidation. It is still not clear how Cu, Fe, and Ir improve the archival stability. An assumption has been made on that Cu, Fe, and Ir also tend to connect with unconnected bonds of the host material, which prevents oxidation.

A content of at least one element selected from Cu, B N, Ge, Fe, and Ir is preferably 1atm% to 3atm% in the recording layer. If the content of the element is less than 1atm%, there is no effect derived from the addition, which is not preferable. If the content of the element is more than 3atm%, the crystallization speed become lowered, which is not preferable.

In the aspect of the present invention above, thicknesses of the first protective layer and the second protective layer is preferably 20nm to 300nm.

The first protective layer and the second protective layer are each preferably formed by sputtering method using ZnS and $SiO_2$.

The first protective layer and the second protective layer each play a role of protecting the optical recording medium from heat (a role of a heat resistant layer) at the same time as playing a role of a light interference layer.

If the thickness of the first protective layer is less than 200Å (20nm), the first protective layer does not work as the heat resistant layer that prevents damage to the substrate from heat. If the thickness of the first protective layer is more than 3000Å (300nm), the separation of interface between layers, is more likely to occur. The thickness of the first protective layer is therefore preferably 200Å (20nm) to 3000Å (300nm). In order to work as the light interfering layer, the thickness of the first protective layer more preferably satisfies a relation of:

$$0.070\lambda \leq t_1 \leq 0.16\lambda,$$

wherein "$t_1$" expresses the thickness of the first protective layer, and "$\lambda$" expresses the wavelength of the laser beam.

The second protective layer plays a role of effectively dissipating the heat absorbed in the recording layer toward the reflection layer, and a role of preventing a reaction between the recording layer and the reflection layer.

The thickness of the second protective layer is preferably 20Å (2nm) or more. The second protective layer is formed preferably as thin as possible. If the second protective layer is too thin, however, the beam power upon recording has to be large. When using a laser beam having wavelength of 630nm to 700nm, as utilized in DVDs, the thickness of the second protective layer preferably satisfies a relation of:

$$0.011\lambda \leq t_3 \leq 0.040\lambda,$$

wherein "$t_3$" expresses the thickness of the second protective layer, and "$\lambda$" expresses the wavelength of the laser beam.

The recording layer of the aspect of the present invention above is formed ordinarily by sputtering method. A thickness of the recording layer of the aspect is preferably 10nm to 100nm, and more preferably 20nm to 35nm.

If the thickness of the recording layer is smaller than 10nm, light absorption properties deteriorate, and a function as a recording layer is lost. If the thickness of the recording layer is larger than 100nm, a less laser beam is transmitted, and an interference effect cannot be expected.

The reflection layer of the aspect comprises Ag alloy. The reflection layer can be formed by the sputtering method. The reflection layer works also as a heat dissipation layer. A preferable thickness of the reflection layer is 50nm to 200nm, and more preferably, 70nm to 150nm.

In an optical recording medium according to other aspect of the present invention, the recording layer comprises Zr and Mg, as the other elements than Ga and Sb. In the other words, the present invention focuses on high speed crystallization speed derived from Ga and Sb. This is why Ga and Sb are contained in the recording layer of the optical recording medium of the present invention. Mg is employed so as to improve such properties of GaSb that the initial crystallization is slightly difficult because of its high crystallization temperature.

Addition of Mg enables lowering the crystallization temperature of GaSb, higher speed crystallization and a sufficient degree of modulation. Addition of Zr to the GaSb further improves archival stability and overwriting properties of the recording layer.

The reason why the recording material which contains a combination of Ga and Sb, Zr, and Mg enables a high speed crystallization have not yet been clear. An assumption has been made on that it is because the most adjacent distance between the atoms of GaSb alloy is 2.65Å (0.265nm) in the case of amorphous phase, and is 2.64Å (0.264nm) in the case of crystalline phase, and that the phase transferring between the amorphous phase to the crystalline phase can be carried out with slight transferring of the atoms, accordingly.

Decrease in crystallization temperature because of addition of Mg is derived from weakening the bonding among Ga-Sb-Mg alloy, since Mg has weak covalent bonding.

Re-arrangement of atoms is more easily enabled. Thus, the crystallization speed can be accelerated. Moreover, by adding Mg, a structure between amorphous phase and crystalline phase becomes largely changed, compared with that of GaSb alloy. This results in a significant change of optical constant between amorphous and crystalline phases along with the phase transferring. Accordingly, it is possible to improve the degree of modulation.

Although it is still not very clear how the addition of Zr influences the improvement of archival stability and overwriting properties, an assumption has been made on that a high melting point of Zr controls a substance flow, thereby the overwriting properties are improved. Furthermore, a passive state is easily created by adding Zr, which prevents oxidization, thereby improving the archival stability.

According to the above aspect of the present invention, by use of the phase change alloy of the above composition for the recording layer, it is possible to obtain a optical recording medium having a large recording capacity equivalent to that of DVD-ROM, and even at a wide range of recording linear velocity of 3.5 m/s to 35 m/s, including a high linear velocity of 25 m/s or more, and it still improves the degree of modulation, good in overwriting and its repeating property, and further a high archival stability.

In the aspect above, a content of Zr in the recording layer is preferably 0.5atm% to 5atm%, and a content of Mg in the recording layer is preferably 1atm% to 6atm%.

Containing 0.5atm% or more of Zr in the recording layer improves archival stability and overwriting properties. If the content of the Zr is more than 5atm%, crystallization speed and recording sensitivity deteriorate. Containing 1atm% or more of Mg in the recording layer lowers crystallization temperature, and enables easier initial crystallization, and further accelerates crystallization speed. Moreover, containing 1atm% of Mg enables faster crystallization speed, enables easier overwriting at a high linear velocity of 35m/s, and improves the degree of modulation.

If the content of Mg is more than 6atm%, archival stability deteriorates.

In the aspect above, a content of Ga is preferably 6atm% or more, from a viewpoint of crystallization speed. A content of Sb here is preferably 90atm% or less, from a viewpoint of improving the number of cycle of repetitive overwriting.

As a further preferable phase change alloy to be used for the recording layer, there is suggested a recording material in the recording layer comprising Ga, Sb, Zr, and Mg, together with one element selected from Al, C, N, Se, and Sn. When Al, C, N, and Se are added, the archival stability is further improved. When Al, and Sn are added, the crystallization speed is further improved and overwriting can be carried out at a linear velocity of, for example, 35m/ s, on the other hand.

A content of the element selected from Al, C, N, Se, and Sn in the recording layer is preferably 1atm% to 3atm%. Containing 1atm% or more of the element in the recording layer enables exhibiting the above effects such as good archival stability, overwriting properties at the linear velocity of 35m/s, or the like.

Containing more than 3atm% of the element in the recording layer, recording sensitivity deteriorates in a case of Al, C, N, Se, and crystallization temperature decreases and hence archival stability deteriorates in a case of Sn.

The content of Ga, Sb, Zr, and Mg in the recording layer and the reason for the contents are the same as the previously given reasons for the case of Ga, Sb, Zr, and Mg.

The recording layer can be formed by various vapor growth methods, for example, sputtering method, as described in the above. In the aspect above, the thickness of the recording layer is 10nm to 100nm, and more preferably 20nm to 35nm.

If the recording layer is thinner than 10nm, light absorption ability deteriorates, and a function as a recording layer may be lost. If the recording layer is thicker than 100nm, less light is transmitted to the recording layer, and an interference effect may not be expected.

A material of substrate 7 is ordinarily, glass, ceramics or a resin. Of these, a resin is preferable from a viewpoint of capability of forming and cost. Specific examples of the resin include a polycarbonate resin, an acrylic resin, an epoxy resin, a polystyrene resin, an acrylonitrile-styrene copolymer resin, a polyethylene resin, a polypropylene resin, a silicone resin, a fluorine resin, an ABS resin, a urethane resin, and the like. Of these, a polycarbonate resin or an acrylic resin such as polymethyl methacrylate (PMMA) or the like is preferable from a viewpoint of capability of forming, optical properties, and cost. Concavoconvex patterns such as guide grooves are formed on the substrate 7, and the substrate 7 is formed by injecting molding or a photopolymer method. The formation or the shape of the substrate 7 can be any of disk, card, sheet or the like.

Materials of a reflection layer 4 can be metals such as Al, Au, Ag, Cu, Ta, and W, or an alloy thereof. Of these, Ag, Cu, Au is preferably used as the material when recording at a high linear velocity. Cr, Ti, Si, Pd, Ta, Cu, In, Mn, or the like, can be added to the reflection layer 4 either alone or in combination of two or more. The reflection layer 4 can be formed by various vapor growth methods, for example, vacuum deposition method, sputtering method, plasma-CVD method, photo-CVD method, ion plating method, electron beam vacuum deposition method or the like. Of these, the sputtering method is preferable for mass production, for quality of the layer, and the like.

The first protective layer 1 plays a role of protecting the recording layer 2 so that impurities such as moisture or the like from the substrate 7 is not to be included in a recording layer, of preventing thermal damage on the substrate 7, and of adjusting optical properties, and the like. Therefore, the first protective layer 1 preferably is unlikely to penetrate moisture, preferably has good heat resistance, a small absorptance (k) and refractive index (n).

Materials of the first protective layer 1 and the second protective layer 3 can be metal oxide such as SiO, $SiO_2$, ZnO, $SnO_2$, $Al_2O_3$, $TiO_2$, $In_2O_3$, MgO, $ZrO_2$, or the like; nitride such as $Si_3N_4$, AlN, TiN, ZrN, or the like; sulfide such as ZnS, $In_2S_3$, $TaS_4$, or the like; carbides such as SiC, TaC, $B_4C$, WC, TiC, ZrC, or the like; diamond like carbon, and the like. These materials can be used either alone or in a mixture of two or more in order to form each of the first and second protective layers. In addition, these materials may inevitably include impurities. It is necessary that a melting point of the first protective layer 1 and that of the second protective layer 3 are higher than that of the recording layer 2. The first protective layer 1 and the second protective layer 3 can be formed by various vapor growth methods, for example, vacuum deposition method, sputtering method, plasma-CVD method, photo-CVD method, ion plating method, electron beam vacuum deposition method or the like. Of these, the sputtering method is preferable for mass production, for quality of the layer, and the like. It is preferable to form the first protective layer 1 and the second protective layer 3 by sputtering method, using $(ZnS) \cdot (SiO_2)$.

Material of the light transmittance layer 5 is preferably resin, from a viewpoint of ability of forming and cost. Examples of the resin include a polycarbonate resin, an acrylic resin, an epoxy resin, a polystyrene resin, an acrylonitrile-styrene copolymer resin, a polyethylene resin, a polypropylene resin, a silicone resin, a fluorine resin, an ABS resin, a urethane resin and the like. Of these, a polycarbonate resin or an acrylic resin such as polymethyl methacrylate (PMMA), or the like, is preferable from viewpoints of ability of forming, optical properties, and cost. It is also preferable to use an ultraviolet setting resin.

The light transmittance layer 5 may have concavoconvex patterns such as guide grooves. The concavoconvex patterns are molded by injecting molding or a photopolymer method, as in the substrate 7.

Examples of the material for the intermediate layer include ITO formed of InO and SnO, and the like.

Examples of an overcoat layer, which will be mentioned in the followings, include an acrylic resin, and the like.

EXAMPLES

The present invention will be described in more detail with reference to the following EXAMPLES. It should be noted that the present invention is not limited to those EXAMPLES and conditions for manufacturing can be suitably changed or adjusted according to necessity.

(EXAMPLE A-1)

On a 0.6mm thick polycarbonate substrate having a guiding groove which is formed of track pitch of $0.74\mu m$ and of groove depth of 400Å (40nm), and also having a diameter of 120mm, a 75nm thick first protective layer comprising $ZnS \cdot SiO_2$ mixture target (in which $SiO_2$ was 20 mol%), a 16 nm thick recording layer comprising Ga12Sb88 (atm%) alloy target, a 14 nm thick second protective layer comprising the same target as those for the first protective layer, and a 140nm thick reflection layer comprising Ag-Pd (1 atm%)-Cu(1 atm%) target, were sequentially disposed in this order by the sputtering method.

As for the alloy target of the recording layer, a feed amount thereof was weighed beforehand, and was heated and melted in a glass ampoule. Thereafter, it was taken out to be pulverized into powder by a pulverizer. The powder thus obtained was heated and sintered, thereby making a disc-shaped target. Composition ratio of the recording layer after deposition was measured by the inductively coupled plasma (ICP) emission spectrochemical analysis. The resulted composition ratio was the same as that of the elements of the target. For the ICP emission spectrochemical analysis, Sequential type ICP atomic emission spectrometer SPS4000, produced by Seiko Instruments Inc., was used. It should be noted that, in the following EXAMPLES A-2 to A-7, and COMPARATIVE EXAMPLE A-1, the composition ratio of the alloy in the recording layer and the composition ratio of the alloy of the sputtering target were identical.

Subsequently, on the reflection layer, an around $5\mu m$ to $100\mu m$ thick surrounding protective layer comprising an acrylic resin was disposed by a spin coating method. On the surrounding protective layer, a 0.6mm thick substrate, which was as thick as the substrate originally formed, was adhered to an ultraviolet setting resin, so as to manufacture the optical recording medium of the EXAMPLES As. Initial crystallization was carried out by rotating thus obtained optical recording medium at a constant linear velocity of 3m/s, while a laser beam having a power density of 8 mW/$\mu m^2$ was irradiated radially, and moving the laser beam at $36\mu m/r$.

Recording and reproducing was carried out to the optical recording medium, by using a pickup having wavelength of 660nm and NA of 0.65. Random patterns were recorded by EFM+ modulation technique, which is a modulation technique of DVD, under the recording conditions of a recording linear velocity of 17m/s, recording linear density of $0.267\mu m/bit$, which is the same capacity as that of DVD-ROM, recording power (Pw) of 20mW, and erasing power (Pe) of 7mW.

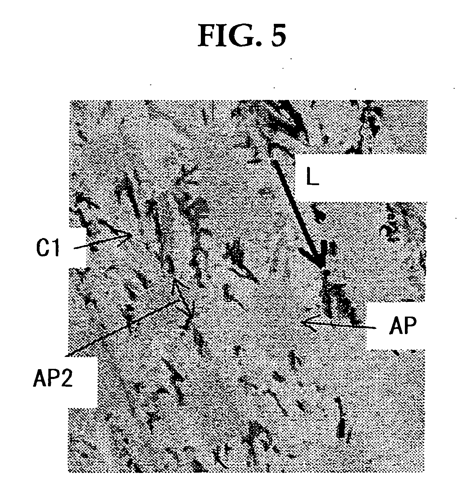

FIG. 5 shows a transmission electron microscope image of the recording layer after the first recording.

As shown in FIG. 5, it was observed that a mark AP 2 (gray portion without black and white contrast in the figure) which had around $0.4\mu m$ of the shortest mark and around $1.8\mu m$ of the longest mark in the laser beam scanning direction (expressed by an arrow L), were recorded randomly. The gray area was analyzed by an electron beam diffraction and it was found to be a halo pattern which indicated that this area was in amorphous material phase AP (amorphous phase). On the other hand, when the area having a clear contrast of black and white was analyzed by the electron beam diffraction, spots indicating crystalline phase C1 were observed.

Furthermore, when the recording layer was observed by its transmission electron microscope image after 10 time direct overwriting (DOW), an image similar to the initial recording was observed. Therefore, it was confirmed that a repetitive recording could be carried out by the phase change between an amorphous phase and a crystalline phase.

In a similar manner as described above, an optical recording medium that had a different composition ratio of the recording layer was manufactured. An amorphous phase and a crystalline phase were observed from the transmission electron microscope images after initial recording and 10 time DOW at a recording linear velocity of 10 m/ s. It was confirmed that repetitive recording was carried out by phase change between the amorphous phase and the crystalline phase.

Composition ratios and results in a case of GaSb are shown in TABLE 1. "○" in the table expresses that crystalline phase and amorphous phase were observed. "× (1)" expresses that an amorphous phase was not observed under any recording conditions. This is because crystallization speed of the recording material was too fast, and a sufficient rapid cooling condition could not be obtained within recording conditions available in a current optical recording apparatus, and as a result, an entire portion of the recording layer was crystallized. " $\times$ (2)" expresses that amorphous phase was observed, but was still formed on a space part of the recording layer, which should have been crystallized entirely, and that the recording linear velocity herein did not enable erasing.

[TABLE 1]

| Ga (atm%) | Sb (atm%) | Initial recording | After 10 times DOW |
|---|---|---|---|
| 3 | 97 | $\times$ (1) | $\times$ (1) |
| 5 | 95 | ○ | ○ |
| 7 | 93 | ○ | ○ |
| 12 | 88 | ○ | ○ |
| 18 | 82 | ○ | ○ |
| 20 | 80 | ○ | ○ |
| 22 | 78 | ○ | $\times$ (2) |

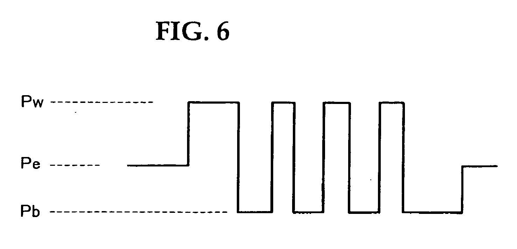

On a rewritable optical recording medium, recording and erasing are generally carried out by a recording strategy as shown in FIG. 6. Usually, the recording strategy includes recording power (Pw) (mW), erasing power (Pe), and bias power (Pb: here, "Pb" is 1mW or less), in descending order from higher power. By irradiating pulses to drastically reduce the power from "Pw" to "Pb," the recording layer is rapidly cooled, and an amorphous phase is thus formed. On the other hand, by irradiating the constant power (Pe), the recording layer is gradually cooled and a space (crystalline phase) is formed. Amorphous phase was formed in the space part, which should have become a crystalline phase, because the recording linear velocity was too fast with respect to the crystallization speed of the recording material.
According to those results, the preferable composition ratio of the recording layer was found out to be shown in the following Formula (1);

$$Ga\alpha Sb\beta \qquad \text{Formula (1)}$$

wherein "$\alpha$" and "$\beta$" were each expressed in "atm%," and each satisfied the relations of "$5 \leq \alpha \leq 20$," and "$80 \leq \beta \leq 95$."
As for GaSb, the detailed explanation in Japanese Patent Application Laid-Open (JP-A) No. 61-168145 states that "If the composition ratio of Ga becomes 20% or less, a prominence may occur probably due to air bubble, causing instability of variation level of reflectance coefficient. Therefore, there may be a problem in practical use." According to this description, it has been confirmed that the optical recording medium of the present invention and that of the JP-A No. 61-168145 are substantially different from each other.
This fact indicates that, when phase change between amorphous and crystalline phases is utilized, as in the present invention, the composition ratio capable of obtaining excellent recording properties is apparently different from that in the JP-A No. 61-168145 where the phase change between crystal and crystalline phases is used.

(EXAMPLE A-2)

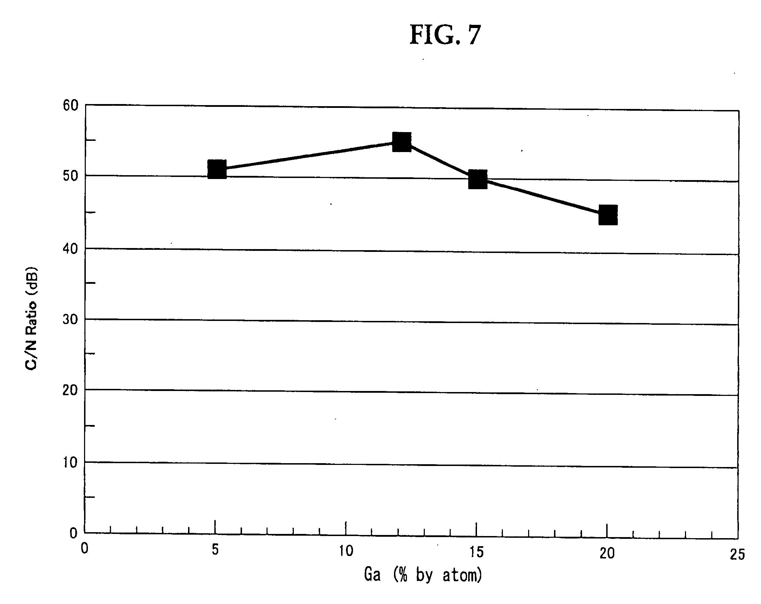

Optical recording media were manufactured in the same manner as in EXAMPLE A-1, except that the alloy target for recording was replaced with GaSb alloy having an identical composition to that of the recording layer shown in TABLE 2. Thereafter, those optical recording media were subjected to initial crystallization as in EXAMPLE A-1.
With respect to these optical recording media, C/N ratios [ratio between noise (N) level and signal intensity (C: carrier) was measured by spectrum analyzer] after 10 time DOW (direct overwriting) of 3T under the same recording conditions as those of EXAMPLE A-1, are shown in TABLE 2, and FIG. 7. In order to implement a rewritable optical disc system, the C/N ratio is required to be at least 45dB. If it is 50dB or more, further stable system can be obtained.

[TABLE 2]

| Ga (atm%) | Sb (atm%) | C/N ratio(dB) after 10 times DOW of 3T |
|---|---|---|
| 3 | 97 | - |
| 5 | 95 | 51 |

(continued)

| Ga (atm%) | Sb (atm%) | C/N ratio(dB) after 10 times DOW of 3T |
|---|---|---|
| 12 | 88 | 55 |
| 15 | 85 | 50 |
| 20 | 80 | 45 |
| 25 | 75 | - |

Furthermore, optical recording media were manufactured in the same manner as in EXAMPLE A-1, except that the alloy target for recording was replaced with GaSb alloy having a composition ratio of the recording layer shown in TABLE 3. Thereafter, the optical recording media were subjected to initial crystallization as in EXAMPLE A-1.

With respect to these optical recording media, C/N ratios [ratio between noise (N) level and signal intensity (C: carrier) which was measured by spectrum analyzer] after 10 time DOW (direct overwriting) of 3T under the same recording conditions as those of EXAMPLE A-1, except that the recording linear velocity were set to 10m/s,14m/s, 28m/s, and 35m/s, are shown in TABLE 3.

[TABLE 3]

| | | C/N ratio(dB) after 10 time DOW of 3T | | | |
|---|---|---|---|---|---|
| Ga (atm%) | Sb (atm%) | 10 m/s | 14 m/s | 28 m/s | 35 m/s |
| 3 | 97 | × | × | × | × |
| 4 | 96 | × | Δ | Δ | ○ |
| 5 | 95 | ○ | ◎ | ◎ | ◎ |
| 12 | 88 | ◎ | ◎ | ◎ | ◎ |
| 15 | 85 | ◎ | ◎ | ◎ | ○ |
| 20 | 80 | ◎ | ○ | Δ | Δ |
| 25 | 75 | Δ | × | × | × |
| ◎: 50dB or more ○: 45dB or more Δ: 40dB or more ×: less than 40dB | | | | | |

According to those results, the preferable composition ratio of the recording layer was found out to be expressed in the following Formula (1);

$$Ga_\alpha Sb_\beta \qquad \text{Formula (1)}$$

wherein "$\alpha$" and "$\beta$" were each expressed in atm% and each satisfied the relations of "$5 \leq \alpha \leq 20$," and "$80 \leq \beta \leq 95$."

When "$\alpha$" and "$\beta$" each satisfied the above relations, it was possible to carry out recording even at a recording linear velocity of 10 m/s to 35m/s. However, in the case of Ga3Sb97, an amorphous phase was not formed, and further, in the case of Ga25Sb75, repetitive recording could not be carried out. In order to certainly obtain a stable system having C/N ratio of 45dB or more, the composition ratio of GaSb preferably satisfies relations of: "$5 \leq \alpha \leq 15$," and "$85 \leq \beta \leq 95$."

(EXAMPLE A-3)

Optical recording media were manufactured in the same manner as in EXAMPLE A-1, except that the alloy target for recording was replaced with an alloy which was obtained by adding 5 atm% of each of Ag, In, Sn, Ge, to Ga12Sb88. Thereafter, the optical recording media were subjected to initial crystallization as in EXAMPLE A-1.

As for thus obtained four of the optical recording media, recording test was conducted in a similar manner as that of EXAMPLE A-1. The alloy to which Ag or In was added, was capable of reducing recording power required to obtain the same degree of modulation as that in the case of recording using Ga12Sb88 alone, with Pw of 30mW at the recording linear velocity of 28m/ s. When Ag was added, the recording power was reduced by 10%, and when In was added, it was reduced by 13% or less.

With a criteria for 45dB or more for the C/N ratio, however, an alloy having the composition ratio of Ga12Sb88 alone enabled recording at a linear velocity of 36 m/s to 38 m/s. On the other hand, the alloy having Ag additionally produced a result that a range of a linear velocity was reduced by 10%. The alloy having In additionally produced a result that a range of a linear velocity was reduced by 5% or less.

As for the alloy to which Sn was added, under the condition of recording linear velocity of 28m/ s, the recording power to obtain the same degree of modulation was approximately equal to that of using Ga12Sb88 alone, but a range of the recording linear velocity became higher by around 7%.

As for the alloy to which Ge was added, the recording linear velocity range was reduced by around 10%, and around 5% more recording power was required. However, when a archival stability test was conducted at high temperature of 80°C and high humidity of 85%RH, it was found out that increase of jitter value after a lapse of 500 hours was around 1.5%, and that, in the case of Ga12Sb88 alone, contrary to the case of Ge addition, it could be reduced by within 0.5%.

Similarly, optical recording media were manufactured with Ga12Sb88, the additive elements to which were replaced by 5 atm% of Au, Cu, B, Al or Mn, it was possible to reduce recording power, as shown in the cases of Ag or In. Further, when optical recording media were manufactured with Ga12Sb88, the additive elements to which were replaced with 5 atm% of Zn, Si, Bi and Pb, a recording linear velocity became higher as shown in the case of Sn. Further, when an optical recording medium was manufactured with Ga12Sb88, the additive element to which was replaced by 2 atm% of N, a stability of amorphous mark was improved, as shown in the case of Ge.

In an actual composition ratio, sufficient recording properties can be obtained with GaSb alone. However, it is possible to control the recording layer material properties by adding the above elements either alone or in combination of two or more, according to the intended use.

Furthermore, using an alloy, which was provided by adding In to Ga12Sb88, a suitable additive amount of In was evaluated. When the content of In was more than 10 atm%, the recording linear velocity became 10 m/s or less. When a archival stability test was conducted under a condition of high temperature of 80°C and 85%RH of high humidity, a defect was found that reflectance change was significantly deteriorated, and then it was found that a high speed recording, a purpose of the present invention, became not possible. The same tendency was found when Ag, Au, Cu, B, Al, or Mn was added to the alloy.

Furthermore, as for the alloy to which Sn was added, when the additive amount was more than 10%, the same degree of modulation could not be obtained although the recording power was increased by 30%, comparing to the case that the additive amount was 5%. In such a case, even if a maximum recording power which could be provided by a currently available recording system, is used, there may be a possibility that sufficient signal cannot be obtained. Similar tendency was found in the case of using the alloy to which Zn, Bi, or Pb was added. As for the alloy added with Ge, when the additive amount was more than 10%, the recording linear velocity became 10m/s or less, as shown in the case of an alloy to which In was added. Further, larger recording power was required by 30% or more, compared to the case of using Ga12Sb88 alone. It should be noted that as for N, it was taken into the alloy by gas phase reaction when the recording layer was subjected to sputtering, but admixture amount 5atm% or more of N was found to be difficult.

(EXAMPLE A-4)

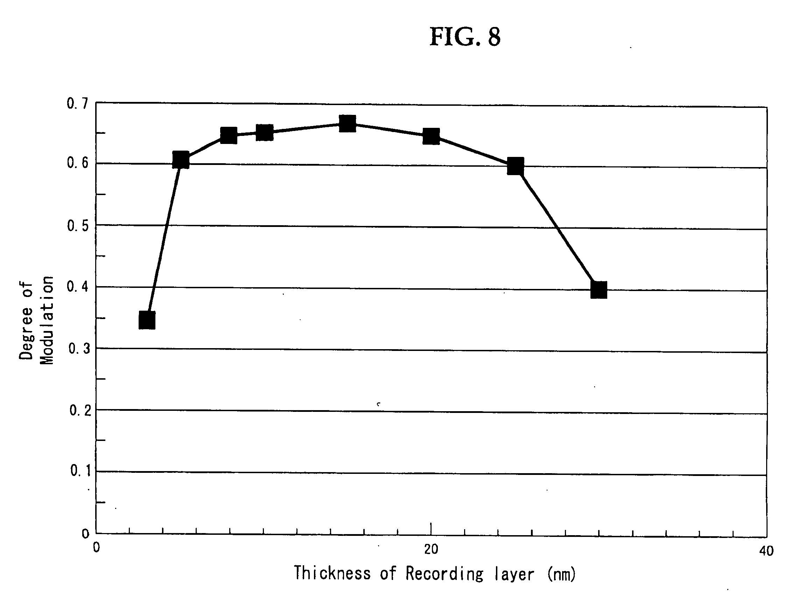

Optical recording media were manufactured in the same manner as in EXAMPLE A-1, except that thicknesses of the recording layer were changed to 3nm, 5nm, 8nm, 10nm, 15nm, 20nm, 25nm and 30nm, respectively. After initial crystallization as in EXAMPLE A-1 was carried out thereon, C/N ratios and a degree of modulation were evaluated in the same manner as in EXAMPLE A-1. The results are shown in TABLE 4 and FIG. 8. When the thickness of the recording layer was 5nm to 25nm, a degree of modulation was 0.6 or more, which satisfies a DVD standard, was obtained. A preferable thickness of the recording layer was 8nm to 20nm. Within this range, the degree of modulation was 0.65 or more, and further stable system can be obtained.

[TABLE 4]

| Dependence of recording layer thickness | | |
| --- | --- | --- |
| Recording layer thickness (nm) | C/N ratio (dB) | Degree of modulation |
| 3 | 43 | 0.35(35%) |
| 5 | 53 | 0.605(60.5%) |

(continued)

| Dependence of recording layer thickness | | |
|---|---|---|
| Recording layer thickness (nm) | C/N ratio (dB) | Degree of modulation |
| 8 | 54 | 0.65(65%) |
| 10 | 56 | 0.655(65.5%) |
| 15 | 55 | 0.67(67%) |
| 20 | 50 | 0.65(65%) |
| 25 | 45 | 0.6(60%) |
| 30 | 30 | 0.4(40%) |

(EXAMPLE A-5)

The optical recording medium manufactured in EXAMPLE A-1, was rotated at a constant linear velocity of 9m/s, and a laser beam having power density of 18mW/$\mu$m$^2$ was irradiated radially, while moving the laser beam at 36$\mu$m/r, so as to carry out initial crystallization.

Bonded portions of the optical recording medium were physically separated off, and then a surrounding protective layer and a reflection layer were separated off with adhesive tape. Subsequently, a surface of the substrate on which the recording layer remained was soaked into an organic solvent, the recording layer was exfoliated from the substrate, and then it was subjected to filtering to obtain powder. Thus obtained powder was filled in a capillary, and powder X-ray diffraction measurement was conducted at wavelength of 0.419Å (0.0419nm), by using emitted light of the incident beam having a parallelism and extremely high luminance.

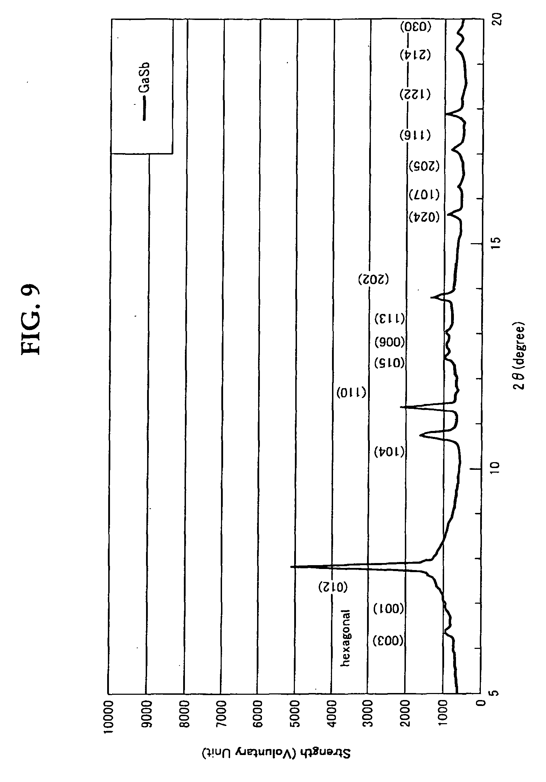

The powder X-ray diffraction spectrum is shown in FIG. 9. Main peaks of the diffraction spectrum were 2$\theta$ =6.36˚, 6.875˚, 7.804˚, 10.737˚,11.334˚. When surface distance of lattice planes corresponding to each of these peaks was calculated by the following Bragg's equation, the values were d = 3.78, 3.49, 3.08, 2.24, 2.12, respectively. These peaks could be exponentially expressed by rhombohedral structure, which is similar to Sb structure. Thereafter, it was found out that the recording layer had a single layer structure;

$$\text{Bragg's equation: } 2d\sin\theta = n\lambda,$$

wherein "d" expresses Distance of lattice planes, "n" expresses Order of reflection, and "$\lambda$" expresses X-ray wavelength)

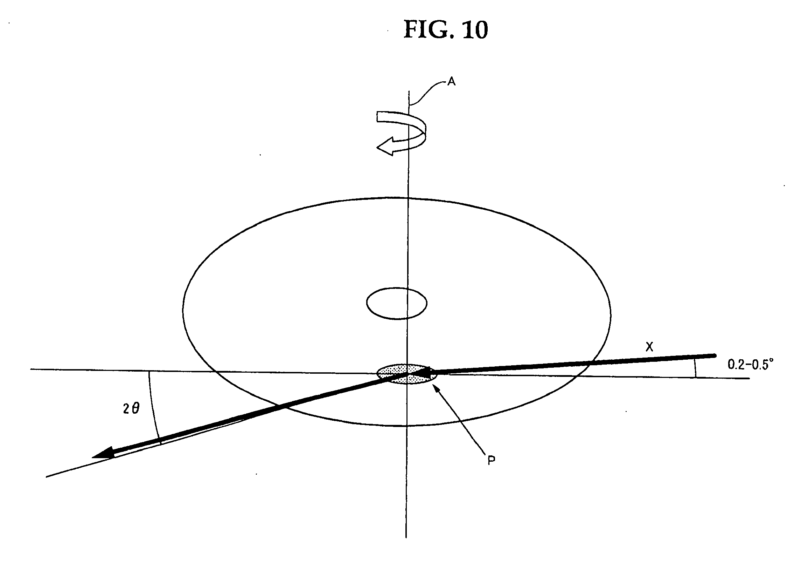

In a state that the bonded portions of the optical recording medium same as above were physically separated off and the recording layer became the uppermost surface of the optical recording medium, the optical recording medium was subjected to In-plane X-ray diffraction (a method for measuring a lattice plane being vertical to a substrate surface of the sample here). Details of this measurement method are described in The Rigaku-Denki Journal 31(1), 2000. Here, a schematic graph is shown in FIG. 10.

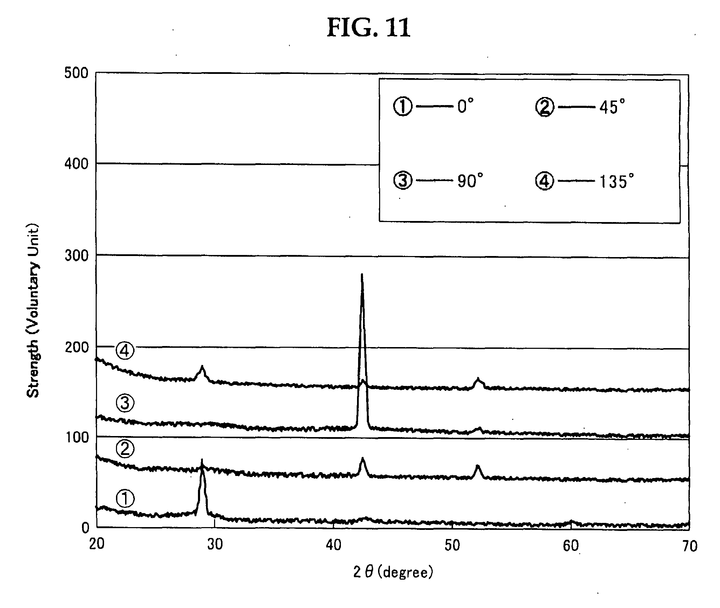

X'pert MRD manufactured by Philips Co., Ltd., was used as the apparatus, and for the incident light source of X-ray, K$\alpha$ ray of copper (wavelength $\lambda$ = 1.54Å (0.154nm)) was used. X-ray was entered almost parallel to the substrate surface (angle of incident light: from 0.2˚ to 0.5˚), and the sample (optical recording medium) was rotated by 45˚, having an axis "A" in FIG. 10 of the rotation in a portion P exposed to the X-ray, so as to measure X-ray diffraction spectrum. According to this measurement method of X-ray diffraction spectrum, since the X-ray is entered almost parallel to the substrate surface, it is possible to suppress a penetration depth of the X-ray within a few nanometers. Therefore, the crystal structure of the recording layer having a thin thickness can be accurately examined. Further, the sample was set so that X-ray was irradiated to a 40mm vicinity of the radius of the sample (optical recording medium), and then the X-ray was irradiated parallel to a direction of tracking of the optical recording medium. The angle of incidence of the X-ray was set to 0˚, and the sample was rotated by 45˚, having an axis "A" in FIG. 10 of the rotation in a portion P exposed to the X-ray, so as to measure X-ray diffraction spectrum. The results are shown in FIG. 11.

There is a relationship that pertinent peaks are intensified, when a polycrystalline film is oriented in a certain direction. The aforementioned powder X-ray diffraction was measured in a state that the orientation of crystal was removed by separating the sample off from the substrate and rendered into powder. By comparing the result of the powder X-ray diffraction and the result of in-plane diffraction (In-plane X-ray diffraction), the orientation of crystal can be more remarkably revealed.

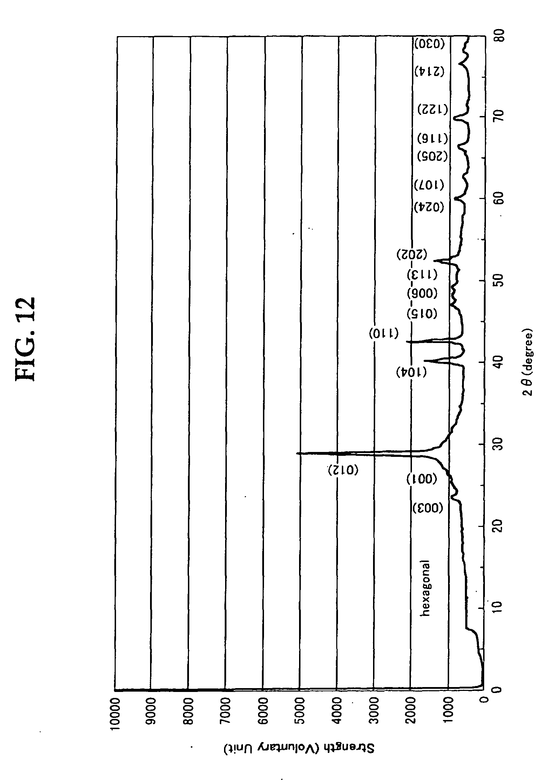

FIG. 12 shows a result obtained by converting the powder X-ray diffraction result at wavelength of $\lambda$ = 1.54Å (0.154nm) is shown. Comparing this result with that of in-plane diffraction, the peak in the vicinity of $2\theta$ = 29° of the powder X-ray diffraction was most intensified, whereas the peak of 29° of the in-plane diffraction became weak, and further the appeared number of peaks were reduced. This is because of the orientation of crystal, and because a lattice plane not satisfying the Bragg's diffraction condition may appear. When X-ray was entered at an angle of 90° with respect to the track direction, the crystal was strongly oriented to a lattice plane having lattice distance "d" of 2.12Å (0.212nm), wherein $2\theta$ = 42.6°.

Next, the power density was set to 3mW/$\mu$m$^2$, 5mW/$\mu$m$^2$, 7mW/$\mu$m$^2$, 15mW/$\mu$m$^2$, 25mW/$\mu$m$^2$, 40mW/$\mu$m$^2$, 50mW/$\mu$m$^2$, and 52mW/$\mu$m$^2$, and a state after initialization at the optimum linear velocities, respectively, and reflectance are shown in TABLE 5. The evaluation criteria were set as the following:

"$\times$ (1)": there was no orientation of crystal
"O": there was a orientation of crystal
"◎": there was a strong orientation of crystal
"$\times$ (2)": separation of layer occurred.

[TABLE 5]

| Conditions of initialization | | | |
|---|---|---|---|
| Linear velocity (m/s) | Power density (mW/$\mu$m$^2$) | State after initialization | Reflectance (%) |
| 2 | 3 | $\times$ (1) | 15 |
| 3 | 5 | O | 20 |
| 5 | 7 | O | 21 |
| 6 | 15 | ◎ | 24 |
| 10 | 25 | ◎ | 25 |
| 14 | 40 | ◎ | 24.5 |
| 18 | 50 | O | 22 |
| 19 | 52 | $\times$ (2) | - |

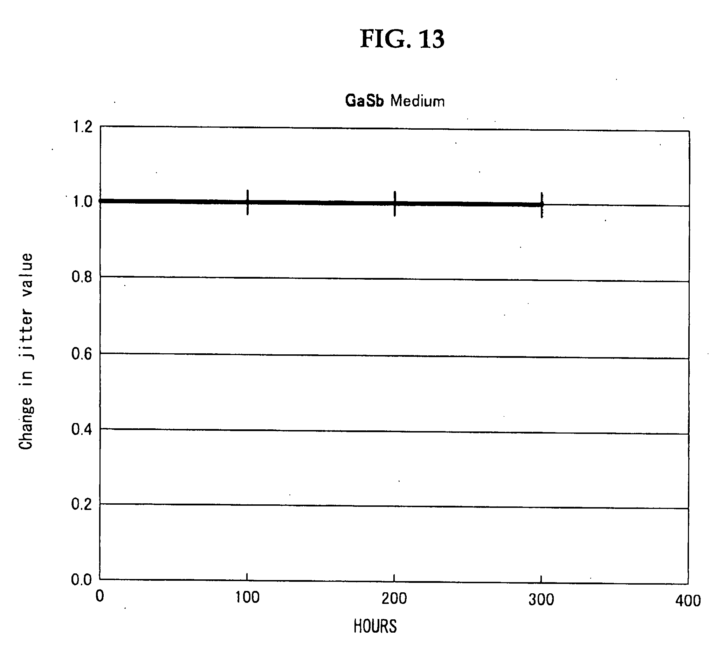

Within a range of the linear velocity of 3m/s to 18m/s, and power density of 5 mW/$\mu$m$^2$ to 50mW/$\mu$m$^2$, the orientation of crystal appeared. In particular, when the linear velocity was from 6m/s to 14m/s, and power density was from 15 mW/$\mu$m$^2$ to 40mW/ $\mu$m$^2$, strong orientation appeared and accordingly, high reflectance was obtained. The optical recording medium having the orientation of crystal and high reflectance exhibits an excellent recording property having C/N ratio of 45dB or more, under the recording condition of recording linear velocity of 10m/ s to 35m/ s. After the recorded optical recording medium was stored under a condition of 85°C and 85%RH, and change in jitter value was examined. In spite of a lapse of 300 hours, the jitter value was not changed, and it was confirmed that stability of the amorphous mark was good (as shown in FIG. 13).

The jitter value refers to a dispersion of mark edge, and the smaller the value is, the less dispersion occurs, and thus indicates an excellent recording was carried out. It is known according to acceleration test that when crystallization starts from edge of the amorphous mark, the jitter value drastically becomes worse. When the result of the acceleration test is estimated in a room temperature, the lifetime is prolonged to 10 years or more, and thus a sufficient lifetime of the optical recording medium is secured. Therefore, it has been confirmed that the above initialization conditions are suitable for obtaining an optical recording medium capable of high speed recording at a recording linear velocity of 10 m/s or more, which is a purpose of the present invention.

Optical recording media were manufactured in the same manner as in EXAMPLE A-1, except that the alloy target for recording was replaced with Ag2In5Sb68Te25, Sb78Te22, Sb88Te12, In31.7Sb68.3 (each of which was used in the COMPARATIVE EXAMPLE), Ga12Sb88, Ge16.7Sb83.3, each of which was parent phase material.

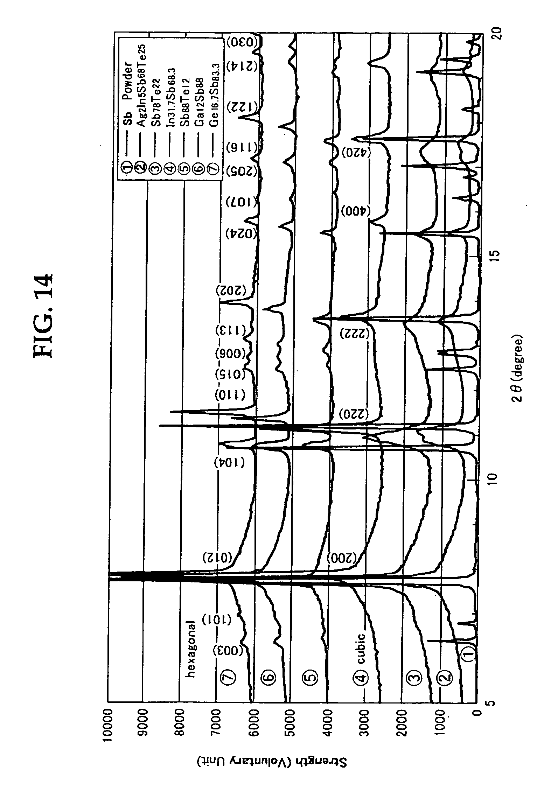

These optical recoding media were rotated at a constant linear velocity of 8 m/s, and a laser beam having power density of 20mW/$\mu$m$^2$ was irradiated radially while moving at 36$\mu$m/r, so as to carry out initial crystallization. As to these optical recording media, with a same process as described above, powder X-ray diffraction was carried out. For a purpose of comparison, the powder X-ray diffraction was carried out as to the powder of Sb. A summary of the results is shown in FIG. 14. Each peak of Ag2In5Sb68Te25, Sb78Te22, and In31.7Sb68.3 could be exponentially expressed by cubic structure. Sb88Te12, Ga12Sb88 and Ge16.7Sb83.3 could be exponentially expressed by hexagonal structure, which was similar to Sb structure.

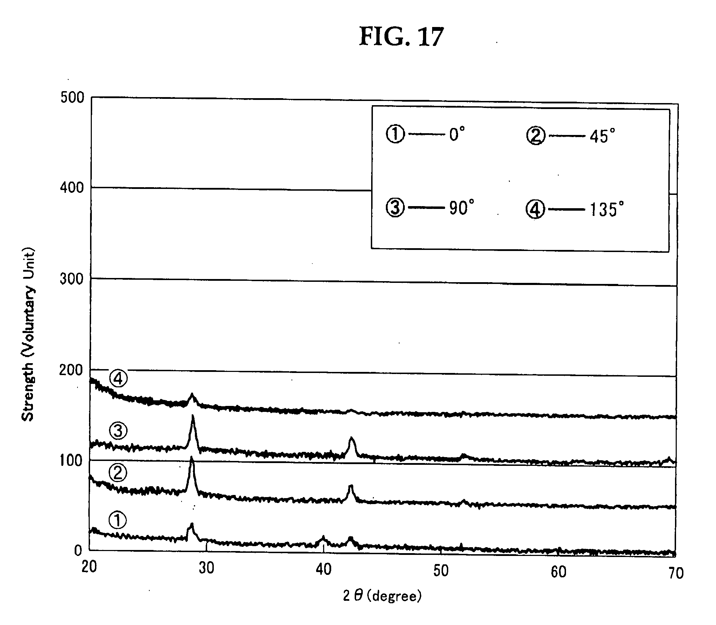

In order to compare the crystal structure of the materials, all of the materials were subject to calculation to obtain lattice constant "a (Å)/ (nm)" and lattice constant "c (Å)/ (nm)," where the unit lattice of hexagonal structure (shown in FIG. 17) was considered to be a standard, and crystallization temperature Tc (˚C) obtained by thermal analysis are shown in TABLE 6. When c/ a ratio is 2.45, it is equivalent to cubic structure. As for the crystallization temperature, a single film as a recording layer was formed on a glass, temperature of the film in amorphous phase was raised by differential scanning calorimeter, at 10˚C/minute and when crystallization started, the temperature at which the crystallization started was taken to be crystallization temperature. It is possible to say that the higher the crystallization temperature is, the more stable the amorphous phase is and also the more difficult crystallization is.

[TABLE 6]

| Lattice constant | | | | |
|---|---|---|---|---|
| Composition Ratio | a(Å)/(nm) | c(Å)/(nm) | c/a | Tc(˚C) |
| Ag2In5Sb68Te25 | 4.339/0.4339 | 11.006/1.1006 | 2.537 | 179.5 |
| Sb78Te22 | 4.402/0.4402 | 10.766/1.0766 | 2.445 | 120.5 |
| Sb88Te12 | 4.327/04327 | 11.116/1.1116 | 2.576 | 79.5 |
| Sb | 4.300/0.4300 | 11.273/1.1273 | 2.622 | - |
| Ga12Sb88 | 4.240/0.4240 | 11.307/1.1307 | 2.667 | 194.5 |
| Ge16.7Sb83.3 | 4.185/0.4185 | 11.320/1.1320 | 2.705 | 255.5 |
| In31.7Sb58.3 | 4.323/0.4323 | 10.618/1.0618 | 2.456 | 114.1 |

Ag2In5Sb68Te25 was a material obtained by adding Ag and In as additive elements to the parent phase material, SbTe. It is known that by increasing the amount of Sb of the parent material SbTe, the speed for crystallizing material is accelerated. However, there is a defect that in the material containing increased amount of Sb, amorphous phase is crystallized even under a low temperature. Therefore, recording at 18m/s, 5 × DVD speed, is assumed to be upper limit. Comparing to the low crystallization temperature of SbTe, such as 120.5˚C, 79.5˚C, GaSb and GeSb respectively has high temperature such as 194.5˚C and 255.5˚C. Therefore, it has been found that the amorphous phase is hardly crystallized and archival stability of amorphous mark is good. These phenomena can be explained from a material structure. It can be considered that all of the materials which were subjected to powder X-ray diffraction measurement in the EXAMPLEs were material that something was added to Sb. In the case of Sb alone, crystallization speed is high, but stability of amorphous phase is not good such as causing crystallization even at a room temperature. Therefore, it cannot be used as a material of the optical recording medium of the present invention. Then, it is conceivable that in order to enhance the stability of amorphous phase, bonding power is enforced by adding elements other than Sb.

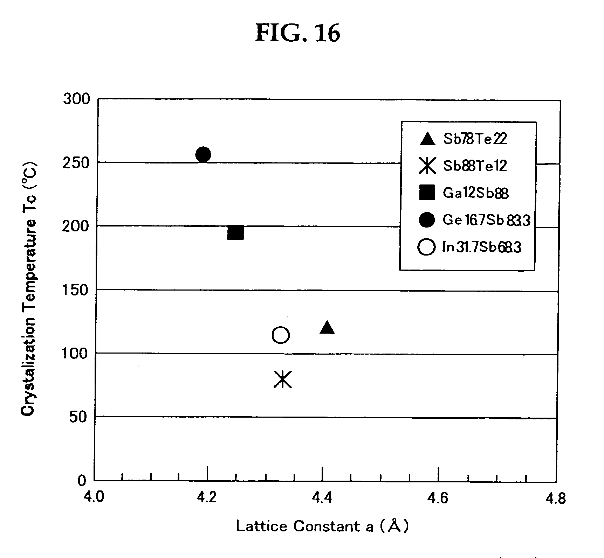

Relations between lattice constant a, and crystallization temperature is shown in FIG. 16. A material having a small lattice constant "a," is strong in covalent bonding force. Since in order to thermally crystallize the amorphous phase, large energy is required to cut the covalent bonding and recompose a network. Therefore, it is conceivable that crystallization temperature is relatively high.

(SAMPLE EXAMPLE A-1)

The optical recoding medium obtained in EXAMPLE A-1 was rotated at a constant linear velocity of 2 m/s, and a laser beam having power density of 4.5mW/ $\mu$m$^2$ was irradiated radially, while moving at 36$\mu$m/r, so as to carry out initial crystallization.

In a state that the bonded portions of the optical recording medium were physically separated off and the recording layer became the uppermost surface, the in-plane diffraction (in-plane X-ray diffraction) was conducted as the case of EXAMPLE A-5. Namely, X-ray was entered almost parallel to the substrate surface (angle of incidence: from 0.2˚ to 0.5˚), and the sample (optical recording medium) was rotated by 45˚, so as to measure X-ray diffraction spectrum. FIG. 17 shows a result of measurement where the angle of incidence of X-ray in parallel to a direction of tracking was set to 0˚, and the sample was rotated by 45˚ to 135˚.

By use of the recording and reproducing apparatus as used in EXAMPLE A-1, the above optical recording medium on which initial crystallization had been carried out was subjected to recording under same conditions as those of EXAMPLE A-1. As a result, reflectance and degree of modulation were, compared to EXAMPLE A-1, low, 17% and 0.55 (55%), respectively. This is because this material has small orientation and is, compared to EXAMPLE A-1, poor in crystallization, resulting in low reflectance and low degree of modulation.

(EXAMPLE A-6)

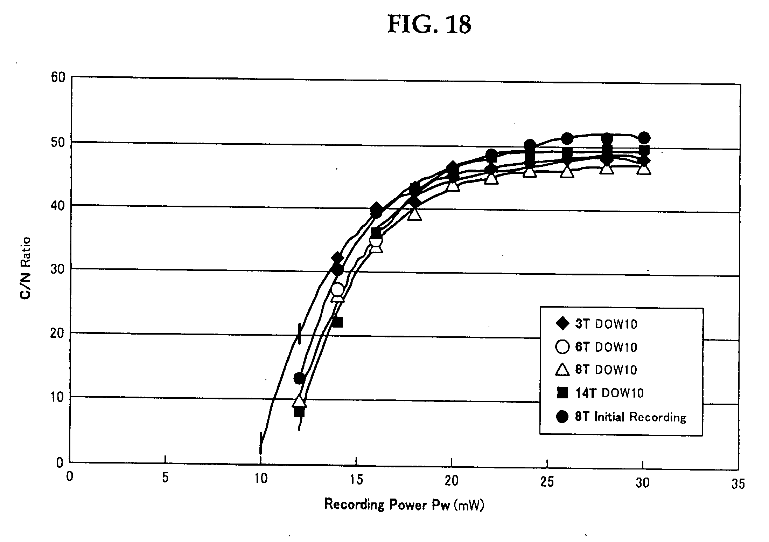

As to the optical recording medium manufactured in the same manner as in EXAMPLE A-1, a recording test was conducted, using an optical system having LD (laser diode) having wavelength of 660nm and NA of 0.65, where the recording linear velocity was 28m/s, Pe/Pw was 0.2 with a laser beam having pulse train as shown in FIG. 6, and Pw varied. The results are shown in FIG. 18.

This test was conducted by 10 time DOW (direct overwriting) of single marks of 3T, 6T, 8T, and 14T, respectively, at EFM+ modulation, which is a modulation system of DVD. Then, obtained C/N ratios were monitored. As to 8T mark, another result was also plotted in the case where recording was carried out only once (initial recording was carried out). A pulse used for recording was optimized in each Ts, and the pulse number, pulse width, and Pb level width were optimized for the use.

In the optical recording medium where Ga12Sb88 is used as a recoding material in a recording layer, in order to secure 30dB or more of C/N ratio, 15mW or more of recording power (Pw) is required, and if a recording property of 45dB or more, for further stable recording, is to be obtained, the recording power (Pw) of around 20mW or more is required.

In the optical system used in this EXAMPLE A-6, a beam diameter to obtain $1/e^2$ of beam power is necessary to be around 0.9 micron. Therefore, it has been found out that the power density of the beam in the recording power (Pw) required for recording, is necessary to be at least 20mW/$\mu m^2$, and more preferably 30mW/$\mu m^2$ or more.

(EXAMPLE A-7)

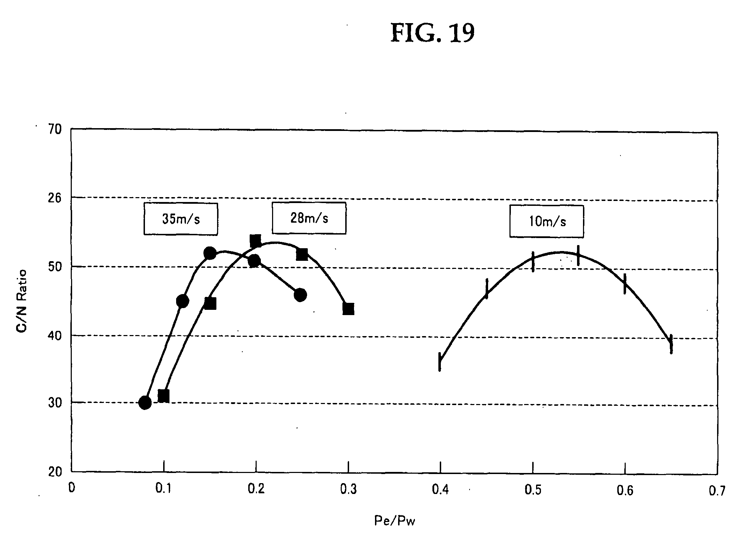

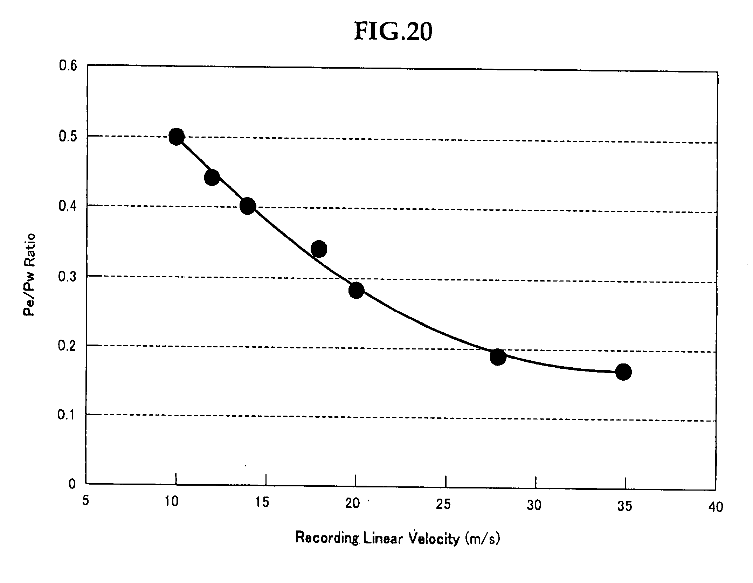

By use of the optical recording medium manufactured in EXAMPLE A-1, recording was carried out utilizing the pulse beam as shown in FIG. 6, at the recording linear velocity of 10m/ s, 28m/ s, and 35m/s. In FIG. 19, it is shown that C/N ratios of the recording were plotted. In FIG. 20, it is shown that ratios of erasing power (Pe) and peak power (Pw) were respectively optimized at each of the recording linear velocities, and a power condition where the C/N ratio became maximum was plotted with respect to the recording linear velocities.

Similar to the case of EXAMPLE A-6, the pulse number with respect to each Ts was changed at each of the recording linear velocities, and optimized number was used. EFM+ modulation system was used for recoding, and those results were obtained by randomly recording each of Ts.

At a recording linear velocity of 10m/s, if Pe/Pw is changed, the range to obtain excellent C/N ratio satisfied the relation of $0.42 \leq Pe/Pw \leq 0.65$. In particular, if it satisfied a relation of around $0.47 \leq Pe/Pw \leq 0.60$, C/N ratio could become 50dB. Further, at recording linear velocity of 35m/s, the range to obtain excellent C/N ratio satisfied a relation of $0.10 \leq Pe/Pw \leq 0.25$. In particular, if it satisfied a relation of around $0.13 \leq Pe/Pw \leq 0.22$, C/N ratio could become 50dB. Since it is possible to apply each recording linear velocity within the range of 10m/ s to 35m/ s, the range of Pe/Pw to obtain an excellent recording property, when the recording linear velocity is 10 m/s to 35 m/s, is $0.10 \leq Pe/Pw \leq 0.65$, and preferably $0.13 \leq Pe/Pw \leq 0.60$.

According to the present invention, it is possible to provide an optical recording medium, having a capacity equivalent to that of DVD-ROM, and even at the linear velocity of 10m/s or more, recording and erasing by a reversible phase change between amorphous material phase (amorphous phase) and crystalline phase of the recording layer can be attained.

According to a preferable aspect of the present invention, it is possible to provide an optical recording medium on which recording and erasing can be carried out at a linear velocity of 10m/s or more.

According to another preferable aspect of the present invention, it is possible to provide an optical recording medium on which repetitive recording can be carried out at a recording linear velocity of $4 \times$ DVD speed (14m/s) or more.

According to another preferable aspect of the present invention, it is possible to provide an optical recording medium on which repetitive recording can be carried out at a recording linear velocity of $8 \times$ DVD speed (28m/s) or more.

According to the present invention, it is possible to provide an optical recording medium having high degree of modulation by adjusting a thickness of the recording layer to 5nm to 25nm, and more preferably 8nm to 20nm.

According to the present invention, it is possible to provide a process for manufacturing an optical recording medium having a capacity equivalent to that of DVD-ROM, and high-speed recording can be carried out thereto even at the recording linear velocity of 10m/ s or more.

According to the present invention, it is possible to provide a sputtering target for manufacturing an optical recording medium having a capacity equivalent to that of DVD-ROM, on which high-speed recording can be carried out thereto even at the recording linear velocity of 10m/s or more.

According to the present invention, it is possible to provide an optical recording process, where stable recording can be carried out.

According to another preferable aspects of the present invention, it is possible to provide an optical recording process where a high C/N ratio is enabled at the recording linear velocity of 10m/s or more.

(EXAMPLE B-1)

On a 0.6mm thick a polycarbonate substrate which has a meandering groove of pitch size $0.74\mu m$, meandering amount of 35 nm and groove width of $0.25\mu m$, a 65nm to 85nm thick first dielectric layer (first protective layer) using $ZnS\text{-}SiO_2$ mixing target ($SiO_2$ 20 mol%), a 15nm to 20 nm thick recording layer which contains Ga0.1Sb0.9, a 12 nm thick second dielectric layer using the same materials as those of the first dielectric layer, a 2nm to 8nm thick third dielectric layer using SiC target, and a 80nm to 150nm thick reflection layer using Ag target, were disposed in this order by sputtering method. An ultraviolet setting resin layer (overcoat layer) was disposed on the reflection layer by spin coating. Thereafter, a 0.6mm thick second polycarbonate substrate was disposed onto the reflection layer, using the ultraviolet setting resin. Subsequently, the layers were annealed (initialized) with a laser diode beam under a power condition of 130W · sec/ disk. Accordingly, the recording material, which had been amorphous just after sputtering, was crystallized and an optical recording medium was thus manufactured (in the EXAMPLE B-1, the second protective layer had double layered structure which included the second dielectric layer and the third dielectric layer).

The followings are film (layer)-forming conditions by the sputtering device for each of the layers.

|  | Input power; | Ar gas pressure (air pressure in film-forming chamber) |
|---|---|---|
| First and second dielectric layers: | 3kW | 2mTorr |
| Recording layer: | 1kW | 2mTorr |
| Third dielectric layer: | 1kW | 2mTorr |
| Reflection layer | 5kW | 2mTorr |

A thickness of the first dielectric layer was prepared so as to have a similar reflectance, Rg. Onto the thus obtained optical recording medium, recording was carried at various recording linear velocity, and a degree of modulation was measured, using a recording system with a laser beam having wavelength of 650nm to 665nm, lens NA of 0.65, so as to have a recording density equivalent to that of DVD. It was found out that a recordable range of linear velocity was as wide as 6 m/ s to 40 m/ s.

It was also confirmed that recording could be carried out, when a degree of modulation (M) between the reflectance at unrecorded space part, "Rg," and the reflectance at recording mark (recorded portion), "Rb," was 4.0 or more.

Change in jitter properties in accordance with a recording linear velocity was measured. Here, the change in jitter properties was expressed by σ/Tw (%),which is a distribution of mark edge relative to a channel cycle, "Tw."

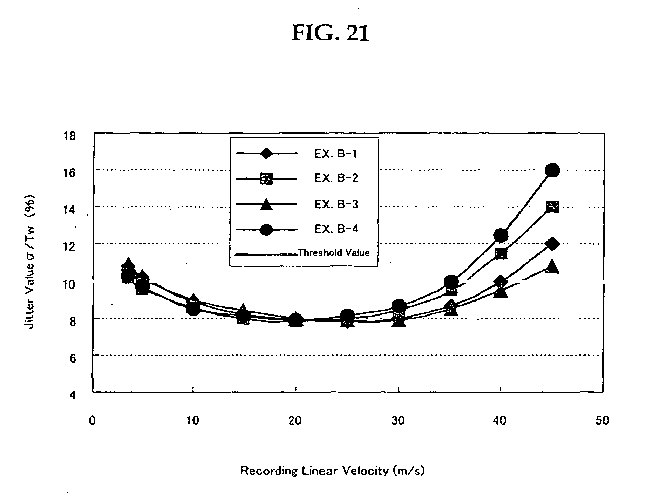

The results of the measurement are shown in FIG. 21. When the jitter value of 10% or less is defined as a sufficient recording linear velocity, as can be understood from the results of the measurement, it was found out that sufficient jitter value could be obtained at a recording linear velocity similar to the one obtained by the degree of modulation (M).

The results of measuring the jitter value after 10 time overwriting, a degree of modulation (M), a reflectance at an unrecorded space part, "Rg (%)," and a reflectance at a recorded mark, "Rb (%)," at a recording linear velocity of 15m/s, 25m/s, and 35m/ s, are shown in TABLE 7.

(EXAMPLE B-2)

An optical recording medium was manufactured in the same manner as described in EXAMPLE B-1, except that the recording layer material was replaced by Ge0.03 (Ga0.1Sb0.9)Sb0.97, in which a content of Ge was 3atm%, a content of Ga was 10atm%, a content of Sb was 97atm% in the recording layer.

Recording in the optical recording medium was carried out by the same system as used in EXAMPLE B-1. It was found out that the range of the recording linear velocity with which recording could be carried out, was as wide as 4m/s to 37m/s.

Change in jitter properties in accordance with a recording linear velocity was measured in the same way as in EXAMPLE B-1. The results of the measurement are shown in FIG. 21.

The results of measuring the jitter value after 10 time overwriting, a degree of modulation (M), a reflectance at an unrecorded space part, "Rg (%)," and a reflectance at a recorded mark, "Rb (%)," at a recording linear velocity of 15m/s, 25m/s, and 35m/s, are shown in TABLE 7.

Furthermore, a archival stability test was conducted with the optical recording medium manufactured in EXAMPLE B-2, under a condition of high temperature of 80˚C and high humidity of 85%, along with the optical recording medium manufactured in EXAMPLE B-1. The result showed increase of jitter property of recording mark, as the following. As for the optical recording medium of EXAMPLE B-1, increase rate was 5% after a lapse of 300 hours, whereas as for the optical recording medium of EXAMPLE B-2, the increase rate was 1% or less. It was hence found out that addition of Ge was effective for enhancing the archival stability.

It was also found out that if the addition amount of Ge was 1% or more, it was not effective, and that the recordable range of linear velocity was narrowed as the addition amount increased.

It depends on the target range of linear velocity, however, the addition amount of Ge is preferably 0.1 or less in atomic ratio, and more preferably 0.07 or less in atomic ratio.

(EXAMPLE B-3)

An optical recording medium was manufactured in the same manner as described in EXAMPLE B-1, except that the recording layer material was replaced by $Ge_{0.03}In_{0.05}(Ga_{0.1}Sb_{0.9})_{0.92}$.

Recording in the optical recording medium was carried out by the same system as used in EXAMPLE B-1. It was found out that the range of the recording linear velocity was as wide as 6m/ s to 43m/ s.

It was found that addition of In was effective for enhancing a range of the recording linear velocity. It was also found out that addition of Mn or Al instead of In was also effective to obtain the good recording linear velocity.

It depends on the target range of linear velocity, however, the addition amount of In, Mn or Al is preferably 0.15 or less in atomic ratio, and more preferably 0.1 or less in atomic ratio, since the excessively large addition amount of In, Mn or Al causes crystallization even with a low power laser beam upon repetitive reproducing.

Change in jitter properties in accordance with a recording linear velocity was measured in the same way as in EXAMPLE B-1. The results of the measurement are shown in FIG. 21. It was confirmed that the range of the recording linear velocity was wide from the viewpoint of the jitter value. The results of measuring the jitter value after 10 time overwriting, a degree of modulation (M), a reflectance at an unrecorded space part, "Rg (%)," and a reflectance at a recorded mark, "Rb (%)," at a recording linear velocity of 15m/s, 25m/ s, and 35m/ s, are shown in TABLE 7.

(EXAMPLE B-4)

An optical recording medium was manufactured in the same manner as described in EXAMPLE B-1, except that the recording layer material was replaced by $Ge_{0.03}Ag_{0.02}(Ga_{0.1}Sb_{0.9})_{0.95}$.

Recording in the optical recording medium was carried out by the same system as used in EXAMPLE B-1. It was found out that the range of the recording linear velocity was as wide as 4m/ s to 35m/s.

An equivalent degree of modulation to that of EXAMPLE B-2 was obtained even with around 10% smaller power of a laser beam.

It was also found out that addition of Cu, Au, or N instead of Ag was also effective to obtain the equivalent recording linear velocity.

It depends on the target range of linear velocity, however, the addition amount of Ag, Cu, Au, or N is preferably 0.05 or less in atomic ratio, and more preferably 0.03 or less in atomic ratio, since the excessively large addition amount of Ag, Cu, Au, or N causes a narrower range of recording linear velocity.

Change in jitter properties in accordance with a recording linear velocity was measured in the same way as in EXAMPLE B-1. The results of the measurement are shown in FIG. 21. The results of measuring the jitter value after 10 time overwriting, a degree of modulation (M), a reflectance at an unrecorded space part, "Rg (%)," and a reflectance at a recorded mark, "Rb (%)," at a recording linear velocity of 15m/s, 25m/s, and 35m/s, are shown in TABLE 7.

(EXAMPLE B-5)

An optical recording medium having the same recording material as in EXAMPLE B-1, was manufactured in the same manner as described in EXAMPLE B-1, except that the thickness of the first dielectric layer (first protective layer) was changed to 105nm, 120nm, and 80nm.

The results of measuring the jitter value after 10 time overwriting, a degree of modulation (M), a reflectance at an unrecorded space part, "Rg (%)," and a reflectance at a recorded mark, "Rb (%)," at a recording linear velocity of 15m/s, 25m/s, and 35m/s, are shown in TABLE 7. Here, the thickness of the recording layer was 16nm.

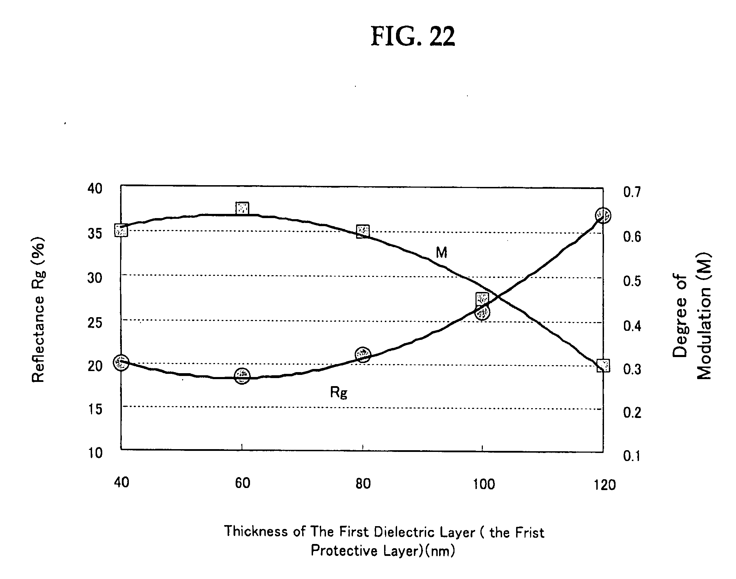

The relationship among the first dielectric layer, a reflectance, and a degree of modulation at a recording linear velocity of 35m/ s (wavelength of the laser beam was 660nm), was measured further in detail. The result is shown in FIG. 22.

It was found out from the measurement that an excessively high reflectance deteriorates a degree of modulation. It was also found out that a reflectance and a degree of modulation could be adjusted by a thickness of the first dielectric layer. In the EXAMPLE B-5, the degree of modulation became 0.4 or more, when the reflectance was 30% or less. Here, the jitter value was within 10%, which was recordable. The thickness of the first dielectric layer was around 107nm (0.162$\lambda$). When the thickness of the first dielectric layer was 120nm, the reflectance was more than 30%, and the degree of modulation (M) was less than 0.4.

On the other hand, when the thickness of the first dielectric layer was 60nm, the reflectance was as low as around 16%. However, in the condition of the thickness of the first dielectric layer and the reflectance, the results produced a large value for the degree of modulation and good jitter values.

(EXAMPLE B-6)

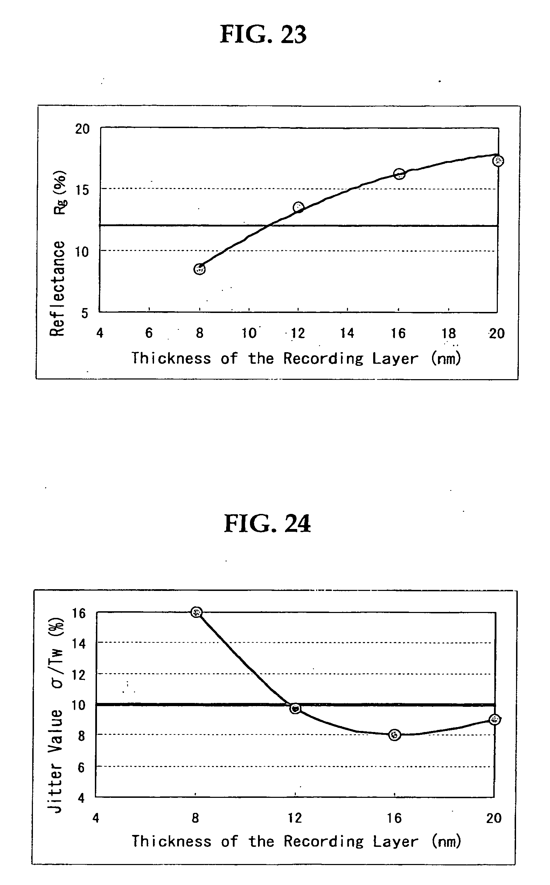

An optical recording medium was manufactured in the same manner as described in EXAMPLE B-1, except that the thickness of the first dielectric layer (first protective layer) was changed to 60nm. A reflectance and a jitter value were measured at a recording linear velocity of 35m/ s (wavelength of the laser beam was 660nm), in which a thickness of the recording layer of the optical recording medium manufactured in EXAMPLE B-6, was changed. The results are shown in FIGs. 23 and 24.

As the results show, it was found out that an excessively low reflectance deteriorated jitter properties. It was also found out that decrease in the reflectance and deterioration of the jitter properties were related to the thickness of the recording layer, and that an excessively thin recording layer caused decrease in reflectance and deterioration of the jitter properties. For the recording material of the EXAMPLE B-6, the thickness of the recording layer was required to be around 10nm (0.015$\lambda$) or more in order to obtain a sufficient reflectance (reflectance of 12% or more). The thickness of the recording layer of 12nm (0.018$\lambda$) or more contributed to good jitter properties.

The results of measuring the jitter value after 10 time overwriting, a degree of modulation (M), a reflectance at an unrecorded space part, "Rg (%)," and a reflectance at a recorded mark, "Rb (%)," at a recording linear velocity of 15m/s, 25m/s, and 35m/s, are shown in TABLE 7. Here, the thickness of the recording layer was 7nm. With the condition provided here, recording could not be carried out, from viewpoints of the degree of modulation (M) and jitter value. In the following TABLE 7, "PL" expresses a thickness of the recording layer.

[TABLE 7]

| | | Thickness of the first dielectric layer (nm) | Recording Linear Velocity (m/s) | Recording Power (mW) | Recording Properties after 10 time Overwirting | | | |
|---|---|---|---|---|---|---|---|---|
| | | | | | Jitter Value (%) | Degree of Modulation (M) | Reflectance Rg (%) | Reflectance Rb (%) |
| EX. B-1 | Ga0.1Sb0.9 | 70 | 15 | 18 | 8.2 | 0.63 | 20.0 | 7.4 |
| | | 73 | 25 | 26 | 7.8 | 0.62 | 19.9 | 7.6 |
| | | 75 | 35 | 36 | 8.7 | 0.61 | 19.8 | 7.7 |
| EX. B-2 | Ga0.03(Ga0.1Sb0.9)0.97 | 70 | 15 | 18 | 8.0 | 0.65 | 19.6 | 6.9 |
| | | 73 | 25 | 26 | 8.0 | 0.64 | 19.5 | 7.0 |
| | | 75 | 35 | 36 | 9.5 | 0.62 | 19.6 | 7.4 |
| EX. B-3 | Ge0.03In0.05 (Ga03.1 Sb0.9) | 70 | 15 | 18 | 8.4 | 0.70 | 20.5 | 6.2 |
| | | 73 | 25 | 26 | 7.9 | 0.68 | 20.6 | 6.6 |
| | | 75 | 35 | 36 | 8.5 | 0.68 | 20.6 | 6.6 |
| EX. B-4 | Ge0.03Ag0.02 (Ga0.1Sb0.9) | 70 | 15 | 18 | 8.1 | 0.68 | 19.2 | 6.1 |
| | | 73 | 25 | 26 | 8.1 | 0.67 | 19.0 | 6.3 |
| | | 75 | 35 | 36 | 10.0 | 0.66 | 19.0 | 6.5 |
| EX. B-5 | Ga0.1Sb0.9 | 105 | 15 | 18 | 9.6 | 0.50 | 27.5 | 13.8 |
| | | 105 | 25 | 26 | 8.3 | 0.45 | 27.2 | 15.0 |
| | | 105 | 35 | 36 | 9.1 | 0.43 | 27.0 | 15.4 |
| | Ga0.1Sb0.9 | 60 | 15 | 18 | 9.0 | 0.69 | 16.5 | 5.1 |
| | | 60 | 25 | 26 | 8.1 | 0.67 | 16.8 | 5.4 |
| | | 60 | 35 | 36 | 8.9 | 0.66 | 16.0 | 5.4 |
| | Ga0.1Sb0.9 | 120 | 15 | 18 | >15 | 0.37 | 33.0 | 20.8 |
| | | 120 | 25 | 26 | >15 | 0.35 | 32.6 | 21.2 |
| | | 120 | 35 | 36 | >15 | 0.33 | 32.8 | 21.6 |
| EX. B-6 | Ga0.1Sb0.9 | 60/PL7 | 15 | 18 | >15 | 0.39 | 11.4 | 7.0 |
| | | 60/PL7 | 25 | 26 | >15 | 0.38 | 11.8 | 7.0 |
| | | 60/PL7 | 35 | 36 | >15 | 0.38 | 11.1 | 6.9 |

According to present invention, it is possible to achieve an optical recording medium prepared for a wide recording speed range from 1 × to 10 × or more for DVD recording. As a result, it enables a short time recording when a user inputs contents. Further, in a certain system, it is possible to carry out recording during a real-time reproducing. Therefore, it may enhance the convenience of a recording system.

According to an aspect of the present invention where the recording layer further comprises at least one element such as Ge or the like, a degree of modulation and archival stability of a recording mark are further improved, which requires an optical recording medium to employ only small amount of recording power.

The following EXAMPLEs C-1 to C-11, COMPARATIVE EXAMPLEs C-1 to C-2 describes a case where a laser beam having short wavelength was used as the laser beam for recording.

(EXAMPLEs C-1 to C-11, COMPARATIVE EXAMPLEs C-1 to C-2)

On a 0.6mm thick polycarbonate substrate having a diameter of 12 cm, which has irregularity for a tracking guide formed of continuous groove on a surface thereof, 100nm thick ZnS·SiO$_2$ (20 mol%) having as a first protective layer, a 12nm thick recording layer using a composition target as shown in TABLE 8 and TABLE 9, 20nm thick ZnS·SiO$_2$ (20 mol %) as a second protective layer, and a 140nm thick Ag-Pd (1 atm%)-Cu (1 atm%) as a reflection layer, were sequentially disposed. A sputtering method in Ar gas atmosphere was employed for forming these layers.

On the reflection layer, an overcoat layer was provided utilizing a spin coater, and an optical recording medium was manufactured. Subsequently, using an initialization apparatus having a semiconductor laser of large diameter, the recording layer of the optical recording medium was subjected to initialization.

Recording was carried out under the following condition for each of the thus manufactured optical recording media. Upon recording, under a condition of linear density of 0.18μm/bit, jitter value and a degree of modulation (M), and jitter value and a degree of modulation (M) after 1,000 times recording were measured. The results are shown in TABLE 8 and TABLE 9.

<Recording condition>

· Wavelength of a laser beam        407nm
· Numerical aperture NA        0.65
· Linear velocity        5.7m/s, 17.1m/s, and 34.2m/s
· Tracking pitch        0.40μm

[TABLE 8]

| Recording experiment of an optical recording medium | | | | | | |
|---|---|---|---|---|---|---|
| | Recording layer composition (atm%) | Linear velocity (m/s) | Jitter value (%) after overwriting | | Degree of modulation after overwriting | |
| | | | 1 time | 1,000 times | 1 time | 1,000 times |
| Ex. C-1 | Ga12Sb88 | 5.7 | 6.8 | 7.0 | 0.69(69%) | 0.68(68%) |
| | | 17.1 | 6.9 | 7.1 | 0.67(67%) | 0.67(67%) |
| | | 34.2 | 7.0 | 7.4 | 0.66(66%) | 0.65(65%) |
| Ex. C-2 | Ga5Sb95 | 5.7 | 7.2 | 7.8 | 0.68(68%) | 0.69(69%) |
| | | 17.1 | 7.5 | 7.8 | 0.68(68%) | 0.68(68%) |
| | | 34.2 | 7.6 | 7.9 | 0.64(64%) | 0.65(65%) |
| Ex. C-3 | Ga20Sb80 | 5.7 | 7.3 | 7.5 | 0.68(68%) | 0.67(67%) |
| | | 17.1 | 7.4 | 7.6 | 0.65(65%) | 0.65(65%) |
| | | 34.2 | 7.6 | 7.9 | 0.65(65%) | 0.65(65%) |

(continued)

| Recording experiment of an optical recording medium | | | | | | |
|---|---|---|---|---|---|---|
| | Recording layer composition (atm%) | Linear velocity (m/s) | Jitter value (%) after overwriting | | Degree of modulation after overwriting | |
| | | | 1 time | 1,000 times | 1 time | 1,000 times |
| Ex. C-4 | Ca11Sb84Ge5 | 5.7 | 6.7 | 6.8 | 0.7(70%) | 0.69(69%) |
| | | 17.1 | 6.8 | 7.0 | 0.7(70%) | 0.7(70%) |
| | | 34.2 | 7.0 | 7.4 | 0.69(69%) | 0.68(68%) |
| Ex. C-5 | Ga12Sb85In3 | 5.7 | 7.1 | 7.4 | 0.65(65%) | 0.65(65%) |
| | | 17.1 | 7.2 | 7.5 | 0.65(65%) | 0.66(66%) |
| | | 34.2 | 7.5 | 7.9 | 0.63(63%) | 0.63(63%) |
| Ex. C-6 | Ga12Sb85Zn3 | 5.7 | 7.2 | 7.5 | 0.69(69%) | 0.69(69%) |
| | | 17.1 | 7.4 | 7.8 | 0.69(69%) | 0.7(70%) |
| | | 34.2 | 7.6 | 7.9 | 0.67(67%) | 0.68(68%) |

[TABLE 9]

| Ex. C-7 | Ga10Sb83Mn3Ag4 | 5.7 | 7.3 | 7.5 | 0.66(66%) | 0.67(67%) |
|---|---|---|---|---|---|---|
| | | 17.1 | 7.5 | 7.6 | 0.65(65%) | 0.65(65%) |
| | | 34.2 | 7.7 | 8.0 | 0.65(65%) | 0.66(66%) |
| Ex. C-8 | Ga10Sb83Ge3Cu4 | 5.7 | 7.1 | 7.3 | 0.71(71%) | 0.7(70%) |
| | | 17.1 | 7.2 | 7.5 | 0.7(70%) | 0.7(70%) |
| | | 34.2 | 7.5 | 7.8 | 0.68(68%) | 0.67(67%) |
| Ex. C-9 | Ga10Sb83In3N4 | 5.7 | 7.3 | 7.4 | 0.65(65%) | 0.64(64%) |
| | | 17.1 | 7.5 | 7.7 | 0.65(65%) | 0.65(65%) |
| | | 34.2 | 7.7 | 7.8 | 0.63(63%) | 0.64(64%) |
| Ex. C-10 | Ga6Sb80Mn7Ag7 | 5.7 | 11.1 | 15.4 | 0.67(67%) | 0.66(66%) |
| | | 17.1 | 11.2 | 16.2 | 0.65(65%) | 0.61(61%) |
| | | 34.2 | 12.0 | 16.8 | 0.52(52%) | 0.48(48%) |
| Ex. C-11 | Ga9Sb80Ge3Ag8 | 5.7 | 9.8 | 11.0 | 0.64(64%) | 0.63(63%) |
| | | 17.1 | 9.9 | 11.8 | 0.63(63%) | 0.63(63%) |
| | | 34.2 | 9.9 | 12.3 | 0.6(60%) | 0.62(62%) |
| Comp. Ex. C-1 | Ga50Sb50 | 5.7 | 15.2 | 18.2 | 0.38(38%) | 0.35(35%) |
| | | 17.1 | 16.0 | 19.0 | 0.34(34%) | 0.34(34%) |
| | | 34.2 | 17.1 | 19.0 | 0.3(30%) | 0.29(29%) |
| Comp. Ex. C-2 | Ga22Sb78 | 5.7 | 12.5 | 15.6 | 0.57(57%) | 0.58(58%) |
| | | 17.1 | 12.7 | 16.7 | 0.55(55%) | 0.56(56%) |
| | | 34.2 | 13.0 | 17.9 | 0.54(54%) | 0.55(55%) |

As indicated in TABLE 8 and TABLE 9, it was found out that the optical recording medium according to the EXAMPLES C-1 to C-9 of the present invention, jitter value and a degree of modulation were excellent and had excellent overwriting property, even at a high linear velocity. In addition, even when thickness of each of the layers was changed within a range of:

$$0.070\lambda \le t_1 \le 0.5\lambda$$

$$0.015\lambda \le t_2 \le 0.05\lambda$$

$$0.011\lambda \le t_3 \le 0.055\lambda$$

$$0.10\lambda \le t_4\ ;$$

wherein "$t_1$" expresses the thickness of the first protective layer, "$t_2$" expresses the thickness of the recording layer, "$t_3$" expresses the thickness of the second protective layer, and "$t_4$" expresses the thickness of the reflection layer, the optical recording medium still attained the jitter value and the degree of modulation.

On the other hand, the optical recording media of COMPARATIVE EXAMPLEs C-1 and C-2, where the recording layer comprised Ga and Sb, and a content of Sb is 80atm% to 95atm% relative to a total content of Sb, did not show a sufficient degree of modulation, or showed a result that jitter value was large although having a sufficient degree of modulation. Furthermore, the optical recording media of EXAMPLEs C-10 and C-11, where less than 90% of Ga and Sb was contained in the recording layer, showed deteriorated results, compared to the optical recording media of EXAMPLEs C-1 to C-9, where 90% or more of Ga and Sb were contained in the recording layer.

Furthermore, apart from the above EXAMPLEs, it was found out that excellent properties such as improvement of archival stability and recording sensitivity were obtained, by adding at least one selected from Au, B, Al, Si, Sn, Pb, Bi, La, Ce, Gd, and Tb to the recording layer.

(EXAMPLE C-10)

On a 1.1mm thick polycarbonate substrate having a diameter of 12 cm, which had irregularity for a tracking guide formed of continuous groove on a surface thereof, a 120nm thick Ag-Pd (1 atm%)-Cu (1 atm%) as a reflection layer, 15nm thick ZnS·SiO$_2$ (20 mol%) as a second protective layer, 12nm thick Ga11Sb84Ge5 as a recording layer, and 100nm thick ZnS·SiO$_2$ (20 mol%) having as a first protective layer, were sequentially disposed. A sputtering method in Ar gas atmosphere was employed for disposing these layers.

On the first protective layer, a 50$\mu$m thick polycarbonate film was laminated, via a 50$\mu$m thick adhesive sheet, thus forming a 0.1mm thick light transmittance layer, and an optical recording medium was manufactured. Subsequently, by an initialization apparatus having a semiconductor laser of large diameter, the recording layer of the optical recording medium was subjected to initialization.

Recording was carried out under a condition shown in the following as to thus manufactured optical recording medium.

<Recording condition>

· Wavelength of laser beam        407nm
· Numerical aperture NA        0.85
· Linear velocity        5.7m/s, 17.1m/s, 34.2m/s
· Tracking pitch        0.32$\mu$m

Recording was carried out under the following condition as to each manufactured optical recording medium. Upon recording, under a condition of linear density of 0.13$\mu$m/bit, jitter value and a degree of modulation (M), and jitter value and a degree of modulation (M) after 1000 time recording was measured. It was found out that jitter value and degree of modulation (M) were excellent and the optical recording medium had excellent overwriting property, within a linear velocity of 5.7 m/s to 34.2m/s. In addition, even when thicknesses of each layer was changed within a limitation of the present invention, the above properties were obtained.

(EXAMPLE C-11)

On a 0.6mm thick polycarbonate substrate having a diameter of 12 cm, which had irregularity for a tracking guide formed of continuous groove having a pitch of 0.4$\mu$m on a surface thereof, 150nm thick ZnS·SiO$_2$ (20 mol%) having as a first protective layer, 10nm thick ZnS·SiO$_2$ (20 mol%) as a second protective layer, a 10nm thick Ag-Pd (1 atm%)-Cu (1 atm%) as a reflection layer, and a 200nm thick heat dissipation layer which contained AlN, were sequentially disposed, so as to form a first information layer. The light transmittance rate of the first information layer was 42%, when the laser beam had wavelength of 407nm.

On the first information layer, by photopolymer method, a transparent layer which had irregularity for a tracking guide formed of continuous groove of pitch 0.4$\mu$m, was formed. The thickness of the transparent layer was 30$\mu$m. On the transparent layer, a 40nm thick ZnS·SiO$_2$ (20 mol%) as a first protective layer, a 12nm thick Ga11Sb84Ge5 as a second recording layer, a 15nm thick ZnS·SiO$_2$ (20 mol%) as a second protective layer, and a 150nm Ag-Pd (1 atm%)-Cu (1 atm%) as a reflection layer, were sequentially disposed so as to form a second information layer. A sputtering method in Ar gas atmosphere was employed for disposing each of the layers.

On the second information layer, an overcoat layer was formed using a spin coater, and a double-layer optical recording medium was thus manufactured. Subsequently, by an initialization apparatus having a semiconductor laser of large diameter, the recording layers of the double-layer optical recording medium was subjected to initialization.

Recording was carried out under a condition shown in the following as to the double-layer optical recording medium.

<Recording condition>

    · Wavelength of laser beam        407nm
    · Numerical aperture NA          0.65
    · Linear velocity          17.1m/s

Upon recording, under a condition of linear density of 0.18$\mu$m/bit, jitter value and a degree of modulation (M), and jitter and a degree of modulation (M) after 1,000 time recording were measured.

In addition, according to the experiment apart from the above Examples, the light transmittance rate of the first information layer was required to be 40% or more in order to conduct recording and reproducing in the second information layer in good condition.

As described above, according to the present invention, it is possible to provide an optical recording medium having a large degree of modulation, showing excellence in recording and reproducing, and further good overwriting property, by using Ga and Sb in the recording layer and restricting a composition ratio thereof, even when a laser beam having wavelength of 350nm to 450nm. In addition, by defining thickness of each of the layers, it is possible to achieve an optical recording medium having an excellent recording sensitivity.

The optical recording medium of the present invention can cope with shorter wavelength of a laser beam, and also can cope with an optical pickup apparatus having a high numerical aperture (NA). Therefore, recording with a high density can be carried out, and thus recording capacity is enlarged.

The following EXAMPLEs D-1 to D-10, and COMPARATIVE EXAMPLEs D-1 and D-4 indicate an aspect of the present invention, where the recording layer of an optical recording medium contains Ga, Sb, Ri and Rh.

(EXAMPLES D-1 to D-10, COMPARATIVE EXAMPLES D-1 to D-4)

In order to manufacture an optical recording medium having a composition as shown in TABLE 10, on a 0.6mm thick polycarbonate substrate having track pitch of 0.7$\mu$m, groove depth of 400Å (40nm), and a diameter of 120mm, a first protective layer (thickness: 700Å (70nm)), a recording layer (thickness: 150Å (15nm)), an second protective layer (thickness: 250Å (25nm)), and a reflection layer (thickness:1000Å (100nm)) were sequentially formed by a sputtering method, and further on the reflection layer, an surrounding protective layer was provided by spin coating method. Subsequently, after having thus obtained optical recording medium subjected to initial crystallization, signal property of the optical recording medium was evaluated. In order to evaluate a response against higher linear velocity, evaluation items were determined as follows: recording linear velocity and recording power were 3.5m/ s (10mW), 15m/s (16mW), 25m/s (26mW), and 35m/s (36mW), respectively. Wavelength of recording laser beam was 650nm, overwriting was repeated in EFM (Eight to Fourteen Modulation) random pattern. Evaluation of reproduced signal property was conducted as to a jitter value of 3T signal and a degree of modulation of 14T signal. A archival stability was evaluated by 3T signal jitter value and 14T signal degree of modulation at the 1000 times of overwriting, as to the optical recording medium, which had been overwritten for 1000 times and maintained for 300 hours under the temperature of 80°C and humidity of 85RH%. The result is shown in the following TABLE 11, TABLE 12, and TABLE 13.

[TABLE 10]

|  | First protective layer | Recording layer | Second protective layer | Reflection layer |
|---|---|---|---|---|
| Ex. D-1 | $(ZnS)_{80}(SiO_2)_{20}$ (mol%) | Ga10Sb85Bi3Rh2 (atm%) | $(ZnS)_{80}(SiO_2)_{20}$(mol%) | Ag96Cu2Ni2 |
| Ex. D-2 | $(ZnS)_{80}(SiO_2)_{20}$ | Ga9Sb85Bi3Rh2Cu1 | $(ZnS)_{80}(SiO2)_{20}$ | Ag96Cu2Ni2 |
| Ex. D-3 | $(ZnS)_{80}(SiO_2)_{20}$ | Ga9Sb85Bi3Rh2B1 | $(ZnS)_{80}(SiO2)_{20}$ | $Ag_{96}Cu_2Ni_2$ |
| Ex. D-4 | $(ZnS)_{80}(SiO2)_{20}$ | Ga9Sb85Bi3Rh2N1 | $(ZnS)_{80}(SiO_2)_{20}$ | Ag96Cu2Ni2 |
| Ex. D-5 | $(ZnS)_{80}(SiO_2)_{20}$ | Ga9Sb85Bi3Rh2Ge1 | $(ZnS)_{80}(SiO_2)_{20}$ | Ag96Cu2Ni2 |
| Ex. D-6 | $(ZnS)_{80}(SiO_2)_{20}$ | Ga9Sb85Bi3Rh2Fe1 | $(ZnS)_{80}(SiO_2)_{20}$ | Ag96Cu2Ni2 |
| Ex. D-7 | $(ZnS)_{80}(SiO_2)_{20}$ | Ga9Sb85Bi3Rh2Ir1 | $(ZnS)_{80}(SiO_2)_{20}$ | Ag96Cu2Ni2 |
| Ex. D-8 | $(ZnS)_{80}(SiO_2)_{20}$ | Ga12Sb88 | $(ZnS)_{80}(SiO_2)_{20}$ | Ag96Cu2Ni2 |
| Ex. D-9 | $(ZnS)_{80}(SiO_2)_{20}$ | Ga10Sb88Bi2 | $(ZnS)_{80}(SiO_2)_{20}$ | Ag96Cu2Ni2 |
| Ex. D-10 | $(ZnS)_{80}(SiO_2)_{20}$ | Ga10Sb88Ge2 | $(ZnS)_{80}(SiO_2)_{20}$ | Ag96Cu2Ni2 |
| Comp. Ex. D-1 | $(ZnS)_{80}(SiO_2)_{20}$ | Ga50Sb50 | $(ZnS)_{80}(SiO_2)_{20}$ | Ag96Cu2Ni2 |
| Comp.Ex. D-2 | $(ZnS)_{80}(SiO_2)_{20}$ | Ga4Sb96 | $(ZnS)_{80}(SiO_2)_{20}$ | Ag96Cu2Ni2 |
| Comp.Ex. D-3 | $(ZnS)_{80}(SiO_2)_{20}$ | Ga2Sb96Bi1Rh1 | $(ZnS)_{80}(SiO_2)_{20}$ | Ag96Cu2Ni2 |
| Comp.Ex. D-4 | $(ZnS)_{80}(SiO_2)_{20}$ | Ag1In3Sb80Te16 | $(ZnS)_{80}(SiO_2)_{20}$ | Ag96Cu2Ni2 |

As for initial crystallization, in EXAMPLEs D-1 to D-10, and in COMPARATIVE EXAMPLE D-4, a semiconductor laser with 700 mW output was used. In COMPARATIVE EXAMPLE D-1, a semiconductor laser with 1000 mW output was used.

[TABLE 11]

| | Recording Linear Velocity (m/s) | Recording Power (mW) | Jitter Value after Overwriting | | Degree of Modulation (M) after Overwriting | | Reflectance, Rg(%) after Overwriting | | Archival Stability | | Reflectance, Rb(%) after Overwriting | |
|---|---|---|---|---|---|---|---|---|---|---|---|---|
| | | | 1 time | 1000 times | 1 time | 1000 times | 1 time | 1000 times | Jitter Value (%) | Degree of Modulcation (M) after Overwriting | 1 time | 1000 times |
| EX. D-1 | 3.5 | 10 | 7.2 | 7.3 | 65 | 67 | 19.8 | 19.6 | 7.5 | 0.65 (65%) | 6.9 | 6.5 |
| | 15 | 16 | 7.2 | 7.3 | 65 | 67 | 19.7 | 19.4 | 7.5 | 0.65 (65%) | 6.9 | 6.4 |
| | 25 | 26 | 7.3 | 7.5 | 63 | 65 | 19.5 | 19.2 | 7.7 | 0.63 (63%) | 7.2 | 6.7 |
| | 35 | 36 | 7.6 | 7.8 | 62 | 64 | 19.3 | 18.9 | 8.0 | 0.62 (62%) | 7.3 | 6.8 |
| EX. D-2 | 3.5 | 10 | 7.1 | 7.4 | 66 | 68 | 20.4 | 20.2 | 7.6 | 0.66 (66%) | 6.9 | 6.5 |
| | 15 | 16 | 7.2 | 7.5 | 65 | 68 | 20.3 | 20.0 | 7.7 | 0.65 (65%) | 7.1 | 6.4 |
| | 25 | 26 | 7.3 | 7.6 | 64 | 66 | 20.0 | 19.7 | 7.8 | 0.64 (64%) | 7.2 | 6.7 |
| | 35 | 36 | 7.6 | 7.9 | 63 | 65 | 19.8 | 19.5 | 8.1 | 0.63 (63%) | 7.3 | 6.8 |
| EX. D-3 | 3.5 | 10 | 7.2 | 7.3 | 68 | 70 | 20.0 | 19.7 | 7.4 | 0.68 (68%) | 6.4 | 5.9 |
| | 15 | 16 | 7.3 | 7.5 | 67 | 69 | 20.1 | 19.7 | 7.6 | 0.67 (67%) | 6.6 | 6.1 |
| | 25 | 26 | 7.4 | 7.6 | 66 | 68 | 19.9 | 19.5 | 7.7 | 0.66 (66%) | 6.8 | 6.2 |
| | 35 | 36 | 7.7 | 7.9 | 65 | 68 | 19.7 | 19.4 | 8.0 | 0.66 (66%) | 6.9 | 6.2 |
| EX. D-4 | 3.5 | 10 | 7.0 | 7.2 | 66 | 68 | 20.2 | 20.0 | 7.3 | 0.66 (66%) | 6.9 | 6.4 |
| | 15 | 16 | 7.2 | 7.4 | 66 | 68 | 20.0 | 19.8 | 7.5 | 0.66 (66%) | 6.8 | 6.3 |
| | 25 | 26 | 7.4 | 7.5 | 65 | 67 | 19.7 | 19.4 | 7.6 | 0.65 (65%) | 6.9 | 6.4 |
| | 35 | 36 | 7.7 | 7.8 | 63 | 66 | 19.7 | 19.3 | 8.0 | 0.64 (64%) | 7.3 | 6.6 |
| EX. D-5 | 3.5 | 10 | 7.1 | 7.1 | 67 | 69 | 20.2 | 19.9 | 7.2 | 0.67 (67%) | 6.7 | 6.2 |
| | 15 | 16 | 7.2 | 7.3 | 67 | 69 | 20.0 | 19.8 | 7.4 | 0.67 (67%) | 6.6 | 6.1 |
| | 25 | 26 | 7.3 | 7.4 | 66 | 68 | 19.8 | 19.5 | 7.5 | 0.66 (66%) | 6.7 | 6.2 |
| | 35 | 36 | 7.7 | 7.9 | 65 | 67 | 19.6 | 19.2 | 7.9 | 0.65 (65%) | 6.9 | 6.3 |

[TABLE 12]

| | Recording Linear Velocity (m/s) | Recording Power (mW) | Jitter Value after Overwriting | | Degree of Modulation (M) after Overwriting | | Reflectance, Rg(%) after Overwriting | | Archival Stability | | Reflectance, Rb(%) after Overwriting | |
|---|---|---|---|---|---|---|---|---|---|---|---|---|
| | | | 1 time | 1000 times | 1 time | 1000 times | 1 time | 1000 times | Jitter Value (%) | Degree of Modulcation (M) after Overwriting | 1 time | 1000 times |
| EX. D-6 | 3.5 | 10 | 7.2 | 7.4 | 67 | 69 | 20.2 | 19.9 | 7.5 | 0.67 (67%) | 6.7 | 6.2 |
| | 15 | 16 | 7.5 | 7.6 | 67 | 69 | 20.0 | 19.8 | 7.7 | 0.67 (67%) | 6.6 | 6.1 |
| | 25 | 26 | 7.7 | 7.8 | 67 | 68 | 19.8 | 19.6 | 7.9 | 0.66 (66%) | 6.5 | 6.3 |
| | 35 | 36 | 7.8 | 7.9 | 66 | 68 | 19.5 | 19.3 | 8.0 | 0.66 (66%) | 6.6 | 6.2 |
| EX. D-7 | 3.5 | 10 | 7.0 | 7.2 | 66 | 68 | 20.4 | 20.0 | 7.3 | 0.66 (66%) | 6.9 | 6.4 |
| | 15 | 16 | 7.2 | 7.4 | 65 | 67 | 20.2 | 19.9 | 7.5 | 0.65 (65%) | 7.1 | 6.6 |
| | 25 | 26 | 7.4 | 7.6 | 64 | 66 | 20.0 | 19.8 | 7.7 | 0.64 (64%) | 7.2 | 6.7 |
| | 35 | 36 | 7.7 | 7.9 | 63 | 65 | 19.8 | 19.5 | 7.9 | 0.63 (63%) | 7.3 | 6.8 |
| EX. D-8 | 3.5 | 10 | 9.0 | 9.2 | 55 | 57 | 20.2 | 19.9 | 9.3 | 0.56 (56%) | 9.1 | 8.6 |
| | 15 | 16 | 8.7 | 9.0 | 63 | 64 | 20.0 | 19.8 | 9.1 | 0.62 (62%) | 7.4 | 7.1 |
| | 25 | 26 | 8.8 | 9.1 | 62 | 63 | 20.1 | 19.7 | 9.4 | 0.60 (60%) | 7.6 | 7.3 |
| | 35 | 36 | 8.9 | 9.5 | 58 | 54 | 19.7 | 19.5 | 10.0 | 0.57 (57%) | 8.3 | 9.0 |
| EX. D-9 | 3.5 | 10 | 7.2 | 7.9 | 66 | 68 | 19.8 | 19.6 | 10.8 | 0.67 (67%) | 6.7 | 6.3 |
| | 15 | 16 | 7.3 | 8.1 | 65 | 67 | 19.7 | 19.6 | 11.0 | 0.66 (66%) | 6.9 | 6.5 |
| | 25 | 26 | 7.4 | 8.3 | 64 | 66 | 19.7 | 19.4 | 11.3 | 0.65 (65%) | 7.1 | 6.6 |
| | 35 | 36 | 7.7 | 8.8 | 63 | 65 | 19.6 | 19.3 | 11.8 | 0.64 (64%) | 7.3 | 6.8 |

[TABLE 13]

| | Recording Linear Velocity | Recording Power | Jitter Value after Overwriting | | Degree of Modulation (M) after Overwriting | | Reflectance, Rg(%) after Overwriting | | Archival Stability | | Reflectance, Rb(%) after Overwriting | |
|---|---|---|---|---|---|---|---|---|---|---|---|---|
| | (m/s) | (mW) | 1 time | 1000 times | 1 time | 1000 times | 1 time | 1000 times | Jitter Value (%) | Degree of Modulcation (M) after Overwriting | 1 time | 1000 times |
| EX. D-10 | 3.5 | 10 | 9.0 | 9.5 | 54 | 56 | 19.5 | 19.2 | 9.7 | 0.56 (56%) | 9.0 | 8.4 |
| | 15 | 16 | 9.4 | 9.9 | 53 | 55 | 19.5 | 19.1 | 10.1 | 0.55 (55%) | 9.2 | 8.6 |
| | 25 | 26 | 9.9 | 10.5 | 52 | 54 | 19.3 | 19.1 | 10.7 | 0.54 (54%) | 9.3 | 8.8 |
| | 35 | 36 | 10.7 | 11.3 | 51 | 53 | 19.2 | 18.9 | 11.5 | 0.53(53%) | 9.4 | 8.9 |
| COMP. EX. D-1 | 3.5 | 10 | 10.3 | 9.9 | 51 | 56 | 18.0 | 18.0 | 13.1 | 0.56 (56%) | 8.8 | 7.9 |
| | 15 | 16 | 10.7 | 10.5 | 50 | 56 | 17.9 | 17.5 | 14.1 | 0.55 (55%) | 9.0 | 7.7 |
| | 25 | 26 | 10.8 | 11.7 | 50 | 55 | 17.2 | 17.3 | 14.8 | 0.54 (54%) | 8.6 | 7.8 |
| | 35 | 36 | - | - | 45 | 48 | 17.0 | 16.9 | - | 0.42 (42%) | 9.4 | 8.8 |
| COMP. EX. D-2 | 3.5 | 10 | - | - | 42 | 43 | 25.0 | 24.6 | - | 0.40 (40%) | 14.5 | 14.0 |
| | 15 | 16 | 11.5 | 14.0 | 43 | 43 | 24.8 | 24.5 | 11.8 | 0.40 (40%) | 14.1 | 14.0 |
| | 25 | 26 | 11.0 | 12.0 | 45 | 46 | 24.3 | 24.0 | 10.3 | 0.42 (42%) | 13.4 | 13.0 |
| | 35 | 36 | - | - | 43 | 42 | 24.2 | 23.8 | - | 0.40 (40%) | 13.8 | 13.8 |
| COMP. EX. D-3 | 3.5 | 10 | - | - | 54 | 50 | 25.5 | 25.2 | - | 0.48 (48%) | 11.7 | 12.6 |
| | 15 | 16 | 12.0 | 12.5 | 56 | 54 | 25.4 | 25.0 | 13.5 | 0.52 (52%) | 11.2 | 11.5 |
| | 25 | 26 | 11.9 | 12.3 | 57 | 56 | 25.3 | 25.0 | 13.0 | 0.53 (53%) | 10.9 | 11.0 |
| | 35 | 36 | 12.3 | 12.6 | 52 | 50 | 25.0 | 24.6 | 13.8 | 0.47 (47%) | 12.0 | 12.3 |
| COMP. EX. D-4 | 3.5 | 10 | 7.1 | 7.3 | 65 | 68 | 19.5 | 19.2 | 7.5 | 0.65 (65%) | 6.8 | 6.1 |
| | 15 | 16 | 9.3 | 9.5 | 64 | 68 | 19.3 | 19.1 | 9.8 | 0.63 (63%) | 6.9 | 6.1 |
| | 25 | 26 | Unable to Overwrite | | | | | | | | | |
| | 35 | 36 | | | | | | | | | | |

EP 1 566 802 B1

As apparently shown in TABLE 11, TABLE 12, and TABLE 13, it was found out that the optical recording medium of the present invention enables overwriting even within a wide range of linear velocity of 3.5m/s,15 m/s (16 mW), 25m/s (26 mW), and 35m/s (36 mW), and in particular, at the linear velocity over 25m/ s, which was considered to be difficult for overwriting in the related art. In addition, jitter value and degree of modulation of reproduced signal were excellent, archival stability and a repetition property in overwriting were also excellent. On the contrary, as for the optical recording medium of COMPARATIVE EXAMPLE D-1 using eutectic compositions one of Ga50Sb50, overwriting at a high linear velocity could be carried out, but had a poor jitter value, a poor degree of modulation, archival stability and repetition property in overwriting, and also initial crystallization was not easily carried out, comparing to the EXAMPLEs. In addition, as for the material of Ag-In-Sb-Te in COMPARATIVE EXAMPLE D-2, overwriting at linear velocity of 25m/ s and 35m/ s could not be carried out.

According to an aspect of the present invention where the recording layer comprises Ga, Sb, Bi, and Rh, it is possible to provide an optical recording medium having a capacity equivalent to that of DVD-ROM, having a sufficient degree of modulation even at a wide range of recording linear velocity of 3.0 m/s to 35 m/s, excellent in repetition property in overwriting and superior in archival stability. Therefore, the present invention largely contributes to progress in a filed of optical recording.

The following EXAMPLEs E-1 to E-6, and COMPARATIVE EXAMPLEs E-1 and E-2 indicate an aspect of the present invention where the recording layer comprised Ga, Sb, Zr, and Mg.

(EXAMPLE E-1)

As shown in FIG. 2, on a 0.6mm thick polycarbonate substrate having track pitch of $0.7\mu$m, groove depth of 400Å (40nm), diameter of 120mm, a first protective layer 2(thickness: 750Å (75nm)) comprising $(ZnS)_{80}(SiO_2)_{20}$ (mol%), a recording layer (thickness :150Å (15nm)) comprising Ga10Sb88Zr1Mg1, a second protective layer 4 (thickness: 300Å (30nm)) comprising $(ZnS)_{80}(SiO_2)_{20}$ (mol%) and a reflection layer 5(thickness: 950Å (95nm)) comprising Ag alloy, were sequentially disposed by a sputtering method. On the reflection layer 5, an surrounding protective layer 6(thickness: around 5 nm) comprising an acrylic resin was formed by a spin coating method, whereby a optical recording medium for evaluation having a layer structure as shown in FIG. 2 was manufactured.

TABLE 14 shows composition ratio of the material and thickness of each of the layers.

(EXAMPLEs E-2 to E-6)

A optical recording medium for evaluation for use in the EXAMPLES E-2 to E-6 was manufactured in the same manner as in EXAMPLE E-1, except that Ga10Sb88Zr1Mg1, used as material for the recording layer, was replaced by the following materials:

    · Ga9Sb88Zr1Mg1Al1         (EXAMPLE E-2)
    · Ga9Sb87Zr1Mg1Sn2         (EXAMPLE E-3)
    · Ga10Sb87Zr1Mg1Se1         (EXAMPLE E-4)
    · Ga9Sb87Zr1Mg2N1         (EXAMPLE E-5)
    · Ga10Sb87Zr1Mg1C1         (EXAMPLE E-6)

TABLE 14 shows, in summary, composition ratio of the material and thickness of each of the layers in EXAMPLES E-2 to E-6.

[TABLE 14]

| | First protective layer | | Recording layer | | Second protective layer | | Reflection layer | |
|---|---|---|---|---|---|---|---|---|
| | Material composition (mol %) | Thickness (Å)/(nm) | Material composition (atm%) | Thickness (Å)/(nm) | Material composition (mol %) | Thickness (Å)/(nm) | Material | Thickness (Å)/(nm) |
| Ex. E-1 | $(ZnS)_{80}(SiO_2)_{20}$ | 750/75 | Ga10Sb88Zr1Mg1 | 150/15 | $(ZnS)_{80}(SiO_2)_{20}$ | 300/30 | Ag alloy | 950/95 |
| Ex. E-2 | $(ZnS)_{80}(SiO_2)_{20}$ | 750/75 | Ga9Sb88Zr1Mg1Al1 | 150/15 | $(ZnS)_{80}(SiO_2)_{20}$ | 300/30 | Ag alloy | 950/95 |
| Ex. E-3 | $(ZnS)_{80}(SiO_2)_{20}$ | 750/75 | Ga9Sb87Zr1Mg1Sn2 | 150/15 | $(ZnS)_{80}(SiO_2)_{20}$ | 300/30 | Ag alloy | 950/95 |
| Ex. E-4 | $(ZnS)_{80}(SiO_2)_{20}$ | 750/75 | Ga10Sb87Zr1Mg1Se1 | 150/15 | $(ZnS)_{80}(SiO_2)_{20}$ | 300/30 | Ag alloy | 950/95 |
| Ex. E-5 | $(ZnS)_{80}(SiO_2)_{20}$ | 750/75 | Ga9Sb87Zr1Mg2N1 | 150/15 | $(ZnS)_{80}(SiO_2)_{20}$ | 300/30 | Ag alloy | 950/95 |
| Ex. E-6 | $(ZnS)_{80}(SiO_2)_{20}$ | 750/75 | Ga10Sb87Zr1Mg1C1 | 150/15 | $(ZnS)_{80}(SiO_2)_{20}$ | 300/30 | Ag alloy | 950/95 |

(COMPARATIVE EXAMPLEs E-1 and E-2)

An optical recording media for evaluation for use in the COMPARATIVE EXAMPLEs E-1 and E-2 were manufactured in the same manner as described in EXAMPLE E-1, except that the composition ratio of the material in the recording layer and thicknesses were changed as shown in TABLE 15. It should be noted that as shown in TABLE 15, the thicknesses of the recording layer, the second protective layer and reflection layer vary among the COMPARATIVE EXAMPLEs.

[TABLE 15]

| Comparative examples | First protective layer | | Recording layer | | Second protective layer | | Reflection layer | |
|---|---|---|---|---|---|---|---|---|
| | Material composition (mol %) | Thickness (Å)/(nm) | Material composition (atm%) | Thickness (Å) /(nm) | Material composition (mol %) | Thickness (Å) /(nm) | Material | Thickness (Å) /(nm) |
| Comp. Ex. E-1 | $(ZnS)_{80}(SiO_2)_{20}$ | 750/75 | Ga50Sb50 | 160/16 | $(ZnS)_{80}(SiO_2)_{20}$ | 200/20 | Ag alloy | 9000/900 |
| Comp.Ex. E-2 | $(ZnS)_{80}(SiO_2)_{20}$ | 750/75 | Ag1In3Sb80Te16 | 160/16 | $(ZnS)_{80}(SiO_2)_{20}$ | 200/20 | Ag alloy | 1000/100 |

The recording layer of the optical recording media manufactured in the EXAMPLES E-1 to E-6 and COMPARATIVE EXAMPLEs E-1 and E-2 was amorphous, and for evaluation, the optical recording media was subjected to initial crystallization (initialization) and rendered in unrecorded state. Here, in the EXAMPLES E-1 to E-6 and COMPARATIVE EXAMPLEs E-1 and E-3, high output semiconductor laser was used, and initialization was carried out at 700mW output. However, as to the COMPARATIVE EXAMPLE E-1, initialization failed with the 700mW output laser, and thus it was carried out at the condition of 1100 mW output.

After initialization, a reproduced signal property and storage property of each evaluation-purpose optical recording medium (recording medium) were evaluated.

The evaluation was carried out by setting the recording linear velocity and recording power (in parenthesis), 3.5m/s (10mW), 15m/s (16mW), 25m/s (26mW), and 35m/s (36mW), respectively. Wavelength of a recording laser beam was 650nm, overwriting was repeated in EFM (Eight to Fourteen Modulation, 8-14 modulation) random pattern. Evaluation of reproduced signal property was conducted with a jitter value of 3T signal and a degree of modulation of 14T signal. A storage property was evaluated by 3T signal jitter value and 14T signal degree of modulation at the 1000th time of overwriting, as to the optical recording medium, which had been overwritten for 1000 times and maintained for 300 hours at the temperature of 80°C and humidity of 85%.

The results of evaluation of the EXAMPLEs E-1 to E-6 and COMPARATIVE EXAMPLEs E-1 and E-2 are shown in the following TABLE 16 and TABLE 17.

[TABLE 16]

|  | Recording linear velocity (m/s) | Recording power (mW) | Jitter value (%) after overwriting | | Degree of modulation (%) after overwriting | | Archival stability | |
|---|---|---|---|---|---|---|---|---|
|  |  |  | 1time | 1,000times | 1time | 1,000times | Jitter value (%) | Degree of modulation (%) |
| Ex. E-1 | 3.5 | 10 | 7.3 | 7.5 | 66 | 68 | 7.6 | 66 |
|  | 15 | 16 | 7.3 | 7.5 | 65 | 68 | 7.6 | 65 |
|  | 25 | 26 | 7.5 | 7.7 | 65 | 67 | 7.8 | 64 |
|  | 35 | 36 | 7.8 | 8.0 | 63 | 65 | 8.1 | 63 |
| Ex. E-2 | 3.5 | 10 | 7.3 | 7.4 | 66 | 68 | 7.5 | 66 |
|  | 15 | 16 | 7.3 | 7.5 | 66 | 68 | 7.5 | 66 |
|  | 25 | 26 | 7.5 | 7.7 | 65 | 67 | 7.7 | 65 |
|  | 35 | 36 | 7.8 | 8.0 | 64 | 66 | 8.0 | 64 |
| Ex. E-3 | 3.5 | 10 | 7.2 | 7.4 | 67 | 69 | 7.6 | 66 |
|  | 15 | 16 | 7.2 | 7.4 | 67 | 69 | 7.6 | 66 |
|  | 25 | 26 | 7.3 | 7.5 | 67 | 69 | 7.6 | 66 |
|  | 35 | 36 | 7.5 | 7.7 | 66 | 68 | 7.9 | 65 |
| Ex.E-4 | 3.5 | 10 | 7.4 | 7.5 | 64 | 66 | 7.6 | 64 |
|  | 15 | 16 | 7.4 | 7.5 | 64 | 66 | 7.6 | 64 |
|  | 25 | 26 | 7.5 | 7.6 | 64 | 66 | 7.7 | 64 |
|  | 35 | 36 | 7.7 | 7.8 | 63 | 65 | 7.9 | 63 |
| Ex. E-5 | 3.5 | 10 | 7.5 | 7.5 | 62 | 64 | 7.6 | 62 |
|  | 15 | 16 | 7.5 | 7.6 | 62 | 64 | 7.7 | 62 |
|  | 25 | 26 | 7.6 | 7.7 | 62 | 64 | 7.8 | 62 |
|  | 35 | 36 | 7.7 | 7.8 | 61 | 63 | 7.9 | 61 |

[TABLE 17]

| | Recording linear velocity (m/s) | Recording power (mW) | Jitter value (%) after overwriting | | Degree of modulation (%) after overwriting | | Archival stability | |
|---|---|---|---|---|---|---|---|---|
| | | | 1 time | 1,000 times | 1 time | 1,000 times | Jitter value (%) | Degree of modulation (%) |
| Ex. E-6 | 3.5 | 10 | 7.5 | 7.6 | 65 | 66 | 7.7 | 65 |
| | 15 | 16 | 7.5 | 7.6 | 65 | 66 | 7.7 | 65 |
| | 25 | 26 | 7.7 | 7.8 | 64 | 65 | 7.9 | 64 |
| | 35 | 36 | 7.8 | 7.9 | 63 | 64 | 8.0 | 63 |
| Comp. Ex. E-1 | 3.5 | 10 | 9.1 | 9.7 | 52 | 57 | 12.9 | 54 |
| | 15 | 16 | 9.7 | 10.5 | 51 | 55 | 13.8 | 53 |
| | 25 | 26 | 10.8 | 11.6 | 49 | 54 | 14.6 | 52 |
| | 35 | 36 | 11.9 | 12.9 | 48 | 53 | 15.6 | 51 |
| Comp. Ex. E-2 | 3.5 | 10 | 7.1 | 7.3 | 65 | 68 | 7.5 | 65 |
| | 15 | 16 | 9.2 | 9.4 | 64 | 68 | 9.7 | 63 |
| | 25 | 26 | * | * | * | * | * | * |
| | 35 | 36 | * | * | * | * | * | * |
| Here, "*" expresses "unable to overwriting." | | | | | | | | |

Obviously from TABLE 16 and TABLE 17, it was found out that the optical recording medium that uses recording materials comprising phase change alloy of the above aspect of the present invention, overwriting can be carried out even within a wide range of linear velocity of 3.5m/ s to 35m/s, and in particular, at the high linear velocity at 25m/ s or more, which was considered to be difficult for overwriting in the related art. In addition, jitter value and degree of modulation of reproduced signal are excellent, and the optical recording medium had excellent archival stability and a repetition property in overwriting.

On the contrary, as for the optical recording medium in the COMPARATIVE EXAMPLEs E-1 and E-2, using as a recording material, alloy having composition ratio of Ga50Sb50, or alloy having eutectic composition ratio of Ga12Sb88, overwriting at a high linear velocity can be carried out, but has a poor jitter value, a poor degree of modulation, a poor archival stability and a poor repetition property in overwriting.

Further, Ag-In-Sb-Te alloy in the COMPARATIVE EXAMPLE E-2, overwriting at linear velocity of 25m/ s and 35m/ s could not be carried out.

According to another aspect of the present invention where the recording layer comprises Ga, Sb, Zr, and Mg, the present invention can provide a optical recording medium having a large capacity equivalent to that of DVD-ROM, even at a wide range of recording linear velocity from 3.5 m/ s to 35 m/ s, including 25 m/ s or more, having a sufficient degree of modulation, excellence in repetition property in overwriting and in archival stability.

According to the above aspect of the present invention, when the recording layer further comprises at least one element selected from Al, C, N, Se, and Sn, the present invention can provide an optical recording medium having a further enhanced archival stability or high-speed crystallization.

According to an aspect of the present invention where the optical recording medium further comprises a surrounding protective layer, the present invention can provide a optical recording medium in which, at high speed recording linear velocity, large capacity, a sufficient degree of modulation, maintenance of repetition property in overwriting, and maintenance of archival stability can be attained.

**Claims**

1. An optical recording process including the steps of:

    forming a laser beam which reversibly phase changes between an amorphous phase and a crystalline phase in a recording layer (2) which is disposed on a substrate (7) of an optical recording medium so as to have a single pulse or a plurality of pulses; and
    irradiating the laser beam to the optical recording medium at a linear velocity (V) of between more than 3 m/s and 40 m/s or less, and at a recording power (Pw) having a power density of 20 20mW/$\mu$m$^2$ or more, so as to record in the recording layer (2);

said optical recording medium including a substrate (7) and a recording layer (2) disposed on the substrate (7);

wherein the recording layer (2) contains Ga and Sb, the content of Sb being 80 % by atom to 95 % by atom relative to the total content of the Ga and the Sb in the recording layer (2).

2. An optical recording process according to Claim 1, wherein a laser beam having a wavelength of 350 nm to 700 nm is irradiated at a linear velocity (V) of between more than 3 m/s and 40 m/s or less.

3. An optical recording process according to one of Claims 1 and 2, wherein the recording is carried out at a linear velocity of 10 m/s or more.

4. An optical recording process according to any one of Claims 1 to 3, wherein the total content of Ga and Sb in the recording layer (2) is 90 atom % or more.

5. An optical recording process according to Claim 4, wherein the total content of Ga and Sb in the recording layer (2) is 95 atom % or more.

6. An optical recording process according to any one of Claims 1 to 5, wherein the content of Sb is 85 atom % to 95 atom % relative to the total content of Ga and Sb in the recording layer (2).

7. An optical recording process according to any of Claims 2 to 6, wherein the optical recording medium includes:

the substrate (7);
a first protective layer (1);
the recording layer (2);
a second protective layer (3); and
a reflection layer (4),

wherein the first protective layer(1), the recording layer(2), the second protective layer (3), and the reflection layer (4) are disposed on the substrate (7) in this order, and the thickness of the reflection layer(4) satisfies a relation of: 0.10$\lambda$ or more, when the "$\lambda$" expresses the wavelength of the laser beam.

8. An optical recording process according to any one of Claims 2 to 7, wherein the laser beam has a wavelength of 630 nm to 700 nm.

9. An optical recording process according to Claim 8, wherein the optical recording medium includes:

the substrate (7);
the first protective layer (1);
the recording layer (2);
the second protective layer (3); and
the reflection layer (4),

wherein the first protective layer (1), the recording layer (2), the second protective layer (3), and the reflection layer (4) are disposed on the substrate (7) in this order, and each of the thickness of the first protective layer (1), the thickness of the recording layer(2), the thickness of the second protective layer (3), and the thickness of the reflection layer (4) satisfies the following relations, when "$\lambda$" expresses the wavelength of the laser beam;

$$0.070\lambda \leq t_1 \leq 0.16\lambda$$

$$0.015\lambda \leq t_2 \leq 0.032\lambda$$

$$0.011\lambda \le t_3 \le 0.040\lambda$$

$$0.\,10\lambda \le t_4\,;$$

wherein "$t_1$" expresses the thickness of the first protective layer (1), "$t_2$" expresses the thickness of the recording layer (2), "$t_3$" expresses the thickness of the second protective layer (3), and "$t_4$" expresses the thickness of the reflection layer(4).

10. An optical recording process according to one of Claims 8 and 9, wherein the thickness of the recording layer (2) is 5 nm to 25 nm.

11. An optical recording process according to Claim 10, wherein the thickness of the recording layer (2) is 8 nm to 20 nm.

12. An optical recording process according to any one of Claims 2 to 7, wherein the laser beam has a wavelength of 350 nm to 450 nm.

13. An optical recording process according to Claim 12, wherein the optical recording medium includes:

    the substrate (7);
    a first protective layer (1);
    the recording layer (2);
    a second protective layer (3); and
    the reflection layer(4),

wherein the first protective layer (1), the recording layer (2), the second protective layer (3), and the reflection layer (4) are disposed on the substrate (7) in this order, and each of the thickness of the first protective layer(1), the thickness of the recording layer (2), the thickness of the second protective layer(3), and the thickness of the reflection layer (4) satisfies the following relations, when "$\lambda$" expresses the wavelength of the laser beam;

$$0.070\lambda \le t_1 \le 0.5\lambda$$

$$0.015\lambda \le t_2 \le 0.05\lambda$$

$$0.011\lambda \le t_3 \le 0.055\lambda$$

$$0.\,10\lambda \le t_4\,;$$

wherein "$t_1$" expresses the thickness of the first protective layer (1), "$t_2$" expresses the thickness of the recording layer (2), "$t_3$" expresses the thickness of the second protective layer (3), and "$t_4$" expresses the thickness of the reflection layer (4).

14. An optical recording process according to Claim 12, wherein the optical recording medium includes:

    the substrate (7);
    the reflection layer(4);
    the second protective layer (3);

the recording layer (2);
the first protective layer (1); and
a light transmittance layer (5),

wherein the reflection layer (4), the second protective layer (3), the recording layer (2), the first protective layer (1), and the light transmittance layer (5) are disposed on the substrate (7) in this order, and each of a thickness of the reflection layer (4), a thickness of the second protective layer(3), a thickness of the recording layer (2), and a thickness of the first protective layer (2), and a thickness of the light transmittance layer (5) satisfies the following relations, when "$\lambda$" expresses the wavelength of the laser beam;

$$0.10\lambda \leq t_4 \leq 0.75\lambda$$

$$0.011\lambda \leq t_3 \leq 0.055\lambda$$

$$0.015\lambda \leq t_2 \leq 0.05\lambda$$

$$0.070\lambda \leq t_1 \leq 0.5\lambda$$

$$0 \leq t_5 \leq 0.6 \text{ mm,}$$

wherein "$t_4$" expresses the thickness of the reflection layer (4), "$t_3$" expresses the thickness of the second protective layer (3), "$t_2$" expresses the thickness of the recording layer (2), "$t_1$" expresses the thickness of the first protective layer (1), and "$t_5$" expresses the thickness of the light transmittance layer (5).

15. An optical recording process according to Claim 12, further including:one or more of the recording layers (2, 12, 22).

16. An optical recording process according to Claim 15, wherein the optical recording medium includes a first information layer (10) which has one of the recording layers (12, 22), and a second information layer (20) which has the other one of the recording layers (12, 22) in this order, from a direction that the laser beam is irradiated, and the light transmittance of the first information layer (10) is 40% or more with the wavelength.

17. An optical recording process according to Claim 3, wherein the recording and the erasing are carried out by the reversible phase change between the amorphous phase and the crystalline phase in the recording layer (2), at a linear velocity of 14 m/s or more.

18. An optical recording process according to Claim 17, wherein the recording and the erasing are carried out by the reversible phase change between the amorphous phase and the crystalline phase in the recording layer (2), at a linear velocity of 28 m/s or more.

19. An optical recording process according to any one of Claims 1 to 18, wherein a reflectance (Rg) at an unrecorded space part satisfies a relation of $12\% \leq Rg \leq 30\%$, when a laser beam having a wavelength between 350 nm and 700 nm is irradiated.

20. An optical recording process according to any one of Claims 1 to 19, wherein the optical recording medium has a degree of modulation (M) of 0.4 or more, when the recording is carried out at a linear velocity (V) of between more than 3 m/s and 40 m/s or less and at a wavelength of a laser beam of between 350 nm and 700 nm, and the degree of modulation (M) satisfies the relation of:

$$M=(Rg-Rb)/Rg,$$

where "M" expresses the degree of modulation, "Rb" expresses the reflectance at a recording mark of the optical recording medium, and "Rg" expresses the reflectance at an unrecorded space part of the optical recording medium.

21. An optical recording process according to Claim 20, wherein the optical recording medium has a degree of modulation (M) of 0.4 or more, when the recording is carried out by an optical lens having NA of 0.60 or more.

22. An optical recording process according to one of Claims 20 and 21, wherein the optical recording medium has a degree of modulation (M) of 0.6 or more.

23. An optical recording process according to Claim 20, wherein the optical recording medium has a degree of modulation (M) of 0.4 or more, when the recording is carried out at a linear velocity (V) between 10 m/s and 35 m/s.

24. An optical recording process according to Claim 23, wherein the optical recording medium has a jitter value of 10 % or less, when the recording is carried out at any linear velocity (V) between 10 m/s and 35 m/s.

25. An optical recording process according to any one of Claims 1 to 24, wherein the recording layer (2) further contains at least one additional element selected from Ag, Au, Cu, Zn, B, Al, In, Si, Ge, Sn, Pb, N, P, Bi, La, Ce, Gd, Tb, Mg, Co, Mn, Zr, Rh, Se, Fe, and Ir.

26. An optical recording process according to Claim 25, wherein the additional element contained in the recording layer (2) is at least one selected from Ag, Au, Cu, B, Al, In, Mn, Sn, Zn, Bi, Pb, Ge, Si, and N.

27. An optical recording process according to Claim 1, wherein the recording layer (2) contains an alloy expressed by the following Formula (1);

$$Ga_\alpha Sb_\beta X_\gamma \qquad \text{Formula (1)}$$

where "X" expresses one of an element and a mixture of elements excluding Ga and Sb, $\alpha$, $\beta$, and $\gamma$ are each expressed in atom %, and each satisfy relations of: $\alpha + \beta + \gamma = 100$, $5 \le \alpha \le 20$, $80 \le \beta \le 95$, and $0 < \gamma \le 10$.

28. An optical recording process according to Claim 27, wherein the "X" contains one of a single element and a mixture selected from Ag, Au, Cu, Zn, B, Al, In, Si, Ge, Sn, Pb, N, P, Bi, La, Ce, Gd, Tb, Mg, Co, Mn, Zr, Rh, Se, Fe, and Ir.

29. An optical recording process according to Claim 25, wherein the recording layer (2) contains Ga, Sb, Bi, and Rh.

30. An optical recording process according to Claim 29, wherein the recording layer (2) further contains one element selected from Cu, B, N, Ge, Fe, and Ir.

31. An optical recording process according to Claim 25, wherein the recording layer (2) contains Ga, Sb, Zr, and Mg.

32. An optical recording process according to Claim 31, wherein the recording layer (2) further contains one element selected from Al, C, N, Se, and Sn.

33. An optical recording process according to any one of Claims 1 to 32, wherein the optical recording medium includes:

    the substrate (7);
    the first protective layer (1);
    the recording layer (2);
    the second protective layer (3);
    the reflection layer(4); and
    a surrounding protective layer (6),

wherein the first protective layer (1), the recording layer (2), the second protective layer (3), and the reflection layer (4) are disposed on the substrate (7) in this order, and the surrounding protective layer (6) is disposed on a surface of the reflection layer (4).

34. An optical recording process according to any one of Claims 1 to 33, wherein the linear velocity (V) is between 10 m/s and 35 m/s.

35. An optical recording process according to Claim 1 to 34, wherein the laser beam is irradiated, so that a ratio of erasing power (Pe) to recording power (Pw) satisfies a relation of:

$$0.10 \leq Pe/Pw \leq 0.65,$$

where "Pe" expresses the erasing power and "Pw" expresses the recording power.

36. An optical recording process according to Claim 35, wherein the laser beam is irradiated so as to have a ratio of an erasing power (Pe) to the recording power (Pw) which satisfies the relation of:

$$0.13 \leq Pe/Pw \leq 0.6,$$

where "Pe" expresses the erasing power and "Pw" expresses the recording power.

**Patentansprüche**

1. Optisches Aufzeichnungsverfahren, welches die Schritte beinhaltet:

Erzeugen eines Laserstrahls, welcher in einer Aufzeichnungsschicht (2), die auf einem Substrat (7) eines optischen Aufzeichnungsmediums angeordnet ist, reversibel die Phase zwischen einer amorphen Phase und einer kristallinen Phase verändert, um einen Einzelpuls oder eine Vielzahl von Pulsen aufzuweisen; und Einstrahlen des Laserstrahls auf das optische Aufzeichnungsmedium bei einer Lineargeschwindigkeit (V) zwischen mehr als 3 m/s und 40 m/s oder weniger und bei einer Aufzeichnungsenergie (Pw) mit einer Energiedichte von 20 mW/$\mu$m$^2$ oder mehr, um in der Aufzeichnungsschicht (2) aufzuzeichnen;

wobei das optische Aufzeichnungsmedium ein Substrat (7) und eine auf dem Substrat (7) angeordnete Aufzeichnungsschicht (2) beinhaltet;
wobei die Aufzeichnungsschicht (2) Ga und Sb enthält und der Gehalt von Sb, bezogen auf den Gesamtgehalt von Ga und Sb in der Aufzeichnungsschicht (2), 80 Atom-% bis 95 Atom-% beträgt.

2. Optisches Aufzeichnungsverfahren gemäß Anspruch 1, wobei ein Laserstrahl mit einer Wellenlänge von 350 nm bis 700 nm bei einer Lineargeschwindigkeit (V) zwischen mehr als 3 m/s und 40 m/s oder weniger eingestrahlt wird.

3. Optisches Aufzeichnungsverfahren gemäß einem der Ansprüche 1 und 2, wobei die Aufzeichnung bei einer Lineargeschwindigkeit 10 m/s oder mehr durchgeführt wird.

4. Optisches Aufzeichnungsverfahren gemäß irgendeinem der Ansprüche 1 bis 3, wobei der Gesamtgehalt von Ga und Sb in der Aufzeichnungsschicht (2) 90 Atom-% oder mehr beträgt.

5. Optisches Aufzeichnungsverfahren gemäß Anspruch 4, wobei der Gesamtgehalt von Ga und Sb in der Aufzeichnungsschicht (2) 95 Atom-% oder mehr beträgt.

6. Optisches Aufzeichnungsverfahren gemäß irgendeinem der Ansprüche 1 bis 5, wobei der Gehalt von Sb, bezogen auf den Gesamtgehalt von Ga und Sb in der Aufzeichnungsschicht (2), 85 Atom-% bis 95 Atom-% beträgt.

7. Optisches Aufzeichnungsverfahren gemäß irgendeinem der Ansprüche 2 bis 6, wobei das optische Aufzeichnungsmedium umfasst:

das Substrat (7);

eine erste Schutzschicht (1);
die Aufzeichnungsschicht (2);
eine zweite Schutzschicht (3); und
eine Reflexionsschicht (4),

wobei die erste Schutzschicht (1), die Aufzeichnungsschicht (2), die zweite Schutzschicht (3) und die Reflexionsschicht (4) in dieser Reihenfolge auf dem Substrat (7) angeordnet sind, und die Dicke der Reflexionsschicht (4) die Bedingung: 0,10$\lambda$ oder mehr erfüllt, wenn "$\lambda$" die Wellenlänge des Laserstrahls bedeutet.

**8.** Optisches Aufzeichnungsverfahren gemäß irgendeinem der Ansprüche 2 bis 7, wobei der Laserstrahl eine Wellenlänge von 630 nm bis 700 nm hat.

**9.** Optisches Aufzeichnungsverfahren gemäß Anspruch 8, wobei das optische Aufzeichnungsmedium beinhaltet:

das Substrat (7);
die erste Schutzschicht (1);
die Aufzeichnungsschicht (2);
die zweite Schutzschicht (3); und
die Reflexionsschicht (4),

wobei die erste Schutzschicht (1), die Aufzeichnungsschicht (2), die zweite Schutzschicht (3) und die Reflexionsschicht (4) in dieser Reihenfolge auf dem Substrat (7) angeordnet sind, und die Dicke der ersten Schutzschicht (1), die Dicke der Aufzeichnungsschicht (2), die Dicke der zweiten Schutzschicht (3) und die Dicke der Reflexionsschicht (4) jeweils die folgenden Beziehungen erfüllen, wenn "$\lambda$" die Wellenlänge des Laserstrahls bedeutet:

$$0{,}070\lambda \leq t_1 \leq 0{,}16\lambda$$

$$0{,}015\lambda \leq t_2 \leq 0{,}032\lambda$$

$$0{,}011\lambda \leq t_3 \leq 0{,}040\lambda$$

$$0{,}10\lambda \leq t_4 \; ;$$

wobei "$t_1$" die Dicke der ersten Schutzschicht (1) bedeutet, "$t_2$" die Dicke der Aufzeichnungsschicht (2) bedeutet, "$t_3$" die Dicke der zweiten Schutzschicht (3) bedeutet und "$t_4$" die Dicke der Reflexionsschicht (4) bedeutet.

**10.** Optisches Aufzeichnungsverfahren gemäß einem der Ansprüche 8 und 9, wobei die Dicke der Aufzeichnungsschicht (2) 5 nm bis 25 nm beträgt.

**11.** Optisches Aufzeichnungsverfahren gemäß Anspruch 10, wobei die Dicke der Aufzeichnungsschicht (2) 8 nm bis 20 nm beträgt.

**12.** Optisches Aufzeichnungsverfahren gemäß irgendeinem der Ansprüche 2 bis 7, wobei der Laserstrahl eine Wellenlänge von 350 nm bis 450 nm hat.

**13.** Optisches Aufzeichnungsverfahren gemäß Anspruch 12, wobei das optische Aufzeichnungsmedium beinhaltet:

das Substrat (7);
eine erste Schutzschicht (1);
die Aufzeichnungsschicht (2);

eine zweite Schutzschicht (3); und
die Reflexionsschicht (4),

wobei die erste Schutzschicht (1), die Aufzeichnungsschicht (2), die zweite Schutzschicht (3) und die Reflexionsschicht (4) in dieser Reihenfolge auf dem Substrat (7) angeordnet sind, und die Dicke der ersten Schutzschicht (1), die Dicke der Aufzeichnungsschicht (2), die Dicke der zweiten Schutzschicht (3) und die Dicke der Reflexionsschicht (4) jeweils die folgenden Beziehungen erfüllen, wenn "$\lambda$" die Wellenlänge des Laserstrahls bedeutet:

$$0{,}070\lambda \le t_1 \le 0{,}5\lambda$$

$$0{,}015\lambda \le t_2 \le 0{,}05\lambda$$

$$0{,}011\lambda \le t_3 \le 0{,}055\lambda$$

$$0{,}10\lambda \le t_4 \;;$$

wobei "$t_1$" die Dicke der ersten Schutzschicht (1) bedeutet, "$t_2$" die Dicke der Aufzeichnungsschicht (2) bedeutet, "$t_3$" die Dicke der zweiten Schutzschicht (3) bedeutet und "$t_4$" die Dicke der Reflexionsschicht (4) bedeutet.

14. Optisches Aufzeichnungsverfahren gemäß Anspruch 12, wobei das optische Aufzeichnungsmedium beinhaltet:

das Substrat (7);
die Reflexionsschicht (4);
die zweite Schutzschicht (3);
die Aufzeichnungsschicht (2);
die erste Schutzschicht (1); und
eine Lichtdurchlässigkeitsschicht (5),

wobei die Reflexionsschicht (4), die zweite Schutzschicht (3), die Aufzeichnungsschicht (2), die erste Schutzschicht (1) und die Lichtdurchlässigkeitsschicht (5) in dieser Reihenfolge auf dem Substrat (7) angeordnet sind, und die Dicke der Reflexionsschicht (4), die Dicke der zweiten Schutzschicht (3), die Dicke der Aufzeichnungsschicht (2) und die Dicke der ersten Schutzschicht (2) und die Dicke der Lichtdurchlässigkeitsschicht (5) jeweils die folgenden Beziehungen erfüllen, wenn "$\lambda$" die Wellenlänge des Laserstrahls bedeutet:

$$0{,}10\lambda \le t_4 \le 0{,}75\lambda$$

$$0{,}011\lambda \le t_3 \le 0{,}055\lambda$$

$$0{,}015\lambda \le t_2 \le 0{,}05\lambda$$

$$0{,}070\lambda \le t_1 \le 0{,}5\lambda$$

$$0 \leq t_5 \leq 0,6 \text{ mm;}$$

wobei "$t_4$" die Dicke der Reflexionsschicht (4) bedeutet, "$t_3$" die Dicke der zweiten Schutzschicht (3) bedeutet, "$t_2$" die Dicke der Aufzeichnungsschicht (2) bedeutet, "$t_1$" die Dicke der ersten Schutzschicht (1) bedeutet und "$t_5$" die Dicke der Lichtdurchlässigkeitsschicht (5) bedeutet.

15. Optisches Aufzeichnungsverfahren gemäß Anspruch 12, ferner umfassend eine oder mehrere der Aufzeichnungsschichten (2, 12, 22).

16. Optisches Aufzeichnungsverfahren gemäß Anspruch 15, wobei das optische Aufzeichnungsmedium eine erste Informationsschicht (10), welche eine der Aufzeichnungsschichten (12, 22) aufweist, und eine zweite Informationsschicht (20), welche die andere der Aufzeichnungsschichten (12, 22) aufweist, in dieser Reihenfolge in einer Richtung beinhaltet, aus welcher der Laserstrahl eingestrahlt wird, und die Lichtdurchlässigkeit der ersten Informationsschicht (10) 40% oder mehr mit der Wellenlänge beträgt.

17. Optisches Aufzeichnungsverfahren gemäß Anspruch 3, wobei die Aufzeichnung und die Löschung durch die reversible Phasenänderung zwischen der amorphen Phase und der kristallinen Phase in der Aufzeichnungsschicht (2) bei einer Lineargeschwindigkeit von 14 m/s oder mehr durchgeführt werden.

18. Optisches Aufzeichnungsverfahren gemäß Anspruch 17, wobei die Aufzeichnung und die Löschung durch die reversible Phasenänderung zwischen der amorphen Phase und der kristallinen Phase in der Aufzeichnungsschicht (2) bei einer Lineargeschwindigkeit von 28 m/s oder mehr durchgeführt werden.

19. Optisches Aufzeichnungsverfahren gemäß irgendeinem der Ansprüche 1 bis 18, wobei der Reflexionsgrad (Rg) an einem unaufgezeichneten Raumteil die Beziehung 12% ≤ Rg ≤ 30% erfüllt, wenn ein Laserstrahl mit einer Wellenlänge zwischen 350 nm und 700 nm eingestrahlt wird.

20. Optisches Aufzeichnungsverfahren gemäß irgendeinem der Ansprüche 1 bis 19, wobei das optische Aufzeichnungsmedium einen Modulationsgrad (M) von 0,4 oder mehr aufweist, wenn die Aufzeichnung bei einer Lineargeschwindigkeit (V) zwischen mehr als 3 m/s und 40 m/s oder weniger und bei einer Wellenlänge des Laserstrahls zwischen 350 nm und 700 nm durchgeführt wird, und der Modulationsgrad die Beziehung erfüllt

$$M=(Rg-Rb)/Rg$$

wobei "M" den Modulationsgrad bedeutet, "Rb" den Reflexionsgrad an einer Aufzeichnungsmarkierung des optischen Aufzeichnungsmediums bedeutet und "Rg" den Reflexionsgrad an einem unaufgezeichneten Raumteil des optischen Aufzeichnungsmediums bedeutet.

21. Optisches Aufzeichnungsverfahren gemäß Anspruch 20, wobei das optische Aufzeichnungsmedium einen Modulationsgrad (M) von 0,4 oder mehr hat, wenn die Aufzeichnung mit einer optischen Linse mit einer NA von 0,60 oder mehr durchgeführt wird.

22. Optisches Aufzeichnungsverfahren gemäß einem der Ansprüche 20 und 21, wobei das optische Aufzeichnungsmedium einen Modulationsgrad (M) von 0,6 oder mehr hat.

23. Optisches Aufzeichnungsverfahren gemäß Anspruch 20, wobei das optische Aufzeichnungsmedium einen Modulationsgrad (M) von 0,4 oder mehr hat, wenn die Aufzeichnung bei einer Lineargeschwindigkeit (V) zwischen 10 m/s und 35 m/s durchgeführt wird.

24. Optisches Aufzeichnungsverfahren gemäß Anspruch 23, wobei das optische Aufzeichnungsmedium einen Jitterwert von 10% oder weniger aufweist, wenn die Aufzeichnung bei einer Lineargeschwindigkeit (V) zwischen 10 m/s und 35 m/s durchgeführt wird.

25. Optisches Aufzeichnungsverfahren gemäß irgendeinem der Ansprüche 1 bis 24, wobei die Aufzeichnungsschicht (2) ferner mindestens ein zusätzliches Element, ausgewählt aus Ag, Au, Cu, Zn, B, Al, In, Si, Ge, Sn, Pb, N, P, Bi, La, Ce, Gd, Tb, Mg, Co, Mn, Zr, Rh, Se, Fe und Ir enthält.

26. Optisches Aufzeichnungsverfahren gemäß Anspruch 25, wobei das in der Aufzeichnungsschicht (2) enthaltene zusätzliche Element mindestens eines ausgewählt aus Ag, Au, Cu, B, Al, In, Mn, Sn, Zn, Bi, Pb, Ge, Si und N ist.

27. Optisches Aufzeichnungsverfahren gemäß Anspruch 1, wobei die Aufzeichnungsschicht (2) eine durch die folgende Formel (1) ausgedrückte Legierung enthält:

$$Ga\alpha Sb\beta X\gamma \qquad \text{(Formel 1)}$$

wobei X ein Element ein Element oder eine Mischung von Elementen außer Ga und Sb umfasst, $\alpha$, $\beta$ und $\gamma$ jeweils in Atom-% ausgedrückt sind und jeweils Beziehungen erfüllen von: $\alpha + \beta + \gamma = 100$, $5 \leq \alpha \leq 20$, $80 \leq \beta \leq 95$ und $0 < \gamma \leq 10$.

28. Optisches Aufzeichnungsverfahren gemäß Anspruch 27, wobei X ein einzelnes Element oder eine Mischung von Elementen, ausgewählt aus Ag, Au, Cu, Zn, B, Al, In, Si, Ge, Sn, Pb, N, P, Bi, La, Ce, Gd, Tb, Mg, Co, Mn, Zr, Rh, Se, Fe und Ir umfasst.

29. Optisches Aufzeichnungsverfahren gemäß Anspruch 25, wobei die Aufzeichnungsschicht (2) Ga, Sb, Bi und Rh enthält.

30. Optisches Aufzeichnungsverfahren gemäß Anspruch 29, wobei die Aufzeichnungsschicht (2) ferner ein Element, ausgewählt aus Cu, B, N, Ge, Fe und Ir enthält.

31. Optisches Aufzeichnungsverfahren gemäß Anspruch 25, wobei die Aufzeichnungsschicht (2) Ga, Sb, Zr und Mg enthält.

32. Optisches Aufzeichnungsverfahren gemäß Anspruch 31, wobei die Aufzeichnungsschicht (2) ferner ein Element, ausgewählt aus Al, C, N, Se und Sn enthält.

33. Optisches Aufzeichnungsverfahren gemäß irgendeinem der Ansprüche 1 bis 32, wobei das optische Aufzeichnungsmedium beinhaltet:

   das Substrat (7);
   eine erste Schutzschicht (1);
   die Aufzeichnungsschicht (2);
   eine zweite Schutzschicht (3);
   eine Reflexionsschicht (4); und
   eine umgebende Schutzschicht (6),

wobei die erste Schutzschicht (1), die Aufzeichnungsschicht (2), die zweite Schutzschicht (3) und die Reflexionsschicht (4) in dieser Reihenfolge auf dem Substrat (7) angeordnet sind, und die umgebende Schutzschicht (6) auf einer Oberfläche der Reflexionsschicht (4) angeordnet ist.

34. Optisches Aufzeichnungsverfahren gemäß irgendeinem der Ansprüche 1 bis 33, wobei die Lineargeschwindigkeit (V) zwischen 10 m/s und 35 m/s liegt.

35. Optisches Aufzeichnungsverfahren gemäß irgendeinem der Ansprüche 1 bis 34, wobei der Laserstrahl so eingestrahlt wird, dass das Verhältnis von Löschenergie (Pe) zu Aufzeichnungsenergie (Pw) die Beziehung erfüllt:

$$0{,}10 \leq Pe/Pw \leq 0{,}65,$$

wobei "Pe" die Löschenergie bedeutet und "Pw" die Aufzeichnungsenergie bedeutet.

36. Optisches Aufzeichnungsverfahren gemäß Anspruch 35, wobei der Laserstrahl so eingestrahlt wird, dass ein Verhältnis von Löschenergie (Pe) zu Aufzeichnungsenergie (Pw) gegeben ist, welches die Beziehung erfüllt:

$$0,13 \leq Pe/Pw \leq 0,6,$$

wobei "Pe" die Löschenergie bedeutet und "Pw" die Aufzeichnungsenergie bedeutet.

**Revendications**

1. Processus d'enregistrement optique comprenant les étapes consistant à :

   former un faisceau laser qui change de phase de manière réversible entre une phase amorphe et une phase cristalline dans une couche d'enregistrement (2) qui est disposée sur un substrat (7) d'un support d'enregistrement optique de telle manière à avoir une impulsion unique ou une pluralité d'impulsions ; et
   irradier le faisceau laser sur le support d'enregistrement optique à une vitesse linéaire (V) comprise entre plus de 3 m/s et 40 m/s ou moins et à une puissance d'enregistrement (Pw) ayant une densité de puissance de 20 mm/$\mu^2$ ou plus, de telle manière à enregistrer dans la couche d'enregistrement (2) ;
   ledit support d'enregistrement optique comprenant un substrat (7) et une couche d'enregistrement (2) disposée sur le substrat (7) ;

   dans lequel la couche d'enregistrement (2) contient Ga et Sb, le contenu de Sb étant de 80 % par atome à 95 % par atome par rapport au contenu total du Ga et du Sb dans la couche d'enregistrement (2).

2. Processus d'enregistrement optique selon la revendication 1, dans lequel un faisceau laser ayant une longueur d'onde de 350 nm à 700 nm est irradié à une vitesse linéaire (V) comprise entre plus de 3 m/s et 40 m/s ou moins.

3. Processus d'enregistrement optique selon l'une des revendications 1 et 2, dans lequel l'enregistrement est réalisé à une vitesse linéaire de 10 m/s ou plus.

4. Processus d'enregistrement optique selon l'une quelconque des revendications 1 à 3, dans lequel le contenu total de Ga et Sb dans la couche d'enregistrement (2) est 90 % en atome ou plus.

5. Processus d'enregistrement optique selon la revendication 4, dans lequel le contenu total de Ga et Sb dans la couche d'enregistrement (2) est de 95 % d'atome ou plus.

6. Processus d'enregistrement optique selon l'une quelconque des revendications 1 à 5, dans lequel le contenu de Sb est de 85 % d'atome à 95 % d'atome par rapport au contenu total de Ga et Sb dans la couche d'enregistrement (2).

7. Processus d'enregistrement optique selon l'une quelconque des revendications 2 à 6, dans lequel le support d'enregistrement optique comprend :

   le substrat (7) ;
   une première couche de protection (1) ;
   la couche d'enregistrement (2) ;
   une deuxième couche de protection (3) ; et
   une couche de réflexion (4),

   dans lequel la première couche de protection (1), la couche d'enregistrement (2), la deuxième couche de protection (3) et la couche de réflexion (4) sont disposées sur le substrat (7) dans cet ordre et l'épaisseur de la couche de réflexion (4) satisfait une relation de : 0,10 λ ou plus, où le λ exprime la longueur d'onde du faisceau laser.

8. Processus d'enregistrement optique selon l'une quelconque des revendications 2 à 7, dans lequel le faisceau laser a une longueur d'onde de 630 nm à 700 nm.

9. Processus d'enregistrement optique selon la revendication 8, dans lequel le support d'enregistrement optique comprend :

   le substrat (7) ;

la première couche de protection (1) ;
la couche d'enregistrement (2) ;
la deuxième couche de protection (3) ; et
la couche de réflexion (4),

dans lequel la première couche de protection (1), la couche d'enregistrement (2), la deuxième couche de protection (3) et la couche de réflexion (4) sont disposées sur le substrat (7) dans cet ordre et chacune de l'épaisseur de la première couche de protection (1), de l'épaisseur de la couche d'enregistrement (2), de l'épaisseur de la deuxième couche de protection (3) et de l'épaisseur de la couche de réflexion (4) satisfait les relations suivantes, lorsque « λ » exprime la longueur d'onde du faisceau laser :

$$0,070\lambda \leq t_1 \leq 0,16\lambda$$

$$0,015\lambda \leq t_2 \leq 0,032\lambda$$

$$0,011\lambda \leq t_3 \leq 0,040\lambda$$

$$0,10\lambda \leq t_4 \ ;$$

où « $t_1$ » exprime l'épaisseur de la première couche de protection (1), « $t_2$ » exprime l'épaisseur de la couche d'enregistrement (2), « $t_3$ » exprime l'épaisseur de la deuxième couche de protection (3) et « $t_4$ » exprime l'épaisseur de la couche de réflexion (4).

10. Processus d'enregistrement optique selon l'une des revendications 8 et 9, dans lequel l'épaisseur de la couche d'enregistrement (2) est de 5 nm à 25 nm.

11. Processus d'enregistrement optique selon la revendication 10, dans lequel l'épaisseur de la couche d'enregistrement (2) est de 8 nm à 20 nm.

12. Processus d'enregistrement optique selon l'une quelconque des revendications 2 à 7, dans lequel le faisceau laser a une longueur d'onde de 350 nm à 450 nm.

13. Processus d'enregistrement optique selon la revendication 12, dans lequel le support d'enregistrement optique comprend :

le substrat (7) ;
une première couche de protection (1) ;
la couche d'enregistrement (2) ;
une deuxième couche de protection (3) ; et
la couche de réflexion (4),

dans lequel la première couche de protection (1), la couche d'enregistrement (2), la deuxième couche de protection (3) et la couche de réflexion (4) sont disposées sur le substrat (7) dans cet ordre et chacune de l'épaisseur de la première couche de protection (1), de l'épaisseur de la couche d'enregistrement (2), de l'épaisseur de la deuxième couche de protection (3) et de l'épaisseur de la couche de réflexion (4) satisfait les relations suivantes, lorsque « λ » exprime la longueur d'onde du faisceau laser ;

$$0,070\lambda \leq t_1 \leq 0,5\lambda$$

$$0,015\lambda \leq t_2 \leq 0,05\lambda$$

$$0,011\lambda \leq t_3 \leq 0,055\lambda$$

$$0,10\lambda \leq t_4 ;$$

dans lequel « $t_1$ » exprime l'épaisseur de la première couche de protection (1), « $t_2$ » exprime l'épaisseur de la couche d'enregistrement (2), « $t_3$ » exprime l'épaisseur de la deuxième couche de protection (3) et « $t_4$ » exprime épaisseur de la couche de réflexion (4).

**14.** Processus d'enregistrement optique selon la revendication 12, dans lequel le support d'enregistrement optique comprend :

le substrat (7) ;
la couche de réflexion (4) ;
la deuxième couche de protection (3) ;
la couche d'enregistrement (2) ;
la première couche de protection (1) ; et
une couche de transmission de la lumière (5),

dans lequel la couche de réflexion (4), la deuxième couche de protection (3), la couche d'enregistrement (2), la première couche de protection (1) et la couche de transmission de la lumière (5) sont disposées sur le substrat (7) dans cet ordre, et chacune de l'épaisseur de la couche de réflexion (4), d'une épaisseur de la deuxième couche de protection (3), d'une épaisseur de la couche d'enregistrement (2) et d'une épaisseur de la première couche de protection (2) et une épaisseur de la couche de transmission de la lumière (5) satisfait les relations suivantes, lorsque « $\lambda$ » exprime la longueur d'onde du faisceau laser ;

$$0,10\lambda \leq t_4 \leq 0,75\lambda$$

$$0,011\lambda \leq t_3 \leq 0,055\lambda$$

$$0,015\lambda \leq t_2 \leq 0,05\lambda$$

$$0,070\lambda \leq t_1 \leq 0,5\lambda$$

$$0 \leq t_5 \leq 0,6mm,$$

dans lequel « $t_4$ » exprime l'épaisseur de la couche de réflexion (4), « $t_3$ » exprime l'épaisseur de la deuxième couche de protection (3), « $t_2$ » exprime l'épaisseur de la couche d'enregistrement (2), « $t_1$ » exprime l'épaisseur de la première couche de protection (1) et « $t_5$ » exprime l'épaisseur de la couche de transmission de la lumière (5).

**15.** Processus d'enregistrement optique selon la revendication 12, comprenant en outre une ou plusieurs des couches d'enregistrement (2, 12, 22).

**16.** Processus d'enregistrement optique selon la revendication 15, dans lequel le support d'enregistrement optique comprend une première couche d'information (10) qui comporte une des couches d'enregistrement (12, 22) et une deuxième couche d'information (20) qui comporte l'autre des couches d'enregistrement (12, 22) dans cet ordre, depuis une direction dans laquelle le faisceau laser est irradié et la transmission de la lumière de la première couche d'information (10) est 40 % ou plus avec la longueur d'onde.

**17.** Processus d'enregistrement optique selon la revendication 3, dans lequel l'enregistrement et l'effacement sont réalisés par le changement de phase réversible entre la phase amorphe et la phase cristalline dans la couche d'enregistrement (2) à une vitesse linéaire de 14 m/s ou plus.

**18.** Processus d'enregistrement optique selon la revendication 17, dans lequel l'enregistrement et l'effacement sont réalisés par le changement de phase réversible entre la phase amorphe et la phase cristalline dans la couche d'enregistrement (2), à une vitesse linéaire de 28 m/s ou plus.

**19.** Processus d'enregistrement optique selon l'une quelconque des revendications 1 à 18, dans lequel un facteur de réflexion (Rg) au niveau d'une partie d'espace non enregistré satisfait une relation de 12 % ≤ Rg ≤ 30 %, lorsqu'un faisceau laser ayant une longueur d'onde entre 350 nm et 700 nm est irradié.

**20.** Processus d'enregistrement optique selon l'une quelconque des revendications 1 à 19, dans lequel le support d'enregistrement optique a un degré de modulation (M) de 0,4 ou plus, lorsque l'enregistrement est réalisé à une vitesse linéaire (V) comprise entre plus de 3 m/s et 40 m/s ou moins et à une longueur d'onde d'un faisceau laser comprise entre 350 nm et 700 nm et le degré de modulation (M) satisfait la relation de :

$$M=(Rg-Rb)/Rg,$$

où « M » exprime le degré de modulation, « Rb » exprime le facteur de réflexion au niveau d'une marque d'enregistrement du support d'enregistrement optique et « Rg » exprime le facteur de réflexion au niveau d'une partie d'espace non enregistré du support d'enregistrement optique.

**21.** Processus d'enregistrement optique selon la revendication 20, dans lequel le support d'enregistrement optique a un degré de modulation (M) de 0,4 ou plus, lorsque l'enregistrement est réalisé par une lentille optique ayant une NA de 0,60 ou plus.

**22.** Processus d'enregistrement optique selon l'une des revendications 20 et 21, dans lequel le support d'enregistrement optique a un degré de modulation (M) de 0,6 ou plus.

**23.** Processus d'enregistrement optique selon la revendication 20, dans lequel le support d'enregistrement optique a un degré de modulation (M) de 0,4 ou plus, lorsque l'enregistrement est réalisé à une vitesse linéaire (V) comprise entre 10 m/s et 35 m/s.

**24.** Processus d'enregistrement optique selon la revendication 23, dans lequel le support d'enregistrement optique a une valeur de sautillement de 10 % ou moins, lorsque l'enregistrement est réalisé à une vitesse linéaire quelconque (V) entre 10 m/s et 35 m/s.

**25.** Processus d'enregistrement optique selon l'une quelconque des revendications 1 à 24, dans lequel la couche d'enregistrement (2) contient en outre au moins un élément supplémentaire sélectionné parmi le groupe consistant en Ag, Au, Cu, Zn, B, Al, In, Si, Ge, Sn, Pb, N, P, Bi, La, Ce, Gd, Tb, Mg, Co, Mn, Zr, Rh, Se, Fe et Ir.

**26.** Processus d'enregistrement optique selon la revendication 25, dans lequel l'élément supplémentaire contenu dans la couche d'enregistrement (2) est au moins un élément sélectionné parmi Ag, Au, Cu, B, Al, In, Mn, Sn, Zn, Bi, Pb, Ge, Si et N.

**27.** Processus d'enregistrement optique selon la revendication 1, dans lequel la couche d'enregistrement (2) contient un alliage exprimé par la formule suivante (1) ;

$$Ga_\alpha Sb_\beta X_\gamma \qquad Formule\ (1)$$

dans lequel « X » exprime l'un d'un élément et d'un mélange d'éléments, à l'exclusion de Ga et Sb, $\alpha$, $\beta$ et $\gamma$ sont chacun exprimés en pourcentage atomique et chacun satisfait les relations : $\alpha + \beta + \gamma = 100$, $5 \le \alpha \le 20$, $80 \le \beta \le 95$ et $0 < \gamma \le 10$.

28. Processus d'enregistrement optique selon la revendication 27, dans lequel le X contient l'un d'un élément unique et d'un mélange sélectionné parmi Ag, Au, Cu, Zn, B, Al, In, Si, Ge, Sn, Pb, N, P, Bi, La, Ce, Gd, Tb, Mg, Co, Mn, Zr, Rh, Se, Fe et Ir.

29. Processus d'enregistrement optique selon la revendication 25, dans lequel la couche d'enregistrement (2) contient Ga, Sb, Bi et Rh.

30. Processus d'enregistrement optique selon la revendication 29, dans lequel la couche d'enregistrement (2) contient en outre un élément sélectionné parmi Cu, B, N, Ge, Fe et Ir.

31. Processus d'enregistrement optique selon la revendication 25, dans lequel la couche d'enregistrement (2) contient Ga, Sb, Zr et Mg.

32. Processus d'enregistrement optique selon la revendication 31, dans lequel la couche d'enregistrement (2) contient en outre un élément sélectionné parmi Ag, C, N, Se et Sn.

33. Processus d'enregistrement optique selon l'une quelconque des revendications 1 à 32, dans lequel le support d'enregistrement optique comprend :

le substrat (7) ;
la première couche de protection (1) ;
la couche d'enregistrement (2) ;
la deuxième couche de protection (3) ;
la couche de réflexion (4) ; et
une couche de protection extérieure (6),

dans lequel la première couche de protection (1), la couche d'enregistrement (2), la deuxième couche de protection (3) et la couche de réflexion (4) sont disposées sur le substrat (7) dans cet ordre et la couche de protection extérieure (6) est disposée sur une surface de la couche de réflexion (4).

34. Processus d'enregistrement optique selon l'une quelconque des revendications 1 à 33, dans lequel la vitesse linéaire (V) est comprise entre 10 m/s et 35 m/s.

35. Processus d'enregistrement optique selon la revendication 1 à 34, dans lequel le faisceau laser est irradié, de telle sorte qu'un rapport de puissance d'effacement (Pe) par rapport à la puissance d'enregistrement (Pw) satisfait une relation de :

$$0{,}10 \le Pe/Pw \le 0{,}65,$$

où « Pe » exprime la puissance d'effacement et « Pw » exprime la puissance d'enregistrement.

36. Processus d'enregistrement optique selon la revendication 35, dans lequel le faisceau laser est irradié de telle manière à avoir un rapport d'une puissance d'effacement (Pe) à la puissance d'enregistrement (Pw) qui satisfait la relation de :

$$0{,}13 \le Pe/Pw \le 0{,}6,$$

où « Pe » exprime la puissance d'effacement et « Pw » exprime la puissance d'enregistrement.

## FIG. 1

Laser beam

## FIG. 2

Laser beam

## FIG. 3

Laser beam

# FIG. 4

# FIG. 5

# FIG. 6

FIG. 7

FIG. 8

EP 1 566 802 B1

## FIG. 9

FIG. 10

FIG. 11

EP 1 566 802 B1

# FIG. 12

## FIG. 13

GaSb Medium

FIG. 14

FIG. 15

## FIG. 16

# FIG. 17

FIG. 18

FIG. 19

FIG.20

Pe/Pw Ratio

Recording Linear Velocity (m/s)

# FIG. 21

## FIG. 22

## FIG. 23

## FIG. 24

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3231889 A
- JP 4191089 A
- JP 4232779 A
- JP 4267192 A
- JP 5345478 A
- JP 2000322740 A

- US 4818666 A
- US 5072423 A
- JP 2001039031 A
- EP 1260973 A2
- JP 61168145 A

**Non-patent literature cited in the description**

- Phase-change optical data storage in GaSb. *Applied optics,* November 1987, vol. 26 (22115

- *Appl. Phys. Lett.,* 22 June 1992, vol. 60 (25), 3123-3125
- *The Rigaku-Denki Journal,* 2000, vol. 31 (1